(19) **Europäisches Patentamt**
**European Patent Office**
**Office européen des brevets**

(11) **EP 4 088 136 B1**

(12) **EUROPÄISCHE PATENTSCHRIFT**

(45) Veröffentlichungstag und Bekanntmachung des Hinweises auf die Patenterteilung:
**11.03.2026   Patentblatt 2026/11**

(21) Anmeldenummer: **21700268.2**

(22) Anmeldetag: **07.01.2021**

(51) Internationale Patentklassifikation (IPC):
*G01S 7/481* (2006.01)    *G01S 7/484* (2006.01)
*G01S 17/10* (2020.01)    *G01S 17/14* (2020.01)
*G01S 17/42* (2006.01)    *G01S 17/89* (2020.01)
*H01S 5/042* (2006.01)    *H01S 5/026* (2006.01)
*H01S 5/0233* (2021.01)    *H01S 5/40* (2006.01)

(52) Gemeinsame Patentklassifikation (CPC):
**G01S 7/4815; G01S 7/4813; G01S 7/484;
G01S 17/10; G01S 17/42; G01S 17/89;**
H01S 5/0428; H01S 5/4031

(86) Internationale Anmeldenummer:
**PCT/EP2021/050199**

(87) Internationale Veröffentlichungsnummer:
**WO 2021/140160 (15.07.2021 Gazette 2021/28)**

(54) **LICHTMODUL UND LIDAR-VORRICHTUNG MIT MINDESTENS EINEM DERARTIGEN LICHTMODUL**

LIGHT MODULE AND LIDAR APPARATUS HAVING AT LEAST ONE LIGHT MODULE OF THIS TYPE

MODULE LUMINEUX ET APPAREIL LIDAR POSSÉDANT AU MOINS UN MODULE LUMINEUX DE CE TYPE

(84) Benannte Vertragsstaaten:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorität:   **07.01.2020   DE 102020100142
23.04.2020   DE 102020111075
03.06.2020   DE 102020114782
22.09.2020   DE 102020124564**

(43) Veröffentlichungstag der Anmeldung:
**16.11.2022   Patentblatt 2022/46**

(60) Teilanmeldung:
**23187887.7 / 4 254 011
23187901.6 / 4 239 370**

(73) Patentinhaber: **Elmos Semiconductor SE
51379 Leverkusen (DE)**

(72) Erfinder:
• **SROWIG, Andre
44227 Dortmund (DE)**
• **FINKELDEY, Fabian
44227 Dortmund (DE)**

(74) Vertreter: **dompatent
Partnerschaft von
Patentanwälten und Rechtsanwälten mbB
Deichmannhaus am Dom
Bahnhofsvorplatz 1
50667 Köln (DE)**

(56) Entgegenhaltungen:
WO-A1-2019/234180    DE-A1- 102018 106 860
US-A1- 2018 045 882    US-A1- 2019 312 407

**Beschreibung**

Die Erfindung betrifft ein Lichtmodul und eine LIDAR-Vorrichtung mit mindestens einem derartigen Lichtmodul sowie ferner eine Optik für eine LIDAR-Vorrichtung und eine integrierte Schaltung, insbesondere Treiberschaltung, z.B. für eine LIDAR-Vorrichtung. Ferner betrifft die Erfindung auch die Anwendung einer LIDAR-Vorrichtung sowie eine Optikeinheit für eine LIDAR-Vorrichtung.

LIDAR (Abkürzung für englisch: light detection and ranging) ist eine dem Radar verwandte Methode zur optischen Abstands- und Geschwindigkeitsmessung sowie zur Fernmessung atmosphärischer Parameter. Statt der Radiowellen wie beim Radar werden Licht- oder Laserstrahlen verwendet. Werden also beispielsweise Halbleiterlaser eingesetzt, so spricht man mitunter auch von LADAR (Abkürzung für englisch: light amplification by stimulation emission of radiation detection and ranging). Im Stand der Technik werden bevorzugt mechanische Spiegel für die Ablenkung der Licht- oder Laserstrahlen in verschiedene Richtungen benutzt.

Aus DE-A-10 2009 060 873 ist eine Treiberschaltung für eine LED bekannt, wobei offengelassen ist, wie die Bauteile montiert werden sollen, um die parasitären Induktivitäten und Kapazitäten in optimaler Weise zu minimieren.

In DE-A-10 2008 062 544 ist eine Laser-Array-Schaltung beschrieben.

Aus DE-A-10 2016 116 368 ist ein Treiberschaltkreis für lichtemittierende optoelektronische Komponenten bekannt. Gemäß Fig. 1 dieser Schrift lädt der Aufladeschaltkreis 2, 3, 4, 5, 9, 10, 11, 12, 13, 14 einen Kondensator 18 bis 21 über einen Serienwiderstand 3. Die lichtemittierenden optoelektronischen Komponenten 22 bis 25 sind mit ihren Kathoden zu einem ersten Sternpunkt zusammengeschaltet. Ein Ansteuerschalter 26 verbindet diesen Sternpunkt mit dem Bezugspotenzial GND, wenn eine oder mehrere der lichtemittierenden optoelektronischen Komponenten Licht emittieren sollen. Ein Pufferkondensator Aufladeschaltkreises 9 dient der schnellen Ladung des eigentlichen Energiereservekondensators 18 bis 21. Bei diesem bekannten Konzept beeinträchtigt der Serienwiderstand die Energiebilanz.

Aus US-B-10 193 304 ist eine Treiberschaltung bekannt, bei der die Aufladung der Kondensatoren derart erfolgt, dass der Strom unter der Ansprechschwelle der Laser bleibt.

Aus EP-A-2 002 519 (siehe Fig. 2) ist ein kompakter Aufbau mit vier Lagen (zwei Leiterplatten, Kondensatoren, Laser und Schalt-IC) bekannt, der für die im Rahmen der Erfindung gesuchte Lösung zu komplex ist und zu langsam arbeitet.

Aus EP-A-3 301 473 ist eine Ansteuerschaltung für eine einzelne LED bekannt, die zur Aussendung kurzer Impulse geeignet ist. Wie die erforderliche Induktivität erreicht werden kann, ist nicht beschrieben oder gezeigt.

Aus DE-A-10 2016 116 369 ist eine LED-Treiberschaltung bekannt, bei der jede LED über einen eigenen Ansteuerschalter verfügt, was den Aufwand vergrößert und die Kompaktheit der Vorrichtung verschlechtert.

Aus DE-A-10 2008 021 588 ist eine Laseransteuerschaltung bekannt, bei der mehrere Ansteuerschalter parallelgeschaltet sind, so dass diese zeitversetzt zueinander Pulse generieren und zwischen den Pulsen abkühlen können, während andere Ansteuerschalter die weiteren Pulse erzeugen können.

Aus DE-A-10 2017 121 713 sind Ansteuerschalter bekannt, die aus Untereinheiten bestehen, bei denen jede Untereinheit einen eigenen Kondensator zur Bereitstellung der Schaltenergie aufweist.

Aus DE-A-199 14 362 und DE-A-19 514 062 ist jeweils eine Steuereinrichtung für einen Gas-Laser bekannt.

Aus US-B-9 185 762 (DE-A-10 2014 105 482) ist eine Schaltung zur Verringerung der Ausschaltzeit einer Laser-Diode bekannt.

Aus der DE-A-10 2017 100 879 ist eine Schaltung zum schnellen Ein- und Ausschalten einer einzelnen Laser-Diode bekannt. Dort wird auch ein Aufbaubeispiel gegeben.

Aus DE-A-10 2018 106 860 und US-A-2018/0045882 sind zwei Varianten einer direkten Verbindung zwischen einem Laser-Die eines Einzellasers und dem Die eines integrierten Ansteuerschalters bekannt. Der Ansteuerschalter ist dabei zwischen Versorgungsspannung und Anode der Laser-Diode geschaltet, was, wie im Folgenden noch klarwerden wird, eine besonders kompakte Lösung für ein Laser-Array verhindert.

In DE-A-10 2018 106 860 ist ein Laserdioden-Modul beschrieben, bei dem mehrere Ladungsspeicherkondensatoren und mehrere Laserdioden-Dies auf einem Substrat angeordnet sind. Die elektrische Verbindung der Laserdioden mit einem Ansteuer-IC kann über einen Bonddraht erfolgen. Die Verbindung der Ladungsspeicherkondensatoren mit dem Ansteuer-IC erfolgt über einen Leiterrahmen (Lead Frame).

Aus US-A-2018/0045882 ist ein Laser-Modul bekannt, bei dem auf einem Schaltungs-Die ein als Kantenemitter ausgebildete Laserdioden-Die sowie ein Ladungsspeicherkondensator angeordnet sind. In dem Schaltungs-Die ist unter anderem ein Leistungstransistor zum elektrischen Verbinden des Ladungsspeicherkondensators mit der Laserdiode angeordnet. Der Leitungspfad des Leistungstransistors ist über zwei Oberflächenkontakte des Schaltungs-Dies kontaktierbar. Zusätzlich weist das Schaltungs-Die zwei weitere Oberflächenkontakte auf, die zur elektrischen Verbindung mit dem jeweiligen einen Kontakt des Ladungsspeicherkondensators und des Laserdioden-Dies vorgesehen sind. Der zweite Kontakt des Ladungsspeicherkondensators ist mittels einer flexiblen Leiterkarte mit einem der beiden Oberflächenkontakte für den Leitungspfad des Leistungstransistors verbunden. In gleicher Weise ist der zweite Kontakt des Laserdioden-Dies über eine flexible Leiterkarte mit dem anderen Kontakt für den Leitungspfad des Leistungstransistors verbunden. Der elektrische Strom, der zum Zünden der Laserdiode vom Kondensator zur Laserdiode fließt, fließt also durch die beiden flexiblen Leiterkarten und über den Leitungspfad. Der Stromkreis wird geschlossen durch eine elektrische Verbindung zwischen Laserdiode und Ladungsspeicherkondensator, die in dem Schaltungs-Die ausgebildet ist. Die Gesamtlänge dieses Stromkreises ist vergleichsweise groß, weshalb sowohl elektrische Verluste als auch Beeinträchtigungen durch parasitäre Induktivitäten zu befürchten sind.

In DE-A-10 2016 116 875 ist eine Treiberschaltung beschrieben. Sie weist gemäß Fig. 12 dieser Schrift einen gemeinsamen Ansteuerschalter S3 für mehrere Laser D1, D7 auf, wobei der gemeinsame Ansteuerschalter S3 an die Kathoden der Laser angeschlossen ist und diese mit dem Bezugspotenzial verbinden kann. Die Energie für den Laserpuls wird dabei einer gemeinsamen Speicherkapazität C entnommen. Die Laser werden über separate Schalter S2 selektiert. Die bekannte Schaltung hat den Nachteil, dass über diese Schalter S2 eine parasitäre Spannung abfällt.

Aus DE-B-10 2006 036 167 ist eine Lasertreiberschaltung bekannt, bei der die Resonanzen der parasitären Induktivitäten und der Kapazitäten so abgestimmt sind, dass sie vorbestimmte Eigenschaften der zu erzeugenden Lichtpulse unterstützen.

In US-B-6 697 402 ist ein Lasertreiber mit einer Laserstromerfassung über einen Shunt-Widerstand zwischen Kathodenanschluss und Bezugspotenzial beschrieben.

Aus US-B-9 368 936 ist eine einzelne Treiberschaltung bekannt. Eine Spule wird als Energiespeicher verwendet.

In US-B-9 155 146 ist eine Schaltung zur Energieversorgung einer LED-Kette beschrieben.

Aus DE-A-10 2018 106 861 ist die Ansteuerung einer Laser-Diode mit einer H-Brücke bekannt.

Aus der DE-C-195 46 563 ist eine Treiberschaltung bekannt, bei der der Aufladeschaltkreis durch eine Induktivität von der Laser-Diode für die kurze Zeit der Lichtpulsemission abgeklemmt wird, wenn der Ansteuertransistor die Lichtemission initiiert.

In WO-A-2019/234180 ist der Aufbau der Sendekomponenten eines LIDAR-Systems beschrieben. Dabei sind der Halbleiter-Laser, ein Ansteuerschaltkreis, ein Kondensator und ein Schaltelement in Form eines Transistors in einem gemeinsamen Gehäuse verbaut. Die Figuren dieser Schrift zeigen verschiedene Realisierungen, wobei auch Komponenten wie Transistoren und Kondensatoren im Bauteilträger in Form etwa einer Multikeramik untergebracht sind. Die elektrischen Verbindungen erfolgen über Durchkontaktierungen im Falle einer Platzierung auf der Oberseite des Bauteilträgers, wo auch die Laserdioden platziert sein können, erfolgt die elektrische Verbindung über Durchkontaktierungen und/oder Bond-Drähte.

Aufgabe der Erfindung ist es, ein Lichtmodul für insbesondere die Verwendung bei einer LIDAR-Vorrichtung zu schaffen, das die obigen Nachteile des Standes der Technik vermeidet und zusätzliche Vorteile aufweist.

Ferner besteht eine weitere Aufgabe der Erfindung darin, mittels eines oder mehrerer erfindungsgemäßer Lichtmodule eine LIDAR-Vorrichtung, ohne zu bewegende Komponenten zu schaffen. Schließlich besteht eine weitere Aufgabe der Erfindung darin, eine optimierte Abbildungsoptik sowie streifenförmiges Beleuchtungslicht ermöglichende Optik anzugeben, die vornehmlich in einer LIDAR-Vorrichtung einsetzbar ist. Als letztes geht eine weitere Aufgabe der Erfindung dahin, eine Treiberschaltung für insbesondere Leistungstransistoren zum kurzzeitigen Leiten von hohen Strömen (Strompulsen) zu schaffen.

Diese Aufgaben der Erfindung werden gelöst mit den Gegenständen der Ansprüche 1 und 14. Einzelne Ausgestaltungen dieser erfindungsgemäßen Gegenstände sind Gegenstand der Unteransprüche.

So schafft die Erfindung ein Lichtmodul mit

- einem mit einer Oberseite versehenen Träger, in dem ein Schaltungs-Die mit integrierten Schaltungen angeordnet ist,
- wobei das Schaltungs-Die eine Oberseite aufweist,
- einem in der Oberseite des Schaltungs-Dies ausgebildeten Transistor, insbesondere Leistungstransistor,
- wobei der Transistor einen leitend oder sperrend schaltbaren Leitungspfad mit einem ersten Endbereich und einem zweiten Endbereich aufweist, von denen der erste Endbereich mit einem ersten Leitungspfad-Anschlussfeld und der zweite Endbereich mit einem zweiten Leitungspfad-Anschlussfeld elektrisch verbunden ist, die beide an der Oberseite des Trägers freiliegen, und wobei der Transistor einen Steueranschluss zum Leitend- und Sperrendschalten des Leitungspfad aufweist,
- einem eine Leuchtdiode aufweisenden Leuchtdioden-Die, insbesondere einem eine Laserdiode aufweisenden Leuchtdioden-Die, mit einer ein erstes Anschlussfeld aufweisenden Unterseite und einer ein zweites Anschlussfeld aufweisenden Oberseite,
- wobei das Leuchtdioden-Die mit seinem ersten Anschlussfeld auf dem ersten Leitungspfad-Anschlussfeld des Transistors liegend angeordnet ist und diese beiden Anschlussfelder elektrisch miteinander verbunden sind,
- einem einen Ladungsspeicher aufweisenden Ladungsspeicherbauteil, das eine ein erstes Anschlussfeld aufweisende Unterseite und eine ein zweites Anschlussfeld aufweisende Oberseite aufweist,
- wobei das Ladungsspeicherbauteil mit seinem ersten Anschlussfeld auf dem zweiten Leitungspfad-Anschlussfeld des Transistors liegend angeordnet ist und diese beiden Anschlussfelder elektrisch miteinander verbunden sind,
- mindestens einem ersten Bonddraht, der das zweite Anschlussfeld des Leuchtdioden-Dies elektrisch mit dem zweiten Anschlussfeld des Ladungsspeicherbauteils verbindet,

- einer in dem Schaltungs-Die integrierten, einen Ausgang aufweisenden Aufladeschaltung zum Aufladen des Ladungsspeicherbauteils mit elektrischer Ladung und
- einer in dem Schaltungs-Die integrierten Steuerschaltung zur Ansteuerung des Transistors und der Aufladeschaltung,
- wobei der Aufladeschaltung ein an der Oberseite des Trägers freiliegendes Ladungsanschlussfeld zugeordnet ist, mit dem der Ausgang der Aufladeschaltung elektrisch verbunden ist,
- wobei das Anschlussfeld der Aufladeschaltung mit dem zweiten Anschlussfeld des Ladungsspeicherbauteils über mindestens einen zweiten Bonddraht elektrisch verbunden ist, und
- wobei die Steuerschaltung die Aufladeschaltung zum Laden des Ladungsspeicherbauteils bis zu einem für die Erzeugung eines Lichtpulses durch das Leuchtdioden-Die erforderlichen Aufladungsgrad ansteuert und danach den Transistor zum Leitendschalten seines Leitungspfades ansteuert.

Das erfindungsgemäße Lichtmodul weist einen Träger auf, in dem sich ein Schaltungs-Die mit integrierten Schaltungen befindet. Die Kontaktierung des Schaltungs-Dies erfolgt mittels eines Leadframes, also eines Leitungsrahmens, der mehrere Leitungszungen oder -finger aufweist, die in an der Oberseite des Trägers befindlichen Anschlussfeldern enden. Bei dem Träger handelt es sich also sozusagen um das Gehäuse aus typischerweise Kunststoffmasse, in das das Schaltungs-Die und der Leiterrahmen eingebettet sind.

Die elektrischen Verbindung der einzelnen Komponenten des Lichtmoduls sind hinsichtlich der Reduktion parasitärer Impedanzen, insbesondere parasitärer Induktivitäten optimiert, so dass innerhalb kürzester Zeiten Hochstrompulse generiert werden können, die für einen energiereichen leistungsstarken Lichtpuls sorgen.

Zu diesem Zweck befindet sich in der Oberseite bzw. nahe der Oberseite des Schaltungs-Dies in diesem ein Transistor, bei dem es sich typischerweise um einen Leistungtransistor handelt. Mit dem Leitungspfad des Transistors elektrisch verbunden ist eines der beiden Anschlussfelder eines Leuchtdioden-Dies. Dieses Leuchtdioden-Die, bei dem es sich vorzugsweise um ein Laserdioden-Die handelt, ist zweckmäßigerweise durch Die-zu-Die-Bonding mit einem in der Oberseite des Trägers ausgebildeten, freiliegenden Anschlussfeld verbunden, das über den Leiterrahmen und innerhalb des Schaltungs-Dies mit einem der beiden Endbereiche des Leitungspfads des Transistors elektrisch verbunden ist. Diese Verbindung sollte so kurz wie möglich sein, weshalb unter anderem die Anordnung des Transistors direkt in bzw. unter der Oberseite des Schaltungs-Dies von Vorteil ist. Das aktive Gebiet des Transistors befindet sich also an der Oberseite des Schaltungs-Dies. Hier ist nun auch das Ladungsspeicherbauteil angeordnet, bei dem es sich im Regelfall um einen Kondensator handelt. Das Ladungsspeicherbauteil ist ebenfalls als Die ausgebildet und weist ein unterseitiges Anschlussfeld auf, die mit dem anderen Leitungspfad-Anschlussfeld des Transistors elektrisch verbunden ist. Der Aufladeschaltkreis weist eine in dem Schaltungs-Die integrierte Aufladeschaltung auf, die von einer ebenfalls im Schaltungs-Die integrierten Steuerschaltung angesteuert wird. Der Anschluss an die Aufladeschaltung ist aus dem Schaltungs-Die über den Leiterrahmen bis zur Oberseite des Trägers herausgeführt und endet dort in einem Anschlussfeld, das mittels eines (zweiten) Bonddrahts mit dem oberseitigen Anschlussfeld des Ladungsspeicherbauteils elektrisch verbunden ist. Das Ladungsspeicherbauteil selbst ist nun wiederum mit einem gegenüber dem zweiten Bonddraht wesentlich kürzeren ersten Bonddraht mit dem Leuchtdioden-Die verbunden, und zwar verbindet dieser zweite Bonddraht die oberseitigen Anschlussfelder von Leuchtdioden-Die und Ladungsspeicherbauteil. Die Steuerschaltung des Schaltungs-Die steuert schließlich auch den Transistor an, und zwar unter Zwischenschaltung einer ebenfalls im Schaltungs-Die integrierten Treiberschaltung. Auf eine mögliche Ausgestaltung dieser Treiberschaltung wird weiter unten noch im Detail eingegangen.

Die erfindungsgemäße Hybrid-Konstruktion des Lichtmoduls sorgt für eine Minimierung parasitärer Induktivitäten und ohmscher Widerstände sowie Kapazitäten, und zwar insbesondere in dem Entladeschaltkreis, der durch den Leitungspfad des Transistors, das Leuchtdioden-Die und das Ladungsspeicherbauteil bestimmt ist. Vorzugsweise werden die beiden zuletzt genannten Komponenten auf der Oberseite des Trägers unmittelbar nebeneinander angeordnet, so dass der erste Bonddraht so kurz wie möglich ausgeführt werden kann. Die Verbindungen zwischen den oberseitigen Leiterpfad-Anschlussfeldern des Trägers für den Transistor bis zum eigentlichen Leitungspfad des Transistors ist ebenfalls optimiert, so dass auch hier parasitäre Impedanzen weitestgehend minimiert sind. Der Aufladeschaltkreis umfasst den Ausgang der Aufladeschaltung, den zweiten Bonddraht und das Ladungsspeicherbauteil und ist ebenfalls hinsichtlich der Reduktion parasitärer Einflüsse durch Induktivitäten und Widerstände sowie Kapazitäten optimiert. Grundsätzlich hat sich herausgestellt, dass die parasitäre Induktivität des Aufladeschaltkreises durchaus vorteilhafterweise größer sein kann als die parasitäre Kapazität des Entladeschaltkreises. Dann nämlich wird sozusagen die elektrische Verbindung ist Ladungsspeicherbauteils zum Aufladeschaltkreis in gewisser Weise blockiert, wenn bei Leitendschaltung des Transistors der Entladeschaltkreis geschlossen wird, so dass der Ladungsspeicher die Leuchtdiode effektiv mit maximaler elektrischer Energie in vorzugsweise kürzester Zeit und mit schnellem Anstieg versorgen kann. Hierzu trägt nicht zuletzt auch die pulsartige Ansteuerung des Transistors mit großer Flankensteilheit des elektrischen Schaltpulses für den Transistor bei. Das wiederum wird unterstützt durch eine vorteilhafterweise entsprechend ausgeschaltete Treiberschaltung, auf die später noch eingegangen wird.

Wie bereits zuvor angedeutet, ist es vorteilhaft, wenn

- der mindestens eine erste Bonddraht eine erste parasitäre Induktivität und einen ersten parasitären ohmschen Widerstand aufweist,
- der mindestens eine zweite Bonddraht eine zweite parasitäre Induktivität und einen zweiten parasitären ohmschen Widerstand aufweist,
- die elektrische Verbindung des ersten Anschlussfeldes des Leuchtdioden-Dies mit dem ersten Endbereich des Leitungspfads des Transistors eine dritte parasitäre Induktivität und einen dritten parasitären ohmschen Widerstand aufweist und
- die elektrische Verbindung zwischen dem ersten Anschlussfeld des Ladungsspeicherbauteils und dem zweiten Endbereich des Leitungspfads des Transistors eine vierte parasitäre Induktivität und einen vierten parasitären ohmschen Widerstand aufweist,
- die elektrische Verbindung des Ausgangs der Aufladeschaltung mit dem der Aufladeschaltung zugeordneten Ladungsanschlussfeld eine fünfte parasitäre Induktivität und einen fünften parasitäre ohmschen Widerstand aufweist,
- wobei die erste parasitäre Induktivität, die dritte parasitäre Induktivität und die vierte parasitäre Induktivität in Summe eine Größe aufweisen, die kleiner ist als die Größe der dritten parasitären Induktivität und der fünften parasitären Induktivität in Summe und insbesondere weniger als 1/2 oder weniger als 1/4 oder weniger als 1/5 der dritten parasitären Induktivität und der fünften parasitären Induktivität in Summe beträgt.

Die Länge des ersten Bonddrahts kann insbesondere weniger als 1/2 oder weniger als 1/3 oder weniger als 1/5 der Länge des zweiten Bonddrahts betragen. Der Wert der ersten parasitären Induktivität und/oder des ersten parasitären ohmschen Widerstands ist vorteilhafterweise kleiner als der Wert der zweiten parasitären Induktivität und/oder des zweiten parasitären ohmschen Widerstands. Die parasitären Induktivitäten bzw. ohmschen Widerstände beider Bonddrähte sind vorzugsweise kleiner als die weiteren oben genannten parasitären Induktivitäten bzw. ohmschen Widerstände. Vorteilhaft ist es ferner, wenn der erste parasitäre ohmsche Widerstand, der dritte parasitäre ohmsche Widerstand und der vierte parasitäre ohmsche Widerstand in Summe eine Größe aufweisen, die kleiner ist als die Größe des dritten ohmschen Widerstand und des fünften ohmschen Widerstand in Summe und insbesondere weniger als 1/2 oder weniger als 1/4 oder weniger als 1/5 des dritten ohmschen Widerstand und des fünften ohmschen Widerstand in Summe beträgt.

Wie bereits oben erläutert, bilden

- die elektrisch miteinander verbundenen Komponenten, nämlich das Leuchtdioden-Die, das Ladungsspeicherbauteil, der mindestens eine erste Bonddraht und der Transistor mit seinem Leitungspfad zusammen einen Entladeschaltkreis, der eine erste parasitäre Induktivität und einen ersten parasitären ohmschen Widerstand aufweist, und
- das Ladungsspeicherbauteil mit seiner elektrischen Verbindung mit dem Ausgang der Aufladeschaltung über den mindestens einen zweiten Bonddraht einen Aufladeschaltkreis, der eine zweite parasitäre Induktivität und einen zweiten parasitären ohmschen Widerstand aufweist,
- wobei die erste parasitäre Induktivität kleiner ist als die zweite parasitäre Induktivität und insbesondere weniger als 1/2 oder weniger als 1/4 oder weniger als 1/5 der zweiten Induktivität beträgt.

Von Vorteil ist es ferner, wenn der erste parasitäre ohmsche Widerstand kleiner ist als der zweite parasitäre ohmsche Widerstand und insbesondere weniger als 1/2 oder weniger als 1/4 oder weniger als 1/5 des zweiten parasitären ohmschen Widerstands beträgt.

Es hat sich herausgestellt, dass es zweckmäßig sein kann, wenn mehrere erste Bond-drähte zueinander parallel geschaltet und mehrere zweite Bonddrähte ebenfalls ihrerseits zueinander parallel geschaltet verwendet werden, um die zuvor genannten elektrischen Verbindungen der oberseitigen Anschlussfelder von Leuchtioden-Die, Ladungsspeicherbauteil und Anschlussfeld für die Aufladeschaltung zu realisieren.

In weiterer vorteilhafter Ausgestaltung der Erfindung können mehrere Leuchtdioden-Dies und mehrere Ladungsspeicherbauteile vorgesehen sein, wobei

- jedem Leuchtdioden-Die ein Ladungsspeicherbauteil zugeordnet ist,
- die Oberseite des Trägers für jedes Leuchtdioden-Die ein freiliegendes erstes Anschlussfeld, das elektrisch mit dem ersten Endbereich des Leitungspfads des Transistors verbunden ist, und für jedes Ladungsspeicherbauteil ein freiliegendes zweites Anschlussfeld aufweist, das elektrisch mit dem zweiten Endbereich des Leitungspfads des Transistors verbunden ist,
- in dem Schaltungs-Die für jedes Ladungsspeicherbauteil eine diesem zugeordnete Aufladeschaltung integriert ist und an der Oberseite des Trägers für jede Aufladeschaltung ein Anschlussfeld freiliegend angeordnet ist,

- jedes Leuchtdioden-Die mit seinem ersten Anschlussfeld auf dem zugeordneten ersten Leitungspfad-Anschlussfeld des Transistors aufliegend angeordnet ist und diese beiden Anschlussfelder elektrisch miteinander verbunden sind,
- jedes Ladungsspeicherbauteil mit seinem ersten Anschlussfeld auf dem zugeordneten zweiten Leitungspfad-Anschlussfeld des Transistors aufliegend angeordnet ist und diese beiden Anschlussfelder elektrisch miteinander verbunden sind,
- das zweite Anschlussfeld jedes Leuchtdioden-Dies mit dem zweiten Anschlussfeld des dem jeweiligen Leuchtdioden-Die zugeordneten Ladungsspeicherbauteils mittels mindestens eines ersten Bonddrahts verbunden ist,
- das Anschlussfeld jeder Aufladeschaltung mit dem zweiten Anschlussfeld des der jeweiligen Aufladeschaltung zugeordneten Ladungsspeicherbauteils mittels mindestens eines zweiten Bonddrahts verbunden ist und
- wobei die Steuerschaltung die Aufladeschaltungen sequentiell zum Laden der jeweiligen Ladungsspeicherbauteile bis zu einen für die Erzeugung eines Lichtpulses durch die dem jeweiligen Ladungsspeicherbauteil zugeordneten Leuchtdioden-Dies erforderlichen Aufladungsgrad ansteuert und vor der Ansteuerung der nächsten Aufladeschaltung den Transistor zum Leitendschalten seines Leitungspfads ansteuert.

Die zuvor beschriebene Ausgestaltung des Lichtmoduls weist nun einen einzigen Transistor auf, der wahlweise einen von mehreren Entladeschaltkreisen schließt, zu denen jeweils eine andere der Leuchtdioden und ein anderer der Ladungsspeicher gehören. Sämtliche Leuchtdioden sind zu einem gemeinsamen ersten Sternpunkt (beispielsweise die Kathoden der Leuchtdioden) zusammengeschaltet und mit dem einen Endbereich des Leitungspfads des Transistors verbunden. Der andere Endbereich des Leitungspfads ist beispielsweise mit dem Bezugspotenzial verbunden, mit dem auch der eine Kontakt des Ladungsspeichers verbunden ist, dessen anderer Kontakt wiederum mit dem anderen nicht mit dem Transistor verbundenen Kontakt der Leuchtdiode (beispielsweise mit deren Anode) verbunden ist. Die Ladungsspeicher werden durch die Steuerschaltung gesteuert sequentiell aufgeladen. Nach jedem Aufladevorgang wird dann der Transistor leitend geschaltet, so dass dann nur diejenige Leuchtdiode aufleuchtet, deren zugehöriger Ladungsspeicher aufgeladen ist. Dieses Schaltungskonzept vereinfacht den Schaltungsaufbau und die Anzahl von Schaltelementen, da nämlich lediglich ein einziger Transistor benötigt wird, der vorteilhafterweise großflächig ausgebildet sein sollte, um die erforderliche Stromtragfähigkeit aufzuweisen. Würde man mehrere derartige Transistoren verwenden, so geriete man recht schnell an Grenzen, was die Anzahl von Transistoren pro Schaltungs-Die betrifft.

Im zuvor beschriebenen Ausführungsbeispiel können an der Oberseite des Trägers mehrere einzelne erste und zweite Leitungspfad-Anschlussfelder für den Transistor vorgesehen sein. Da aber mit beiden Endbereichen des Leitungspfads des Transistors jeweils ein Sternpunkt der Schaltung (nämlich beispielsweise die Anoden sämtlicher Leuchtdioden einerseits und die einen Kontakte sämtlicher Ladungsspeicher andererseits) verbunden sind, können auch ein gemeinsames und damit großflächigeres erstes Leitungspfad-Anschlussfeld sowie ein gemeinsames und damit ebenfalls entsprechend großes zweites Leitungspfad-Anschlussfeld des Transistors an der Oberseite des Trägers ausgebildet sein.

Wie bereits oben beschrieben, weist das Leuchtdioden-Die vorzugsweise eine Laserdiode auf, ist also ein Laserdioden-Die ausgebildet, wobei es zweckmäßig ist, die Laserdiode als Kantenemitter auszubilden.

In weiterer vorteilhafter Ausgestaltung der Erfindung kann ein an der Oberseite des Trägers freiliegendes erstes Versorgungsspannungs-Anschlussfeld für ein Versorgungsspannungs-Potential vorgesehen sein, wobei an das zweite Leitungspfad-Anschlussfeld des Transistor oder, sofern mehrere derartige zweite Leitungspfad-Anschlussfelder vorhanden sind, an sämtliche dieser zweiten Leitungspfad-Anschlussfelder des Transistors oder an ein für alle diese zweiten Leitungspfad-Anschlussfelder gemeinsames zweites Leitungspfad-Anschlussfeld ein Versorgungsspannungs-Bezugspotential anlegbar ist.

Des Weiteren kann zweckmäßigerweise ein einen Pufferkondensator bildendes Pufferkondensatorbauteil mit einer Unterseite vorgesehen sein, an der ein erstes Anschlussfeld angeordnet ist, und einer Oberseite, an der ein zweites Anschlussfeld angeordnet ist, wobei das Pufferkondensatorbauteil mit seinem ersten Anschlussfeld auf dem zweiten Leitungspfad-Anschlussfeld oder den zweiten Leitungspfad-Anschlussfeldern oder dem für sämtliche dieser zweiten Leitungspfad-Anschlussfelder gemeinsamen zweiten Leitungspfad-Anschlussfeld aufliegend angeordnet ist und die beiderseitigen Anschlussfelder miteinander verbunden sind und wobei das zweite Anschlussfeld des Pufferkondensatorbauteils über mindestens einen dritten Bonddraht elektrisch mit dem ersten Versorgungsspannungs-Anschlussfeld verbunden ist.

Zur Minimierung der Länge der die oberseitigen Anschlussfeld von Leuchtdioden-Die und zugeordnetem Ladungsspeicherbauteil verbindenden ersten Bonddrähte ist es von Vorteil, wenn die Leuchtdioden-Dies und die Ladungsspeicherbauteile entlang zweier nebeneinander liegender Linien jeweils aufeinanderfolgend angeordnet sind, wobei jedes Leuchtdioden-Die und das diesem jeweils zugeordnete Ladungsspeicherbauteil einander gegenüberliegend angeordnet sind.

Bei Verwendung eines Lichtmoduls mit mehreren Leuchtdioden-Dies definiert jedes eine optische Achse, entlang der ein von dem betreffenden Leuchtdioden-Die ausgehender Lichtstrahl gerichtet ist, wobei die Linie, entlang der die Leuchtdioden-Die aufeinanderfolgend angeordnet sind, entweder

- kreisbogenförmig um einen Mittelpunkt verläuft und die optischen Achsen der Leuchtdioden-Dies radial zu dieser kreisbogenförmigen Linie verlaufen oder
- geradlinig verläuft und die optischen Achsen der Leuchtdioden-Dies senkrecht dazu verlaufen.

Vorteilhaft ist es, wenn die typischerweise als Ladungsspeicher eingesetzten Kondensatoren und der bereits oben genannte Pufferkondensator als ein gemeinsames Bauteil ausgebildet sind, das eine Unterseite mit einem gemeinsamen Unterseiten-Anschlussfeld und eine Oberseite mit mindestens einem ersten Oberseiten-Anschlussfeld und einem zweiten Oberseiten-Anschlussfeld und ein Dielektrikum zwischen dem Unterseiten-Anschlussfeld einerseits und dem mindestens einen ersten Oberseiten-Anschlussfeld sowie dem zweiten Oberseiten-Anschlussfeld andererseits aufweist, wobei der Pufferkondensator zwischen dem zweiten Oberseiten-Anschlussfeld und dem unterhalb dieses zweiten Oberseiten-Anschlussfeldes liegenden Teilbereich des Unterseiten-Anschlussfeldes ausgebildet ist und jeder Ladungsspeicherkondensator zwischen einem anderen der ersten Oberseiten-Anschlussfelder und dem unterhalb dieses jeweiligen ersten Oberseiten-Anschlussfeldes liegenden Teilbereich des Unterseiten-Anschlussfeldes ausgebildet ist.

Wie bereits oben beschrieben weist der Träger eine Vergussmasse auf, in die ein mehrere Leiterzungen aufweisender Leiterrahmen und das mit den Leiterzungen elektrisch verbundenen Schaltungs-Die eingebettet sind, wobei die Leiterzungen die an der Oberseite des Trägers freiliegenden Anschlussfelder aufweisen.

Die Ansteuerung des insbesondere als Leistungstransistor ausgeführten Transistors des erfindungsgemäßen Lichtmoduls erfolgt zweckmäßigerweise mittels Digital-Spannungssignalen, die naturgemäß keine ausreichende Leistung aufweisen, um das vergleichsweise großflächige Gate eines beispielsweise Leistungs-MOSFET anzusteuern. Ein Leistungstransistor kann aufgefasst werden als die Parallelschaltung einer Vielzahl von Einzeltransistoren. Jeder Einzeltransistor weist einen Einzelsteueranschluss (in Form einer beispielsweise Gate-Elektrode) auf, wobei die Gesamtheit der Einzelsteueranschlüsse den Gesamtsteueranschluss des Leistungstransistors bildet. Damit nun der Leistungstransistor homogen geschaltet werden kann, muss an jeden Einzelsteueranschluss das Digital-Ansteuersignal angelegt werden. Dabei ist ferner zu beachten, dass die Längen der elektrischen Verbindung zwischen dem Ausgang der typischerweise in Digitaltechnik ausgeführten Steuerschaltung zu jedem der Einzelsteueranschlüsse gleich lang und entsprechend geometrisch in ihren Verläufen gestaltet sind.

In diesem Zusammenhang hat sich als vorteilhaft herausgestellt,

- wenn der Transistor des Schaltungs-Die in diesem als ein in Analog-Schaltungstechnik ausgeführter, spannungsgesteuerter, einen Gesamtsteueranschluss und einen Gesamtleitungspfad aufweisenden Gesamttransistor zum Leiten eines elektrischen Stroms über den Gesamtleitungspfad und zum Sperren des Stroms ausgebildet ist,
- wobei sich der Gesamtsteueranschluss über eine Steueranschluss-Gesamtfläche des Schaltungs-Dies erstreckt,
- wenn die Steuerschaltung eine in Digital-Schaltungstechnik ausgeführte Treiberschaltung zum Ansteuern des Gesamtsteueranschlusses des Gesamttransistors zum Leiten und Sperren des Stroms aufweist, oder dass das Schaltungs-Die eine in Digital-Schaltungstechnik ausgeführte, von der Steuerschaltung steuerbare Treiberschaltung zum Ansteuern des Gesamtsteueranschlusses des Gesamttransistors zum Leiten und Sperren des Stroms aufweist,
- wobei der Gesamttransistor in eine Vielzahl von in Analog-Schaltungstechnik ausgeführten Einzeltransistoren unterteilt ist oder eine Vielzahl derartiger Einzeltransistoren aufweist,
- wobei jeder Einzeltransistor einen Einzelsteueranschluss aufweist und sich die Einzelsteueranschlüsse der Einzeltransistoren jeweils über Steueranschluss-Einzelflächen des Die erstrecken, die gleich groß oder gleichmäßig über die Steueranschluss-Gesamtfläche des Gesamttransistors verteilt sind,
- wobei die Treiberschaltung eine Vielzahl von Einzeltreiberschaltungen mit jeweils einem Eingang und u Ausgängen, mit u als ganze natürliche Zahl größer als oder gleich 2, aufweist, die hierarchisch in verschiedene Stufen unterteilt sind, wobei der Ausgang einer Einzeltransistorschaltung einer i-ten Stufe, mit i gleich 1 bis v und v als ganze natürliche Zahl größer als oder gleich 2, mit den Eingängen von u Einzeltreiberschaltungen der (i+1)-ten Stufe, verbunden ist (d.h. wobei jede Einzeltreiberschaltung einen Fan-Out von u, mit u als ganze natürliche Zahl größer als oder gleich 2, aufweist),
- wobei die Anordnung aus einer Einzeltreiberschaltung der i-ten Stufe und den Einzeltreiberschaltungen der (i+1)-ten Stufe, deren Eingänge mit den Ausgängen der Einzeltreiberschaltung der i-ten Stufe verbunden sind, eine selbstähnliche Struktur bildet,
- wobei die selbstähnlichen Strukturen einer i-ten Stufe flächenmäßig größer ist als die selbstähnlichen Strukturen einer (i+1)-ten Stufe und die selbstähnlichen Strukturen der i-ten Stufe mit einer (i+1)-ten Stufe mit der selbstähnlichen Struktur einer i-ten Stufe, aus der sie hervorgegangen ist, ineinander verschachtelt sind, und
- wobei die Ausgänge der Einzeltreiberschaltungen der v-ten Stufe mit den Steueranschlusseinzelflächen der Einzeltransistoren verbunden sind.

Durch die Verschachtelung einzelner selbstähnlicher Strukturen pro Treiberstufe wird erreicht, dass, wie oben beschrieben, die elektrischen Verbindungsleitungen (unter Einbeziehung der elektrischen Verbindungen und Schaltungskomponenten der Einzeltreiberschaltungen der einzelnen Treiberstufen) gleich lang sind und hinsichtlich ihrer geometrischen Ausrichtung und ihres geometrischen Verlaufs identisch bzw. ähnlich, nämlich beispielsweise symmetrisch oder spiegelsymmetrisch sind.

Durch die "Auffächerung" des einen einzigen Transistor-Ansteuersignals der Steuerschaltung auf eine Vielzahl von einzelnen Digital-Signalen, die jeweils nur vergleichsweise kleinflächige Elektroden der Einzeltransistoren ansteuern müssen, gelingt es, die Einschaltzeiten und die Flankensteilheit zu optimieren, so dass mit einem energiereichen Strompuls, der vom Leistungstransistor geschaltet wird, gearbeitet und die Leuchtdiode, vorzugsweise die Laderdiode, angesteuert werden kann.

In weiterer vorteilhafter Ausgestaltung der Erfindung kann vorgesehen sein, dass jede Einzeltreiberschaltung einen Eingang und vier Ausgänge aufweist, dass jede der Einzeltreiberschaltungen der i-ten Stufe und die vier Einzeltreiberschaltungen der (i+1)-ten Stufe mitsamt der elektrischen Verbindung der vier Ausgänge der Einzeltreiberschaltung der i-ten Stufe mit den Eingängen der vier Einzeltreiberschaltungen der (i+1)-ten Stufe eine H-förmige Struktur bildet, wobei die Einzeltreiberschaltungen der (i+1)-ten Stufe an den vier Enden der H-förmigen Struktur angeordnet sind und die Einzeltreiberschaltung der i-ten Stufe in der Mitte zwischen den vier Enden angeordnet ist, und dass die H-förmigen Strukturen von Stufe zu Stufe die gleiche Ausrichtung aufweisen.

Ferner kann es zweckmäßig sein, wenn jede Einzeltreiberschaltung einen Eingang und zwei Ausgänge aufweist, dass jede der Einzeltreiberschaltung der i-ten Stufe in der Mitte zwischen den beiden Einzeltreiberschaltungen der (i+1)-ten Stufe angeordnet ist sowie mitsamt der elektrischen Verbindung der beiden Ausgänge der Einzeltreiberschaltung der i-ten Stufe mit den Eingängen der beiden Einzeltreiberschaltungen der (i+1)-ten Stufe eine geradlinige Struktur bildet und wenn diese selbstähnlichen Strukturen von Stufe zu Stufe jeweils um 90° verdreht zueinander sind.

Vorteilhaft kann es ferner sein, wenn die Einzeltreiberschaltungen als Inverterschaltungen ausgebildet sind und dass die Einzeltransistoren als Leistungstransistoren, insbesondere MOSFET, ausgebildet sind. Die Digital-Inverterschaltung ist das einfachste Konzept für die Einzeltreiberschaltungen, wie sie nach dieser Ausgestaltung der Erfindung in den mehreren Treiberstufen der Treiberschaltung verwendet werden.

Hinsichtlich der geometrischen Ausgestaltung und Anordnung der Anschlussfelder des Lichtmoduls kann es zweckmäßig sein, wenn Oberseite des Trägers eine rechteckige Form mit zwei Längsrändern und zwei im Vergleich zu diesen Längsrändern kürzeren Querrändern aufweist, wobei das mindestens eine erste Leitungspfad-Anschlussfeld des Transistors an einem der beiden Querränder angeordnet ist und an dem anderen Querrand Anschlussfelder für die Energieversorgung der Steuerschaltung, der mindestens einen Aufladeschaltung, des mindestens einen Ladungsspeicherbauteils und des mindestens einen Leuchtdioden-Dies angeordnet sind.

In vorteilhafter Ausgestaltung der Erfindung kann vorgesehen sein, dass an jedem der Längsränder der Oberseite des Trägers eines von zwei Transfersignal-Anschlussfeldern mindestens eines Paares von Transfersignal-Anschlussfeldern angeordnet sind, die elektrisch miteinander verbunden sind und der Zuführung von für das Schaltungs-Die bestimmten Transfersignalen wie z.B. ein Rücksetzsignal, ein Diagnosesignal, ein Buskommunikationssignal, ein Triggersignal für die Auslösung der Erzeugung eines Lichtpulses durch das mindestens eine Leuchtdioden-Die, dienen, wobei die Transfersignale bei Nebeneinanderanordnung mehrerer Lichtmodule nebeneinander von einem Lichtmodul zum jeweils benachbarten Lichtmodul oder von einem Lichtmodul nach Verarbeitung in dessen Schaltungs-Die zum jeweils benachbarten Lichtmodul weiterleitbar sind.

In weiterer vorteilhafter Ausgestaltung der Erfindung kann vorgesehen sein, dass die Lichtmodule unter zueinander benachbarter Anordnung der Längsränder ihrer Oberseiten, insbesondere bei paralleler Ausrichtung der Längsränder, nebeneinander angeordnet sind, wobei die Transfersignal-Anschlussfelder gleicher Paare von Transfersignal-Anschlussfeldern zweier jeweils benachbarter Lichtmodule untereinander elektrisch verbunden sind.

Vorteilhaft kann es ferner sein, wenn die Leuchtdioden-Dies sämtlicher nebeneinander angeordneter Lichtmodule auf einer gemeinsamen kreisbogenförmig gekrümmten Linie oder auf einer geraden Linie angeordnet sind.

Die Erfindung kann insbesondere eingesetzt werden in einer LIDAR-Vorrichtung zum optischen Abtasten eines Raums und zum Aufnehmen eines den Raum repräsentierenden Abstandsbildes, wobei die LIDAR-Vorrichtung versehen ist mit

- mindestens einem Lichtmodul nach einem oder mehreren der vorstehend genannten Ausgestaltungen, wobei von jedem Leuchtdioden-Die jedes Lichtmoduls bei Ansteuerung des betreffenden Leuchtdioden-Dies ein Lichtstrahl mit einem ellipsen- oder ovalförmigen Lichtstrahlquerschnitt mit einer ersten Halbachse und mit einer gegenüber der ersten Halbachse längeren zweiten Halbachse oder mit einem kreisförmigen Querschnitt ausgeht,
- einem Senderoptikelement zur Aufweitung des Lichtstrahls jedes der Leuchtdioden-Dies durch Streckung des ellipsen- oder ovalförmigen Lichtstrahlquerschnitts entlang der zweiten Halbachse und Stauchung des Lichtstrahlquerschnitts entlang der ersten Halbachse oder umgekehrt zu einem auf den abzutastenden Raum gerichteten Lichtstrahlfächer mit einem linienartigen und/oder schlitzartigen Querschnitt oder durch Streckung des kreisförmigen Lichtstrahlquerschnitts zu einem auf den abzutastenden Raum gerichteten Lichtstrahlfächer mit einem linienartigen und/oder schlitzartigen Querschnitt,

- wobei die von den nebeneinander angeordneten Leuchtdioden-Dies erzeugten kegelförmigen Lichtstrahlen als Lichtstrahlfächer unter unterschiedlichen Winkeln in den Raum gelangen,
- einem Fotosensor mit einer Vielzahl von Fotodetektoren, die in einer der Gesamtzahl der Leuchtdioden-Dies des mindestens einen Lichtmoduls gleichenden Anzahl von Zeilen oder Spalten angeordnet sind, wobei jede Zeile oder Spalte die gleiche Anzahl von Fotodetektoren aufweist,
- einem Empfängeroptikelement zum Richten von potentiellem Reflexionslicht aus dem abzutastenden Raum auf den Fotosensor, wobei auf Grund des jeweiligen Lichtstrahlfächers potentiell entstehendes Reflexionslicht auf eine andere der mehreren Zeilen oder Spalten von Fotodetektoren des Fotosensors auftrifft, und
- einer Auswerteeinheit zur Auswertung von Signalen der Fotodetektoren zur Ermittlung von Abstandsinformationen und/oder zur Ermittlung eines Abstandsbildes des abzutastenden Raums.

Die LIDAR-Vorrichtung arbeitet also mit mehreren Leuchtdioden, die sequentiell angesteuert werden, um nach dem Passieren der einzelnen jeweils abgegebenen Lichtstrahlbündeln, die typischerweise einen ellipsen- oder ovalförmigen Querschnitt aufweisen, oder aber einen kreisrunden Querschnitt aufweisen, zu Lichtstrahlstreifen in Linienform umzusetzen. Jede Lichtstrahllinie trifft dabei auf einen anderen linien- bzw. streifenförmigen Bereich der abzubildenden Szene, d.h. des aufzunehmenden Abstandsbildes. Das von dort sukzessive pro Streifen reflektierte Licht gelangt über eine Abbildungs-Empfangsoptik auf die einzelnen Zeilen oder Spalten eines 2D-Fotosensors mit einer Vielzahl von insbesondere als Fotodioden ausgebildeten Fotodetektoren. Die Belichtung des Fotosensors erfolgt dabei also nach Art eines "rolling shutter". Ausgewertet werden die einzelnen Fotodetektorsignale dann durch eine Auswerteeinheit. Dabei kann die Auswertung entweder nach dem Time-of-Flight-Konzept oder aber intensitätsabhängig ausgewertet werden.

Ein Vorteil der zuvor beschriebenen LIDAR-Vorrichtung ist darin zu sehen, dass sie insoweit mechaniklos arbeitet, als es keinerlei bewegbarer Bauteile bedarf.

Bei dem Empfängeroptikelement handelt es sich also zweckmäßigerweise um eine bildgebende Linse bzw. ein bildgebendes Objektiv, wie es typischerweise in Kameras verwendet wird. Das Senderoptikelement kann eine Zylinderlinse und eine Powell-Linse aufweisen oder aber kann eine Linse aufweisen, die die Funktion dieser beiden Linsentypen in sich vereint.

Der Vorteil der Verwendung einer Powell-Linse besteht darin, dass Inhomogenitäten hinsichtlich der Intensitätsverteilung über die Querschnittsfläche des Lichtstrahls kompensiert werden können. Derartige Lichtintensitäts-Inhomogenitäten treten bei gaußschen Strahlern typischerweise auf und sind insbesondere bei Kantenemitter-Leucht- oder Laserdioden anzutreffen. Durch die Powell-Linse oder aber auch durch spezielle Linsen mit entsprechenden Oberflächen lassen sich diese Lichtintensitäts-Inhomogenitäten über die Längserstreckung der Lichtstrahlstreifen, wie sie erfindungsgemäß bei der LIDAR-Vorrichtung eingesetzt werden, ausgleichen.

In vorteilhafter Ausgestaltung der Erfindung können mindestens zwei Lichtmodule vorgesehen sein, wobei die Leuchtdioden-Dies jedes Lichtmoduls jeweils entlang einer sich über einen vorgegebenen Winkel erstreckenden Kreisbogenlinie nebeneinander angeordnet sind und jeweils benachbarte Lichtmodule um den vorgegebenen Winkel gegeneinander verdreht angeordnet sind.

In weiterer vorteilhafter Ausgestaltung der Erfindung können mindestens zwei Lichtmodule vorgesehen sein, wobei die Leuchtdioden-Dies jedes Lichtmoduls entlang einer geraden Linie nebeneinander angeordnet sind und jeweils benachbarte Lichtmodule um einen Winkel verdreht zueinander angeordnet sind, so dass die optischen Achsen derjenigen Leuchtdioden-Dies der Lichtmodule, die an der gleichen Position innerhalb der Aufeinanderfolge von Leuchtdioden-Dies jedes Lichtmoduls angeordnet sind, sich in einem gemeinsamen Punkt schneiden. Der Vorteil dieser Anordnung der Leuchtdioden-Dies besteht darin, dass nun die Entfernung jedes Leuchtdioden-Dies zur Senderoptikelement-Linse gleich ist.

Gemäß einer Alternative der LIDAR-Vorrichtung ist diese versehen mit

- einem Lichtmodul mit einem einzigen Leuchtdioden-Die nach einem oder mehreren der vorstehend genannten, wobei von dem Leuchtdioden-Die bei Ansteuerung ein Lichtstrahl mit einem ellipsen- oder ovalförmigen Lichtstrahlquerschnitt mit einer ersten Halbachse und einer gegenüber der ersten Halbachse längeren zweiten Halbachse oder mit einem kreisförmigen Querschnitt ausgeht,
- einem Senderoptikelement zum Aufweiten des Lichtstrahls des Leuchtdioden-Dies durch Streckung des ellipsen- oder ovalförmigen Lichtstrahlquerschnitts entlang der zweiten Halbachse und Stauchung des Lichtstrahlquerschnitts entlang der ersten Halbachse oder umgekehrt zu einem auf den abzutastenden Raum gerichteten Lichtstrahlfächer mit einem linienartigen und/ oder schlitzartigen Querschnitt oder durch Streckung des kreisförmigen Lichtstrahlquerschnitts zu einem auf den abzutastenden Raum gerichteten Lichtstrahlfächer mit einem linienartigen und/ oder schlitzartigen Querschnitt,
- einem bewegbaren optischen Ablenkelement zum Ablenken des Lichtstrahlfächers unter unterschiedlichen Winkeln in den abzutastenden Raum zum Abtasten des Raums mittels des diesen überstreichenden Lichtstrahlfächers,

- einem Fotosensor mit einer Vielzahl von Fotodioden, die in Zeilen und Spalten angeordnet sind,
- einem Empfängeroptikelement zum Richten von potentiellem Reflexionslicht aus dem abzutastenden Raum auf den Fotosensor,
- wobei potentielles Reflexionslicht, das auf Grund jedes unter einem anderen Winkel in den Raum abgelenkten Lichtstrahlfächers entsteht, auf eine andere der mehreren Zeilen oder Spalten von Fotodetektoren des Fotosensors auftrifft, und
- einer Auswerteeinheit zur Auswertung von Signalen der Fotodetektoren zur Ermittlung von Abstandsinformationen und/oder zur Ermittlung eines Abstandsbildes des abzutastenden Raums.

Bei dieser Variante der LIDAR-Vorrichtung wird mit bewegbarem mechanischem Element gearbeitet, nämlich beispielsweise mit einem schwenkbaren Spiegel oder einer Polymeroptik. Beispiele für derartige grundsätzlich bekannte bewegbare optische Elemente finden sich in EP-A-3 660 574 oder US-A-2020/0264462 als mikro-mechanisch/mikro-elektrische Systeme (MEMS) in Form MEMS-Spiegeln und in WO-A-2008/035983 und WO-A-2018/154139 als Polymeroptikelement mit Piezoantrieb. Mit Vorteil kann also bei LIDAR-Systemen mit beweglichen optischen Ablenkelementen das erfindungsgemäße Schaltungskonzept für die hochenergetische und mit größtmöglicher Flankensteilheit erfolgende elektrische Ansteuerung des Leuchtdioden-Dies mit dem Ergebnis genutzt werden, dass intensitätsreiche, ausreichend lange Lichtpulse erzeugt werden können.

In zweckmäßiger Weiterbildung der zuvor beschriebenen Variante der LIDAR-Vorrichtung kann vorgesehen sein, dass das optische Ablenkelement refraktiv arbeitet und insbesondere als Prisma ausgebildet ist, oder dass das optische Ablenkelement reflektiv arbeitet und insbesondere als Spiegel ausgebildet ist.

Beide zuvor genannten Varianten der LIDAR-Vorrichtung verwenden einen Fotosensor, bei dem die Fotodetektoren in Zeilen und Spalten angeordnet sind. Für die elektronischen Schaltelemente, die den einzelnen Fotodetektoren zugeordnet sind, wird je nach Konstruktion entweder zwischen benachbarten Fotodetektorzeilen oder benachbarten Fotodetektorspalten auf dem Sensorchip Platz benötigt, weshalb die einzelnen Fotodetektorzeilen oder Fotodetektorspalten nicht die gesamte streifenförmig beleuchtete Szene erfassen können. Wenn man nun aber den Fotosensor oder die gesamte LIDAR-Vorrichtung um eine Achse oszillieren lässt, wobei der jeweilige Oszillations- oder Neigungswinkel erfasst wird, so können bei Erfassung der Szene pro Neigungswinkel im Laufe der Oszillation auch diejenigen streifenförmigen Bereiche der beleuchteten Szene erfasst werden, die zuvor auf die Zwischenräume benachbarter Zeilen abgebildet worden sind. Damit erhöht sich die Auflösung, mit der die Szene aufgenommen wird. Insoweit von Vorteil ist es also, eine Kippbewegungseinrichtung zum Kippen des mindestens einen Lichtmoduls oder zum Kippen der Anordnung mehrerer Lichtmodule oder zum Kippen des Fotosensors vorzusehen, wobei die Auswertung der Signale der Fotodetektoren des Fotosensors in Abhängigkeit von dem jeweiligen Kippwinkel erfolgt, unter dem die Leuchtdioden-Dies des oder der Lichtmodule Licht aussenden und/oder der Fotosensor Reflexionslicht empfängt.

Alternativ bzw. zusätzlich kann ferner vorgesehen sein, dass

- jedes Leuchtdioden-Die einen Lichtstrahl als Abtastlichtstrahl mit ellipsen- oder ovalförmigem oder kreisförmigem Lichtstrahlquerschnitt aussendet,
- das Senderoptikelement den Abtastlichtkegel zu einem Abtastlichtfächer aufweitet, der in einer Lichtfächerebene liegt,
- die Abtastlichtfächer der Abtastlichtstrahlen sämtlicher Leuchtdioden-Dies um einen Winkelversatz zueinander versetzt sind,
- von durch einen Abtastlichtfächer beleuchteten Abtastpunkten im abzutastenden Raum potentiell Reflexionsstrahlung im Wesentlichen in Form von Reflexionslichtkegeln ausgehen und
- das Empfängeroptikelement Reflexionslichtkegel, die potentiell von durch einen der Abtastlichtfächer beleuchteten Abtastpunkten des abzutastenden Raums ausgehen, auf eine Fotodetektorspalte oder -zeile des Fotosensors abbildet.

In weiterer zweckmäßiger Ausgestaltung der Erfindung kann vorgesehen sein,

- dass die Leuchtdioden-Dies nebeneinander in einer Reihe angeordnet sind, deren Ausrichtung gleich der Ausrichtung einer Fotodetektorspalte des Fotosensors ist, und
- dass jeder Abtastlichtfächer Abtastpunkte im abzutastenden Raum beleuchtet, die nebeneinander in einer Reihe angeordnet sind, deren Ausrichtung gleich der Ausrichtung einer Fotodetektorzeile des Fotosensors ist.

In zweckmäßiger Ausgestaltung der Erfindung kann ferner vorgesehen sein,

- dass die Leuchtdioden-Dies nebeneinander in einer Reihe angeordnet sind, deren Ausrichtung gleich einer Fotodetektorzeile des Fotosensors ist, und

- dass jeder Abtastlichtfächer Abtastpunkte im abzutastenden Raum beleuchtet, die nebeneinander in einer Reihe angeordnet sind, deren Ausrichtung gleich der Ausrichtung einer Fotodetektorzeile des Fotosensors ist.

In weiterer zweckmäßiger Ausgestaltung der Erfindung kann vorgesehen sein,

- dass die Leuchtdioden-Dies nebeneinander in einer Reihe angeordnet sind, deren Ausrichtung gleich der Ausrichtung einer Fotodetektorspalte des Fotosensors ist, und
- dass jeder Abtastlichtfächer Abtastpunkte im abzutastenden Raum beleuchtet, die nebeneinander in einer Reihe angeordnet sind, deren Ausrichtung gleich der Ausrichtung einer Fotodetektorspalte des Fotosensors ist.

Ferner kann in zweckmäßiger Ausgestaltung der Erfindung vorgesehen sein,

- dass die Leuchtdioden-Dies nebeneinander in einer Reihe angeordnet sind, deren Ausrichtung gleich einer Fotodetektorzeile des Fotosensors ist, und
- dass jeder Abtastlichtfächer Abtastpunkte im abzutastenden Raum beleuchtet, die nebeneinander in einer Reihe angeordnet sind, deren Ausrichtung gleich einer Fotodetektorspalte des Fotosensors ist.

Was die optischen Eigenschaften der LIDAR-Vorrichtung anbelangt, so ist es von Vorteil, wenn das Senderoptikelement eine eine optische Achse aufweisende Linse mit einer insbesondere im Wesentlichen Quaderform und mit einer Höhe, einer Breite sowie einer in Erstreckung der optischen Achse ausgerichteten Dicke und mit einer ersten Hauptseite sowie einer dieser abgewandten zweiten Hauptseite, durch die die optische Achse jeweils hindurch verläuft, aufweist,

- wobei die erste Hauptseite eine ebene Fläche aufweist,
- wobei die zweite Hauptseite eine Fläche aufweist, die als Überlagerung aus einer konvexen Vorwölbung und einer in der Mitte der Breitenerstreckung der Linse angeordneten konkaven Einbuchtung ausgebildet ist,
- wobei die Vorwölbung um eine gedachte, außerhalb der Linse liegende erste Achse verläuft und die Einbuchtung um eine ebenfalls außerhalb der Linse liegende zweite Achse verläuft, die senkrecht zur ersten Achse gerichtet ist.

Diese Ausgestaltung der Hauptseiten des Senderoptikelements ist insoweit von Vorteil, als es zu einer Vergleichmäßigung der Intensität kommt, mit der einzelne Teilabschnitte eines streifenförmigen Bereichs der Szene beleuchtet wird. Das Senderoptikelement kann ein oder mehrere Linsen aufweisen. Die beiden Hauptseiten bilden dann die Endflächen der einen Linse oder der Gruppe aus mehreren Linsen. Die erste Hauptseite kann der aufzunehmenden Szene zugewandt sein, so dass die zweite Hauptseite dem oder den Lichtmodulen zugewandt ist. Es ist aber auch möglich, dass die erste Hauptseite dem oder den Lichtmodulen und die zweite Hauptseite der Szene zugewandt ist.
Bei dem zuvor beschriebenen Senderoptikelement ist vorteilhafterweise vorgesehen, dass die erste Achse in einem sich an die erste Hauptseite der Linse anschließenden Halbraum und die zweite Achse in einem sich an die zweite Hauptseite der Linse anschließenden Halbraum liegt.
Bei einer alternativen Ausgestaltung des Senderoptikelements weist dieses eine eine optische Achse aufweisende Linse mit einer insbesondere im Wesentlichen Quaderform und mit einer Höhe, einer Breite sowie einer in Erstreckung der optischen Achse ausgerichteten Dicke und mit einer ersten Hauptseite sowie einer dieser abgewandten zweiten Hauptseite, durch die die optische Achse jeweils hindurch verläuft, auf,

- wobei die erste Hauptseite als eine Überlagerung aus einer ebenen Fläche mit einer in der Mitte der Breitenerstreckung der Linse angeordneten konkaven ersten Einbuchtung und mit einer zur zweiten Hauptseite hin gerichteten Verbiegung der Linse in deren Bereichen beidseitig dieser Einbuchtung zur zweiten Hauptseite hin ausgebildet ist,
- wobei die zweite Hauptseite als eine Überlagerung aus einer konvexen ersten Vorwölbung und einer in der Mitte der Breitenerstreckung der Linse angeordneten konvexen zweiten Vorwölbung ausgebildet ist,
- wobei sich die erste Vorwölbung um eine gedachte, außerhalb der Linse angeordnete erste Achse erstreckt,
- wobei sich die zweite Vorwölbung um eine gedachte, ebenfalls außerhalb der Linse angeordnete zweite Achse erstreckt, die senkrecht zur ersten Achse gerichtet ist, und
- wobei sich die Einbuchung um eine gedachte, ebenfalls außerhalb der Linse angeordnete dritte Achse erstreckt, die parallel zur zweiten Achse gerichtet ist.

Hierbei kann ferner mit Vorteil vorgesehen sein, dass die erste Achse und die zweite Achse und die dritte Achse in einem an die erste Hauptseite der Linse angrenzenden Halbraum liegen und dass die Verbiegung der Linse in deren Bereichen beidseitig der Einbuchtung der ersten Hauptseite um eine vierte Achse erstreckt, die parallel zur zweiten Achse und zur dritten Achse verläuft und in einem an die zweite Hauptseite angrenzenden zweiten Halbraum liegt.

Eine mögliche Ausgestaltung der Linse kann dadurch gegeben sein, dass

- die erste Hauptseite eine Fläche aufweist, die definiert ist durch eine Funktion der Form

$$z = RY + AR2 * x^2 + AR3 * |x^3| - Sign(RY) * Sqrt(RY2 - y2) + PB2 * x^2 + PB3 * |x^3| + PB4 * x4 + PB6 * x6 + PC2 * x^2 + PC3 * |x^3|$$

mit

$$RY = R0Y + AR2 * x^2 + AR3 * |x^3|,$$

Sign() als Signum-Funktion eines Funktionsparameters,
Sqrt() als Wurzel eines Funktionsparameters,
x für einen Punkt entlang der Breite der Linse,
y für einen Punkt entlang der Höhe der Linse,
z für einen Punkt entlang der Dicke und damit entlang der optischen Achse der Linse, ausgehend von x-y-Mittenebene der Linse, und
R0Y als Krümmungsradius der Linse,

- die zweite Hauptseite eine Fläche aufweist, die definiert ist durch eine Funktion der Form

$$z = -(d + PC2 * x^2 + PC3 * |x^3|),$$

mit d als Dicke der Linse im optischen Zentrum,
- wobei die Parameter PB2 und PB3 von Null verschieden sind und
- zumindest zwei der Parameter AR2, AR3, PB4, PB6, PC2 und PC3 von Null verschieden sind.

Hierbei kann vorgesehen sein, dass die Parameter AR2 und AR3 von Null verschieden sind und zumindest zwei der Parameter PB4, PB6, PC2 und PC3 von Null verschieden sind und/oder dass die Parameter PB4 und PB6 von Null verschieden sind und zumindest einer der Parameter PC2 und PC3 von Null verschieden ist und/oder dass die Parameter PC2 und PC3 von Null verschieden sind.

Der Einsatzbereich der erfindungsgemäßen LIDAR-Vorrichtung mit erfindungsgemäßen Lichtmodulen ist vielfältig. So kann beispielsweise das ein oder die mehreren Lichtmodule und die LIDAR-Vorrichtung verwendet werden für

- die Detektion von Objekten im Umfeld einer oder in einem Teilbereich des Umfeldes einer stehenden oder mobilen Plattform, insbesondere einer sich autonom bewegenden Plattform, insbesondere einer sich autonom bewegenden Plattform, wie z.B. eines Roboters oder eines stehenden oder fahrenden, insbesondere autonom fahrenden Fahrzeugs, wie z.B. eines Wasser-, Land- oder Luftfahrzeuges für insbesondere die Personen- oder Frachtbeförderung, oder
- die Detektion von Objekten bei der Automatisierung von Herstellungsprozessen, oder
- die nicht-invasive Bildgebung lebender Organismen und/oder biologischer Organe eines Lebewesens, oder
- die Untersuchung von biologischem Gewebe, oder
- die Erstellung von dreidimensionalen Abstandsbildern von Objekten in einem Detektionsraum, und/oder
- die Überwachung der Umgebung von Gebäuden.

Bereits oben wurden die Vorteile der Treiberschaltung für den Leistungstransistor zur Erzeugung stabiler Digital-Signale über die verhältnismäßig große Ansteuerelektrode des Leistungstransistors beschrieben. In vorteilhafter Ausgestaltung ist nun diese Treiberschaltung als integrierte elektrische Schaltung zum Schalten elektrischer Ströme versehen mit

- einem Die,
- einem in dem Die in Analog-Schaltungstechnik ausgeführten, spannungsgesteuerten, einen Gesamtsteueranschluss und einen Gesamtleitungspfad aufweisenden Gesamttransistor zum Leiten eines elektrischen Stroms über den Gesamtleitungspfad und zum Sperren des Stroms,
- wobei sich der Gesamtsteueranschluss über eine Steueranschluss-Gesamtfläche des Die erstreckt,
- einer in dem Die in Digital-Schaltungstechnik ausgeführten Treiberschaltung zum Ansteuern des Gesamtsteueranschlusses des Gesamttransistors zum Leiten und Sperren des Stroms,
- wobei jeder Einzeltransistor einen Einzelsteueranschluss aufweist und sich die Einzelsteueranschlüsse der Einzeltransistoren jeweils über Steueranschluss-Einzelflächen des Die erstrecken, die gleich groß oder gleichmäßig über die Steueranschluss-Gesamtfläche des Gesamttransistors verteilt sind,
- wobei die Treiberschaltung eine Vielzahl von Einzeltreiberschaltungen mit jeweils einem Eingang und u Ausgängen, mit u als ganze natürliche Zahl größer als oder gleich 2, aufweist, die hierarchisch in verschiedene Stufen unterteilt sind, wobei der Ausgang einer Einzeltransistorschaltung einer i-ten Stufe, mit i gleich 1 bis v und v als ganze natürliche Zahl größer als oder gleich 2, mit den Eingängen von u Einzeltreiberschaltungen der (i+1)-ten Stufe, verbunden ist (d.h. wobei jede Einzeltreiberschaltung einen Fan-Out von u, mit u als ganze natürliche Zahl größer als oder gleich 2, aufweist),
- wobei die Anordnung aus einer Einzeltreiberschaltung der i-ten Stufe und den Einzeltreiberschaltungen der (i+1)-ten Stufe, deren Eingänge mit den Ausgängen der Einzeltreiberschaltung der i-ten Stufe verbunden sind, eine selbstähnliche Struktur bildet,
- wobei die selbstähnlichen Strukturen einer i-ten Stufe flächenmäßig größer ist als die selbstähnlichen Strukturen einer (i+1)-ten Stufe und die selbstähnlichen Strukturen der i-ten Stufe mit einer (i+1)-ten Stufe mit der selbstähnlichen Struktur einer i-ten Stufe, aus der sie hervorgegangen ist, ineinander verschachtelt sind, und
- wobei die Ausgänge der Einzeltreiberschaltungen der v-ten Stufe mit den Steueranschlusseinzelflächen der Einzeltransistoren verbunden sind.

In vorteilhafter Ausgestaltung der Erfindung kann vorgesehen sein, dass jede Einzeltreiberschaltung einen Eingang und vier Ausgänge aufweist, dass jede der Einzeltreiberschaltungen der i-ten Stufe und die vier Einzeltreiberschaltungen der (i+1)-ten Stufe mitsamt der elektrischen Verbindung der vier Ausgänge der Einzeltreiberschaltung der i-ten Stufe mit den Eingängen der vier Einzeltreiberschaltungen der (i+1)-ten Stufe eine H-förmige Struktur bildet, wobei die Einzeltreiberschaltungen der (i+1)-ten Stufe an den vier Enden der H-förmigen Struktur angeordnet sind und die Einzeltreiberschaltung der i-ten Stufe in der Mitte zwischen den vier Enden angeordnet ist, und dass die H-förmigen Strukturen von Stufe zu Stufe die gleiche Ausrichtung aufweisen.

In weiterer vorteilhafter Ausgestaltung der Erfindung kann vorgesehen sein, dass jede Einzeltreiberschaltung einen Eingang und zwei Ausgänge aufweist, dass jede der Einzeltreiberschaltung der i-ten Stufe in der Mitte zwischen den beiden Einzeltreiberschaltungen der (i+1)-ten Stufe angeordnet ist sowie mitsamt der elektrischen Verbindung der beiden Ausgänge der Einzeltreiberschaltung der i-ten Stufe mit den Eingängen der beiden Einzeltreiberschaltungen der (i+1)-ten Stufe eine geradlinige Struktur bildet und dass diese selbstähnlichen Strukturen von Stufe zu Stufe jeweils um 90° verdreht zueinander sind.

In vorteilhafter Ausgestaltung der Erfindung kann ferner vorgesehen sein, dass die Einzeltreiberschaltungen als Inverterschaltungen ausgebildet sind und dass die Einzeltransistoren als Leistungstransistoren, insbesondere MOSFET, ausgebildet sind.

Weiter oben wurde bereits auf die Optikeinheit der LIDAR-Vorrichtung zur Beleuchtung der Szene eingegangen. Die LIDAR-Vorrichtung ist gemäß einer Variante versehen mit einem oder mehreren Lichtmodulen,

- wobei jedes Leuchtdioden-Die einen Lichtstrahl mit einem elliptischen oder kreisförmigen Querschnitt aussendet,
- wobei jeder Lichtstrahl eine Lichtstrahlachse aufweist,
- wobei die Lichtstrahlachsen im Wesentlichen in einer gemeinsamen Lichtstrahlachsenebene liegen und die Lichtstrahlachsenebene eine optische Achse definiert,
- mit einer auf der optischen Achse der Lichtstrahlachsenebene angeordneten Linse, die jeden Lichtstrahl in zur Laserstrahlachsenebene senkrechter Richtung aufweitet, so dass sich für jeden der Lichtstrahlen ein Lichtfächer in einer Lichtfächerebene senkrecht zur Lichtstrahlachsenebene ergibt,
- mit einem Fotosensor mit einem Fotodetektor-Array, das mehrere Fotodetektorzeilen mit jeweils einer Vielzahl von Fotodetektorpixeln aufweist, und
- mit einer Abbildungsoptik zur reellen optischen Abbildung einer von den Lichtfächern beleuchteten Szene auf den Fotosensor,
- wobei die Abbildungsoptik die Projektion der Lichtstrahlfächer im Fernfeld auf eine ideal homogen weiße und/oder im Wesentlichen ideal diffus einheitlich und gleichmäßig reflektierende Projektionsebene senkrecht zur optischen Achse der Lichtstrahlachsenebene in Form eines Projektionsbildes der Lichtstrahlfächer auf den Fotosensor als Abbildungsbild der Szene abbildet.

Bei dieser LIDAR-Vorrichtung

- ist die Linse so ausgeformt, dass der Wert der Beleuchtungsintensität eines ersten Ausschnitts der Abbildung der Projektion eines ersten Lichtstrahlfächers auf ein erstes Fotodetektorpixel des Fotodetektor-Array des Fotosensors vom Wert der Beleuchtungsintensität eines vom ersten Ausschnitt verschiedenen zweiten Ausschnitts der Abbildung der Projektion des ersten Lichtstrahlfächers auf ein vom ersten Fotodetektorpixel verschiedenes zweites Fotodetektorpixel oder eines zweiten Lichtstrahlfächers auf ein vom ersten Fotodetektorpixel verschiedenes zweites Fotodetektorpixel des Fotodetektor-Array des Fotosensors um nicht mehr als 10% oder um nicht mehr als 5% oder um nicht mehr als 2% abweicht,
- weist die Linse eine erste Oberfläche und eine dieser abgewandte zweite Oberfläche auf,
- ist die erste Oberfläche definiert durch eine Funktion der Form

$$z = RY + AR2*x^2 + AR3*|x^3| - \text{Sign}(RY)*\text{Sqrt}(RY2 - y2) + PB2*x^2 + PB3*|x^3| + PB4*x4 + PB6*x6 + PC2*x^2 + PC3*|x^3|$$

mit

$$RY = R0Y + AR2*x^2 + AR3*|x^3|,$$

Sign() als Signum-Funktion eines Funktionsparameters,
Sqrt() als Wurzel eines Funktionsparameters,
x für einen Punkt entlang der Breite der Linse,
y für einen Punkt entlang der Höhe der Linse,
z für einen Punkt entlang der Dicke und damit entlang der optischen Achse der Linse, ausgehend von x-y-Mittenebene der Linse, und
R0Y als Krümmungsradius der Linse,

- ist die zweite Oberfläche definiert durch eine Funktion der Form

$$z = -(d + PC2*x^2 + PC3*|x^3|),$$

mit d als Dicke der Linse im optischen Zentrum,
- wobei die Parameter PB2 und PB3 von Null verschieden sind und
- zumindest zwei der Parameter AR2, AR3, PB4, PB6, PC2 und PC3 von Null verschieden sind.

Hierbei kann vorgesehen sein, dass die Parameter AR2 und AR3 von Null verschieden sind und zumindest zwei der Parameter PB4, PB6, PC2 und PC3 von Null verschieden sind und/oder dass die Parameter PB4 und PB6 von Null verschieden sind und zumindest einer der Parameter PC2 und PC3 von Null verschieden ist und/oder dass die Parameter PC2 und PC3 von Null verschieden sind. Die erste Oberfläche kann der Szene zugewandt sein, so dass die zweite Oberfläche dem oder den Lichtmodulen zugewandt ist. Ein umgekehrter Aufbau oder Einbau der Linse ist aber ebenso möglich.

Wie bereits oben beschrieben, ist es insbesondere in der Anwendung bei LIDAR-Vorrichtungen wünschenswert, möglichst hochenergetische Lichtpulse erzeugen zu können. Dies erfolgt durch pulsartige Ansteuerung eines (vorzugsweise Leistungs-)Transistors mit großer Flankensteilheit des Ansteuerungspulses. Die Vorbereitung der Transistoransteuerung erfolgt im Regelfall mittels in Digital-Schaltungstechnik ausgeführter Schaltungskomponenten, die letztendlich dann aber einen vergleichsweisen großflächigen Leistungstransistor ansteuern müssen. Für die über die Fläche der Ansteuerelektrode des Leistungstransistors gleichmäßig verteilte gleich starke Ansteuerung müssen spezielle Vorkehrungen getroffen werden, die, soweit bekannt, im Stand der Technik noch nicht zufriedenstellend gelöst sind.

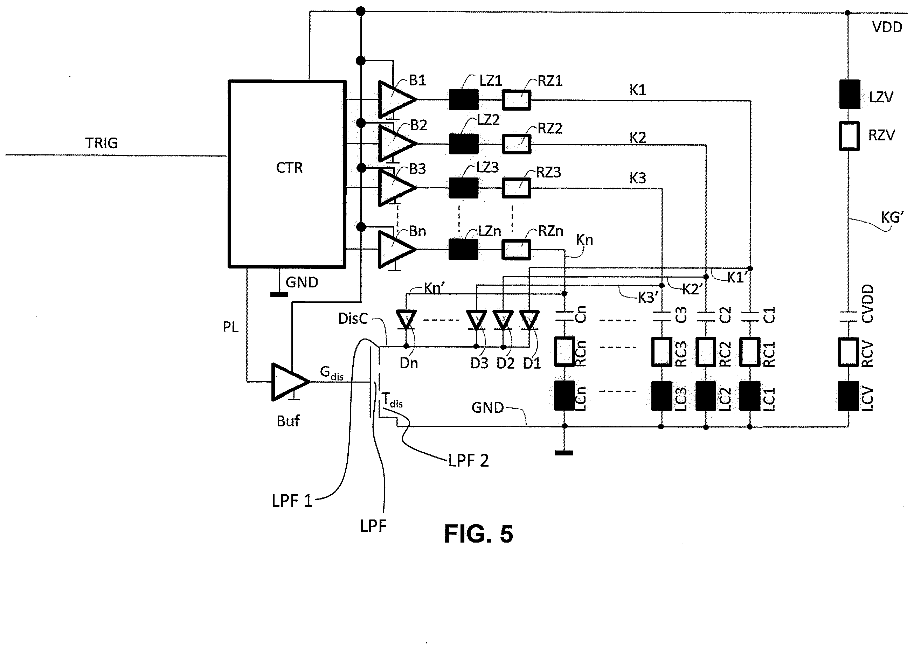

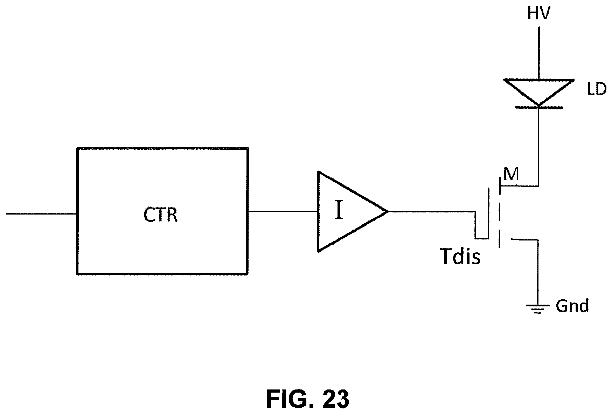

Der Stand der Technik wird beispielhaft anhand der Fig. 23 erläutert. Fig. 23 zeigt eine beispielhafte, auf das Wesentliche reduzierte Schaltung nach dem Stand der Technik für die Ansteuerung einer Laserdiode LD mittels einer Treiberschaltung I sowie eines z.B. Feldeffekttransistors M und einer nicht näher spezifizierten Steuerschaltung CTR, bei der es sich in diesem Falle beispielhaft um den Block CTR der Schaltung nach Fig. 5 handelt. Der exakte Aufbau der nicht näher spezifizierten Vortreiber- bzw. Steuerschaltung CTR ist für die im Folgenden angestellten Betrachtungen nicht relevant und wird daher nicht weiter erläutert.

Die Treiberschaltung I weist einen Eingang und einen Ausgang auf. Die Laserdiode LD umfasst eine Kathode und eine Anode. Die Laserdiode LD kann auch eine Leuchtdiode sein. Der Feldeffekttransistor M umfasst einen Gate-Anschluss, einen Drain-Anschluss und einen Source-Anschluss.

Die Vortreiberschaltung (hier beispielhaft realisiert als Steuerung CTR) ist mit dem Eingang der Treiberschaltung I elektrisch leitend verbunden. Der Ausgang der Treiberschaltung I ist mit dem Gate-Anschluss des Feldeffekttransistors M elektrisch leitend verbunden. In Fig. 23 ist der Feldeffekttransistor M beispielhaft als selbstleitender p-Kanal MOSFET dargestellt. Der Drain-Anschluss des Feldeffekttransistors M ist mit der Kathode der Laserdiode LD elektrisch verbunden. Die Anode der Laserdiode LD ist mit einem ersten Bezugspotential HV elektrisch verbunden. Der Source-Anschluss des Feldeffekttransistors M ist mit einem zweiten Bezugspotential Gnd elektrisch verbunden. Das zweite Bezugspotential Gnd ist betragsmäßig kleiner als das erste Bezugspotential HV.

In einer solchen Schaltung zur Ansteuerung einer Laserdiode LD oder Leuchtdiode sind die Steuerschaltung CTR und die Treiberschaltung I und der Feldeffekttransistor M als voneinander getrennte Blöcke in einer CMOS-Architektur oder als diskrete Bauteile realisiert.

Für die Ansteuerung von gepulsten Laserdioden oder Leuchtdioden mittels kurzer Hochstrompulse sind im Stand der Technik insbesondere GaN-Feldeffekttransistoren als diskrete Bauteile mit externem diskretem Vortreiber, oder CMOS-Hochstromtransistoren mit integriertem Vortreiber bekannt.

Der Erfindung liegt daher die weitere Aufgabe zugrunde, eine Lösung zu schaffen, die die obigen Nachteile des Stands der Technik vermeidet und weitere Vorteile aufweist. Ein wesentlicher Aspekt der Erfindung soll die Vermeidung der bisher bemerkbaren und störenden Begrenzung der maximal erreichbaren Schaltgeschwindigkeit sein, die sich auf Grund der erheblichen Signallaufzeiten, insbesondere des Gate-Signals, wegen der flächigen Ausdehnung von Hochstrom-MOS-Transistoren mit geringem Widerstand einstellt.

Kern der hier vorgestellten Erfindung ist also ein Licht- und insbesondere Laser-Modul, das die Aussendung von vergleichsweise langer, energiereicher, intensiver Laser- oder Lichtpulse mit großer Flankensteilheit erlaubt. Es sei angenommen, dass das Laser-Modul n linear nebeneinander angeordnete Laser umfasst. Bei den Lasern handelt es sich bevorzugt um Halbleiterlaser, die bevorzugt einen gemeinsamen Kathodenkontakt besitzen. Wenn im Folgenden von Laser-Modul oder Laser bzw. Lasern gesprochen wird, so ist dies gleichbedeutend und verallgemeinernd als Lichtmodul mit Lichtquellen in Form von LEDs zu verstehen.

Das vorgeschlagene Laser-Modul besitzt somit ein lineares Laser-Array aus n Lasern, wobei n für eine ganze positive Zahl steht, die größer gleich 1 ist und z.B. größer gleich 2 oder größer gleich 4 oder größer gleich 8 oder größer gleich 16 ist. Bevorzugt ist die Zahl n der Laser eine Potenz von 2. Die Laser sind dabei bevorzugt nebeneinander längs einer ersten (gedachten) Linie mit einem ersten Abstand von Laser zu Laser angeordnet. Bevorzugt sind die Laser in gleicher Weise ausgeführt. Bevorzugt sind die Laser in einem gemeinsamen Kristall gefertigt.

Jedem der n Laser ist bevorzugt genau ein Kondensator von n Kondensatoren als jeweilige Energiequelle für seinen Laserpuls zugeordnet. Ob ein Laser beim nächsten Pulssignal einen Laserpuls aussendet oder nicht, bestimmt sich bevorzugt danach, ob der diesem Laser zugeordnete Kondensator vor der Erzeugung des Pulssignals durch eine Aufladeschaltung aufgeladen wurde oder nicht. Die n Kondensatoren werden bevorzugt längs einer zweiten (gedachten) Linie nebeneinander angeordnet. Diese zweite Linie der Anordnung der Kondensatoren verläuft bevorzugt parallel zu der ersten Linie der Anordnung der Laser. Der zweite Abstand von Kondensator zu Kondensator für die n Kondensatoren, die längs dieser zweiten Linie angeordnet sind, ist bevorzugt gleich dem ersten Abstand von Laser zu Laser, um den voneinander beabstandet die Laser längs der ersten Linie angeordnet sind. Es ergibt sich somit ein lineares Kondensator-Array aus n Kondensatoren.

Des Weiteren weist das Laser-Modul einen Ansteuerschalter auf, der zur Zündung und zum Betreiben der Laser mit elektrischer Ladung aus dem dem jeweiligen Laser zugeordneten Kondensator dient.

Damit ein Laser mit Eintreffen des Pulssignals einen Laserpuls aussenden kann, muss der diesem Laser zugeordnete Kondensator zuvor durch eine diesem Kondensator zugeordnete Aufladeschaltung geladen worden sein. Das Laser-Modul umfasst daher bevorzugt n Aufladeschaltungen, wobei jede Aufladeschaltung selektiv jeweils einen anderen der n Kondensatoren (im Folgenden als der dieser Aufladeschaltung zugeordnete Kondensator bezeichnet) über eine Aufladeleitungsinduktivität laden kann. Es wurde im Zuge der Entstehung der Erfindung erkannt, dass sich die Größe dieser Aufladeleitungsinduktivität für die Entladegeschwindigkeit des jeweiligen Kondensators und damit für die Steilheit der Pulsflanke positiv auswirkt, da diese Induktivität die Aufladeschaltung von dem Kondensator für hohe Frequenzen trennt. Somit wirken sich Ausgangskapazitäten der Aufladeschaltung bei steilen Laserflanken bei einer großen Aufladeleitungsinduktivität nicht mehr aus. Der Laser-Puls wird also durch die sperrende Aufladeleitungsinduktivität potenziell steiler.

Somit ist bevorzugt jedem der n Kondensatoren jeweils einen der n Laser als diesem Kondensator zugeordneter Laser zugewiesen. Mit dem Eintreffen des Pulssignals wird der Ansteuerschalter geschlossen. Der Ansteuerschalter ist dabei bevorzugt ein Transistor einer integrierten Schaltung. Durch das Schließen des Ansteuerschalters entlädt der Ansteuerschalter denjenigen Kondensator der n Kondensatoren, der geladen ist, über den diesem Kondensator zugeordneten Laser und einer Entladeleitungsinduktivität, die diesen Kondensator bevorzugt mit der Anode des Lasers verbindet. Der zugeordnete Laser kann nur dann einen Laserpuls mit dem Eintreffen des Pulssignals und dem darauffolgenden Schließen des Ansteuerschalters aussenden, wenn der diesem Laser zugeordnete Kondensator zuvor durch die Aufladeschaltung aufgeladen worden ist. Durch das Schließen des Ansteuerschalters mit dem Eintreffen des elektrischen Pulssignals verbindet der Ansteuerschalter bevorzugt die Kathode des Lasers mit einem Bezugspotenzial. Selbstverständlich sind auch Schaltungen denkbar oder vorstellbar oder möglich, in denen die Anode und die Kathode des Lasers vertauscht sind. Diese funktionsäquivalenten Schaltungen und Anordnungen sind von der Erfindung ausdrücklich mitumfasst.

Es ist somit eine wesentliche erfindungsgemäße Erkenntnis, dass der Wert der Aufladeleitungsinduktivität möglichst hoch sein sollte, während die Induktivität der Entladeleitung möglichst klein sein sollte. Zur Entladeleitungsinduktivität trägt dabei die Verbindungsleitung von z.B. der Anode des Lasers zu seinem Kondensator und die Zuleitungsinduktivität vom Kondensator zum Bezugspotenzial bei. Die gesamte Entladeleitungsinduktivität sollte dabei möglichst gering sein. Es wurde bei der Entstehung der Erfindung erkannt, dass es vorteilhaft ist, für die Verbindung mehrere dünne Bonddrähte statt eines dicken Bonddrahts mit hoher Stromtragfähigkeit zu verwenden, da die Gesamtinduktivität der mehreren parallel geschalteten Bonddrähte niedriger ist als die parasitäre Induktivität des dicken Bonddrahtes. Zwar kommt es zu einer transformatorischen Koppelwirkung zwischen den parallel gesetzten Bonddrähten, die Vorteile der niedrigen Gesamtinduktivität und damit der schnellen Schaltzeiten überwiegen bei weitem.

Die Aufladeleitungsinduktivität wird maximiert. Die Bonddrahtlänge zur Verbindung des ersten Anschlusses des Kondensators mit der ihm zugeordneten Aufladeschaltung wird daher bevorzugt maximiert, um die Aufladeleitungsinduktivität im Rahmen des Möglichen zu vergrößern und um so eine maximale Separation zwischen den parasitären Ausgangskapazitäten der Aufladeschaltung und der Anode des Lasers zu erhalten.

Somit ist bevorzugt der Wert der Aufladeleitungsinduktivität größer und insbesondere signifikant größer als der Wert der Entladeleitungsinduktivität.

Bevorzugt umfasst das Laser-Modul einen integrierten Schaltkreis, bei dem die Kathoden der Laser des linearen Laser-Arrays aus n Lasern (d.h. der Laser-Zeile) zu einem Sternpunkt bonddrahtlos zusammengeschaltet sind. Bevorzugt wird dazu das Laser-Modul mit einem gemeinsamen Rückseitenkontakt, der in dem hier vorgestellten Beispiel die gemeinsame Kathode der n Laser darstellt, direkt mit einem Kontakt des Ansteuerschalters verbunden, so dass dieser Ansteuerschalter mit einem Anschluss praktisch induktivitätslos mit den Kathoden der n Laser verbunden ist. Der Kristall (d.h. das Die) des integrierten Schaltkreises leitet dabei die Verlustwärme der n-Laser ab. Bevorzugt ist die Rückseite des linearen Laser-Arrays somit thermisch und elektrisch leitfähig mit einem Kontakt des Ansteuerschalters verbunden, der bevorzugt monolithisch in den Kristall der bevorzugt verwendeten integrierten Schaltung integriert ist. Diese Verbindung kann durch Klebung oder Lötung oder eine andere geeignete elektrisch und thermisch leitende Verbindungstechnik, wie z.B. Thermokompression von Bond-Balls oder eine andere Flip-Chip-Montage-Technik hergestellt werden. Bevorzugt ist der Stapel aus dem Kristall (Die) des linearen Laser-Arrays oder den Kristallen (Dies) der einzelnen Dioden-Laser und dem Kristall (Die) der integrierten Schaltung mit dem Ansteuerschalter und bevorzugt mit der Aufladeschaltung thermisch und bevorzugt auch elektrisch leitend mit der Rückseite der integrierten Schaltung auf einer Wärmesenke, beispielsweise mittels thermisch und bevorzugt elektrisch leitender Klebung oder Lötung montiert.

Wie bereits erwähnt, sind der Ansteuerschalter und bevorzugt die n Aufladeschaltungen für die n Kondensatoren des einzeiligen Kondensatoren-Arrays Teil der integrierten Schaltung. Der Ansteuerschalter ist bevorzugt bonddrahtlos mit dem ersten Sternpunkt, der z.B. die Kathoden der n Laser miteinander verbindet, elektrisch verbunden.

In den Kristall des integrierten Schaltkreises sind, wie erwähnt, bevorzugt der Ansteuerschaltkreis und die n Aufladeschaltungen in die der Rückseite des Kristalls gegenüberliegende aktive Oberfläche integriert. Somit sind die n Aufladeschaltungen Teil der aktiven Oberfläche der integrierten Schaltung, was bedeutet, dass sie im Wesentlichen direkt unter der Oberfläche des Kristalls bzw. an dessen Oberfläche platziert sind. Parallel zu dem linearen Laser-Array aus n Lasern ist nun auch das lineare Kondensator-Array aus n Kondensatoren auf der aktiven Oberfläche des monolithischen Kristalls (Die) der integrierten Schaltung angebracht.

Diese Parallelität bezieht sich dabei nicht nur auf eine zeitliche Parallelität, sondern auch auf eine räumliche Parallelität. Die n Laser des Laser-Arrays sind bevorzugt längs einer ersten geraden Linie angeordnet. Die n Kondensatoren des Kondensatoren-Arrays sind bevorzugt längs einer zweiten geraden Linie angeordnet, die erstens bevorzugt parallel zur zweiten Linie ist oder zweitens als an der Unterseite des Kondensator-Arrays liegend gedacht sein kann. Ebenso kann die erste Linie als an der Unterseite des Laser-Arrays liegend gedacht sein. Die erste Linie und die zweite Linie definieren dann eine Ebene, die mit der aktiven Oberfläche des Kristalls der elektrischen Schaltung bevorzugt gleich ist oder zumindest im Wesentlichen zu dieser Oberfläche parallel und nur so wenig durch Befestigungsmittel, wie beispielsweise Kleber oder Lot, von dieser beabstandet ist, dass hier von einer im Wesentlichen Gleichheit der Ebene und der Oberfläche des Die gesprochen werden kann.

Jeder der n Kondensatoren des Kondensator-Arrays weist einen ersten Anschluss und einen zweiten Anschluss auf. Der erste Anschluss jedes Kondensators des linearen Kondensator-Arrays ist zur Reduktion der Entladezuleitungsinduktivität durch eine Mehrfach-Bondung mit einer ersten Bonddrahtlänge mit der Anode des diesem Kondensator zugeordneten Lasers des linearen Laser-Arrays aus n Lasern verbunden. Die zweiten Anschlüsse der n Kondensatoren des Kondensator-Arrays sind zu einem zweiten Sternpunkt zusammengeschaltet. Dieser zweite Sternpunkt ist zur weiteren Entladezuleitungsinduktivitätsreduktion mit einer Mehrzahl von Bonddrähten mit einer zweiten Bonddrahtlänge mit einem Bezugspotenzialkontakt auf der aktiven Oberfläche des Kristalls der integrierten Schaltung verbunden. Diese Konstruktion hat wesentliche Vorteile. Wenn nur einer der Kondensatoren der n Kondensatoren des Kondensator-Arrays durch die ihm zugeordnete Aufladeschaltung aufgeladen wurde und alle anderen Kondensatoren nicht geladen sind, sind diese ungeladenen Kondensatoren im Wesentlichen auf eine Spannung von nahe 0V oder eine derart geringe Spannung aufgeladen, die zur "Zündung" der diesen anderen Kondensatoren zugeordneten Lasern bei weitem nicht ausreicht. Mit dem Eintreffen des Pulssignals verbindet nun der Ansteuerschalter den ersten Sternpunkt mit dem Bezugspotenzial. Zum Ersten wird dadurch der betreffende zuvor aufgeladene Kondensator über den ihm zugeordneten Laser entladen. Zum Zweiten werden aber die ersten Anschlüsse aller anderen Kondensatoren über ihre Laser ebenfalls mit dem Bezugspotenzial verbunden. Da die zugehörigen Kondensatoren dieser Laser im Wesentlichen ungeladen sind, erzwingen diese übrigen Kondensatoren, dass das Potenzial der zweiten Anschlüsse dieser Kondensatoren, die den zweite Sternpunkt bilden, sich ebenfalls nahe des Bezugspotenzials bewegen müssen. Bevorzugt sind die ersten Anschlüsse der Kondensatoren des linearen Kondensator-Arrays über jeweils einen eine dritte Bonddrahtlänge aufweisenden Bonddraht, der den zweiten Sternpunkt kreuzt, mit der dem jeweiligen Kondensator der n Kondensatoren des Kondensator-Arrays zugeordneten Aufladeschaltung der n Aufladeschaltungen verbunden. Die dritte Bonddrahtlänge ist dabei bevorzugt länger als die zweite Bonddrahtlänge. Die zweite Bonddrahtlänge ist dabei bevorzugt länger als die erste Bonddrahtlänge.

Dieses so definierte Laser-Modul kann in einem LIDAR-System eingesetzt werden. Es wird vorgeschlagen, dazu die folgende Grundstruktur eines LIDAR-Systems anzuwenden:

Das vorgeschlagene LIDAR-System umfasst bevorzugt das besagte lineare Laser-Array aus n Lasern, einen Fotosensor mit einem 2D-Fotodetektor-Array aus n x m Fotodetektoren (nachfolgend mitunter auch mit Fotodioden bezeichnet), mit m Fotodetektoren (m als ganze Zahl größer und vornehmlich sehr viel größer als 1) in jeder n von Spalten oder Zeilen, eine Ansteuerschaltung für die n Laser, n x m Empfangsschaltungen für die n x m Fotodetektoren und eine Auswerteschaltung für die Messsignale der n x m Empfangsschaltungen. Die Optik des LIDAR-Systems umfasst auf der Laser-Seite, d.h. für die Lasterstrahlen, bevorzugt eine Powell-Linse, oder eine funktionsäquivalente Optik, die im Folgenden von dem Begriff Powell-Linse mit umfasst sein soll, und auf der Fotodetektorseite, d.h. im Strahlengang von der durch die Laser streifenweise sequentiell beleuchteten Szene zum Fotosensor, bevorzugt eine zweite Optik, im Folgenden als Empfängerlinse bezeichnet. Jeder Laser der n Laser emittiert einen jeweiligen Laser-strahl bei Bestromung mit elektrischem Strom. Die Powell-Linse weitet bevorzugt jeden Laserstrahl zu einem Lichtfächer auf. In der Realität wird jeder Lichtfächer einen stark elliptischen Strahlungsquerschnitt quer zu seiner Ausbreitungsrichtung aufweisen. Im Sinne dieser Erfindung wird in der Beschreibung vereinfachend angenommen, dass die kurze Halbachse der Querschnittsellipse oder des Querschnittsovals ein Längenmaß von praktisch 0 cm besitzt. Da der reale Querschnitt von 0 cm verschieden ist, wird hierdurch die Erfindung nicht eingeschränkt. Diese Annahme von 0 cm Fächerdicke dient also nur der Vereinfachung der Beschreibung. Jeder Lichtfächer hat einen Öffnungswinkel. Jeder Lichtfächer besitzt eine Lichtfächerebene und einem Fächerursprungspunkt. Die Powell-Linse wird relativ zum linearen Laser-Array der n Laser derart angeordnet, dass bevorzugt die Flächennormalen der n Lichtfächerebenen der Lichtfächer der n Laser bevorzugt in einer gemeinsamen Ebene untereinander und zusammen mit der geraden Linie liegen, längs derer bevorzugt die n Laser angeordnet sind. Bevorzugt erzeugen die n Laser des Laser-Arrays n Laserstrahlen, deren n Lichtfächer senkrecht zu ihrer jeweiligen Fächerebene in einen im Wesentlichen gemeinsamen Fächerursprungspunkt um einen jeweiligen Fächerwinkel gegenüber einem frei wählbaren Lichtfächer der n Lichtfächer gekippt sind, und zwar um eine im Wesentlichen gemeinsame Rotationsachse durch diesen Fächerursprungspunkt.

Auf der Fotodetektorenseite findet eine ähnliche Verkippung statt. Jeder der Fotodetektoren besitzt typischerweise bereits konstruktiv bedingt eine Empfangskeule, die die raumrichtungsabhängige Empfindlichkeit des jeweiligen Fotodetektors beschreibt. Bevorzugt werden alle n x m Fotodetektoren in gleicher Weise ausgeführt. Bevorzugt werden sie auf einem Halbleiterkristall monolithisch integriert. Bevorzugt handelt es sich um eine oder n Fotodetektorenzeilen, wobei je Fotodetektorenzeile in der betreffenden Fotodetektorenzeile die m Fotodetektoren linear längs einer geraden Linie angeordnet sind. Es ist aber auch denkbar, nur eine Zeile von Fotodetektoren zu verwenden. Bei den n x m Fotodetektoren handelt es sich bevorzugt um Halbleiterbauelemente. Beispielsweise kommen Lawinenfotodioden (englisch: *avalanche photodiode* (APD)) und/oder Einzel-Photonen-Lawinenfotodioden (englisch: *single-photon avalanche diode* (SPAD)) in Frage. Die Empfängerlinse deformiert die n x m Empfangskeulen der n x m Fotodetektoren zu n x m Empfangsfächern. Auch hier wird wieder zur Vereinfachung angenommen, dass die Empfangsfächer eine Empfangsfächerdicke von im Wesentlichen 0 cm aufweisen. In der Realität ist diese Annahme nicht richtig und der Empfangsfächer ist analog zum Lichtfächer der Laser tatsächlich eine Empfangskeule mit typischerweise stark elliptischem Querschnitt. Auch diese Vereinfachung der Annahme einer Empfangsfächerdicke von 0 cm soll hier nur der Vereinfachung der Beschreibung dienen und schränkt daher die Erfindung nicht ein. Die n x m Empfangsfächer besitzen nun jeweils eine Empfangsfächerebene. Es werden somit n x m Empfangsfächerebenen durch die zweite Optik definiert. Jede Empfangsfächerebene der n x m Empfangsfächerebenen der n x m Fotodetektoren ist nicht parallel zu den n Laserfächerebenen der n Lichtfächer der n Laser. Bevorzugt ist jede Empfangsfächerebene der n x m Empfangsfächerebenen der n x m Fotodetektoren senkrecht jeder der n Laserfächerebenen der n Lichtfächer der n Laser. Es ergeben sich somit bevorzugt k = n x m Kreuzungslinien, die die Empfindlichkeitslinie einer Paarung aus dem Empfangsfächer eines der n x m Empfangsfächer, der einem der n x m Fotodetektoren zugeordnet ist, und einem Lichtfächer der n Lichtfächer darstellen, der einem Laser der n Laser zugeordnet ist. Die Powell-Linse nimmt im System zwei Funktionen wahr. Diese Funktionen können auf die zwei Oberflächen der Powell-Linse verteilt werden. Die beiden Funktionen können allerdings auch mit einer einzelnen Linsenoberfläche implementiert werden. Diese beiden Funktionen sind

a. die vertikale Fokussierung aller Laser und

EP 4 088 136 B1

b. das sogenannte horizontale Flat-Fielding der Laserleistung, also die Gleichverteilung der Laser-Leistung, um eine Zeile des aufzunehmenden Bildes homogen auszuleuchten, wobei diese Gleichverteilung für alle Laser gleich erfolgt.

Eine Zylinderoberfläche realisiert im Wesentlichen die Funktion a. Terme höherer Ordnung erweitern die mathematische Funktion, die die Zylinderoberfläche beschreibt, um die Abbildungsfehler zu minimieren. Der vertikale Krümmungsradius ist eine Funktion des horizontalen Abstands zur Mitte der Linse, was einen besseren Fokus an den Enden der Linien bewirkt.

Ein Polynom für die Oberflächenform der Linse implementiert die Funktion b. Das Polynom beschreibt die Dicke der Linse als Funktion des horizontalen Abstands zur Mitte. Hierdurch kann die Linse die Energie der Laser-Strahlen praktisch fast beliebig horizontal umverteilen.

Eine durch ein Polynom beschriebene horizontalen Krümmung der Linse als Funktion des horizontalen Abstands zur Mitte ergibt eine weitere Optimierung. Dieses Polynom ermöglicht Korrektur der (Kissen-)Verzerrung der Linse.

Alle Polynome haben auch einen schwachen Einfluss auf die jeweils anderen Funktionen (vertikale Fokussierung, horizontale Energieverteilung, Verzerrungskorrektur), so dass bei der Optimierung alle Parameter aufeinander abgestimmt werden müssen. Hierzu wird iterativ immer erst eine Funktion optimiert. Dann werden nacheinander die entstandenen Fehler in den anderen Funktionen korrigiert. Durch zyklisches Wiederholen stabilisiert sich die Konstruktion bei typischerweise immer kleiner werdenden Fehlern. Das Ganze wird nun wiederholt, bis die Fehler klein genug sind.

Die im Zuge der Entstehung der Erfindung beispielhaft ermittelten Parameter sind noch nicht gänzlich optimiert, aber sie sind besser als im Stand der Technik.

Die Gleichungen für die Linse lauten:

Gleichung für die Oberflächenstruktur der Vorderseite:

$$z = RY + AR2{*}x^2 + AR3{*}|x^3| - \text{Sign}(RY){*}\text{Sqrt}(Ry^2 - y^2) + PB2{*}x^2 + PB3{*}|x^3| + PB4{*}x{*} + PB6{*}x + PC2{*}x^2 + PC3{*}|x^3| \text{ mit } RY = R0Y + AR2{*}x^2 + AR3{*}|x^3|$$

Hierbei steht Sign() für die Signum-Funktion und Sqrt() für die Wurzel des Funktionsparameters.

Hierbei steht z für den Abstand zur x-y-Mittenebene, wobei die optische Achse die z-Achse ist.

Gleichung der Oberflächenstruktur der Rückseite:

$$z = -(d + PC2{*}x^2 + PC3{*}|x^3|)$$

Hierbei bedeuten:

x     horizontale Achse
y     vertikale Achse
z     optische Achse
R0Y     Krümmungsradius des Zylinderterms, der die Brennweite bestimmt. R0Y = 12.6 mm wurde als ein Beispiel bei Erfindung benutzt. Dieser Krümmungsradius wird durch den Abstand von Laser zu Laser und den Abstand der Sensoren in der Sensorzeile, sowie durch die Brennweite der Empfängerlinse bestimmt. Es gilt dabei

$$f_{tx}/p_{tx} = f_{rx} / p_{rx}$$

mit

$f_{tx}$     Brennweite der Linse der Laser
$f_{rx}$     Brennweite der Linse der Sensorzeile
$p_{tx}$     Abstand von Laser zu Laser
$p_{rx}$     Abstand von Empfänger zu Empfänger in der Sensorzeile
d     Dicke der Linse im optischen Zentrum. Bei der Erfindung wurde beispielhaft d = 2.2 mm benutzt
AR2, AR3     Koeffizienten der Polynome höherer Ordnung für den Gradienten der Krümmung
PB2, PB3, PB4, PB6     Koeffizienten, die den horizontalen Dickenverlauf der Linse beschreiben
PC2, PC3     Koeffizienten, die die Krümmung der Linse (beide Oberflächen gleich) beschreiben.

Im Rahmen der Entstehung der Erfindung wurden verschiedene Linsen ausgetestet.

Die Parameter einer ersten Linse waren wie folgt:

AR2=0, AR3=0
PB2=-0.0085, PB3=0.0008, PB4=0, PB6=0
PC2=0, PC3=0

Die Parameter einer zweiten Linse waren wie folgt:

AR2=0.01, AR3=0.0006
PB2=-0.0085, PB3=0.0008, PB4=0, PB6=0
PC2=0, PC3=0

Die Parameter einer dritten Linse waren wie folgt:

AR2=0.01, AR3=0.0005
PB2=-0.015, PB3=0.0015, PB4=-0.000024, PB6=0
PC2=0, PC3=0

Die Parameter einer vierten Linse waren wie folgt:

AR2=0.028, AR3=-0.0028
PB2=-0.0115, PB3=0.00038, PB4=-0.000034, PB6=0.00000013
PC2=0.028, PC3=-0.0032

Nachfolgend werden die elektrischen Funktionen eines beispielhaften LIDAR-Systems nach der Erfindung beschrieben.

Die Ansteuerschaltung veranlasst nun zu einem Aussendezeitpunkt einen der n Laser zur Emission eines Laserlichtpulses. Eine Kontrollschaltung veranlasst hierzu vor der Emission beispielsweise eine der n Aufladeschaltungen des zuvor beschriebenen Laser-Moduls, den ihr zugeordneten Kondensator aufzuladen. Alle anderen Kondensatoren sollen ungeladen sein und auch für die Dauer des Verfahrens zur Aussendung eines Lichtpulses durch den dem zu ladenden Kondensator zugeordneten Laser ungeladen bleiben. Nach Abschluss des Ladevorgangs, der beispielsweise zeitgesteuert nach einer vordefinierten oder berechneten Zeit gestoppt wird oder nach dem Erreichen oder Überschreiten einer Kondesatorzielspannung gestoppt wird, wird bevorzugt die Aufladeschaltung von dem zu ladenden Kondensator, beispielsweise durch einen Schalter und/oder durch Hochohmig-Schalten des Ausgangs der Aufladeschaltung getrennt. Nachdem durch die Aufladung des Kondensators eine der Kombinationen aus Laser und Kondensator der n Paare aus Laser und zugeordnetem Kondensator auf diese Weise scharf geschaltet ist, kann die schlagartige Entladung des Kondensators über den Laser und den Ansteuerschalter durch Schließen desselben erfolgen. Hierzu erzeugt bevorzugt eine Kontrollschaltung, die bevorzugt Teil der Ansteuerschaltung ist, ein Pulssignal, das bevorzugt den besagten Ansteuerschalter schließt und somit beispielsweise die Kathode des Lasers mit dem Bezugspotenzial verbindet. Der geladene Kondensator ist bevorzugt mit seinem zweiten Anschluss mit diesem Bezugspotenzial verbunden und bevorzugt mit seinem ersten Anschluss mit der Anode des Lasers verbunden. Somit wird der zuvor geladene Kondensator über den ihm zugeordneten Laser schlagartig entladen. Der Laser emittiert einen Lichtpuls. Die anderen Laser der n Laser emittieren keinen Lichtpuls, da ihre zugeordneten Kondensatoren nicht geladen bzw. nicht ausreichend geladen sind. Theoretisch ist es möglich, mehr als einen Kondensator zu laden und dann nach und nach verschiedene Lademuster zu verwenden und dann wieder auf den einfachen Fall eines einzigen geladenen Kondensators zurückzurechnen.

Der Lichtpuls wird nun über die besagte Powell-Linse zu einem Lichtfächer aufgeweitet und in den Freiraum vor der Vorrichtung emittiert. In diesem Freiraum trifft der Lichtpuls dann nach einer ersten Lichtlaufzeit auf ein hier beispielhaft angenommenes Objekt und wird dort als reflektierter Lichtpuls zurückreflektiert. Nach einer zweiten Lichtlaufzeit erreicht der reflektierte Lichtpuls dann die zweite Optik, die die Photonen des reflektierten Lichtpulses auf die n x m Fotodetektoren verteilt. Hierbei ordnet die zweite Optik dann ein Photon des reflektierten Lichtpulses einem der n x m Fotodetektoren zu, wenn der Ausbreitungsvektor des betreffenden Photons richtungsmäßig in dem entsprechenden Empfindlichkeitsfächer, der diesem Fotodetektor zugeordnet ist, liegt - oder anderes ausgedrückt - wenn die Richtung aus der das Photon kam, in dem Empfindlichkeitsfächer liegt.

Bevorzugt erfassen somit jeder Fotodetektor und die diesem zugeordnete Empfangsschaltung das reflektierte Licht dieses Laserpulses innerhalb ihres jeweiligen Empfangsfächers. Darüber hinaus verfügen die Empfangsschaltungen bevorzugt über Mittel, um die Laufzeit des Lichtpulses ab dem Aussendezeitpunkt bis zum Empfangszeitpunkt in dem Fotosensor zu erfassen. Somit ergeben sich bevorzugt für jeden Laserpuls n x m Lichtlaufzeitinformationen, die die Lichtlaufzeit eines Lichtpulses vom Zeitpunkt des Aussendens (Aussendezeitpunkt) durch einen Laser bis zum Zeitpunkt des Empfangs (Empfangszeitpunkt) durch jeweils einen Fotodetektor als von der Szene reflektierten Lichtpuls repräsentieren. Diese Lichtlaufzeitinformationen können mittels der Lichtgeschwindigkeit, beispielsweise der Lichtgeschwindigkeit in Luft, in eine Länge bzw. in einen Abstand umgerechnet werden.

Wird diese Messung für jeden der n Laser durchgeführt, so erhält man aus den daraus sich ergebenden n Messungen k = n x m Lichtlaufzeitwerte und damit k = n x m Abstände, nämlich für jeden einer Fotodiode zugeordneten Bildpunkt einen Abstand.

Um diese Abstände zu erhalten, gibt die jeweilige Empfangsschaltung den jeweiligen Messwert für den Empfangszeitpunkt des jeweiligen Laserpulses an der jeweiligen Fotodiode an die Auswerteschaltung weiter. Diese erhält von der Steuerschaltung die Information, welcher der n Laser den Lichtpuls abgegeben hat. Hieraus kann die Auswerteschaltung dann feststellen, welche Empfindlichkeitslinie zu welchem Abstand gehört. Es sei darauf hingewiesen, dass eine Empfindlichkeitslinie im Sinne dieser Erfindung aus dem Paar aus dem Empfangsfächer einer der n x m Fotodioden und einem der Lichtfächer der n Laser entsteht.

Nachdem alle n Laser des Laser-Arrays einmal einen Lichtpuls abgegeben haben ergeben sich für die k Empfindlichkeitslinien k Abstände. Werden diese auf der Empfindlichkeitslinie abgetragen, so ergibt sich für jede Empfindlichkeitslinie genau ein Punkt, der die Reflektion des Lichtpulses für den Lichtfächer dieser Empfindlichkeitslinie verursacht hat und von dem Fotosensor mit dem Empfindlichkeitsfächer dieser Empfindlichkeitslinie empfangen wurde. Auf diese Weise werden somit k = n x m Anstände im dreidimensionalen Raum bestimmt, die vorzugsweise aus dem Abstandsempfindlichkeitslinien-Koordinatensystem beispielsweise in ein kartesisches Koordinatensystem zur weiteren Verwendung umgerechnet werden können.

Die Auswerteschaltung erstellt somit eine dreidimensionale Pixelwolke aus dem Winkel des Laserfächers des jeweiligen Laserpulses und dem Winkel des jeweiligen Empfangsfächers des jeweiligen Fotodetektors und dem jeweiligen Empfangszeitpunkt des jeweiligen Laserpulses am jeweiligen Fotodetektor bezogen auf den jeweiligen Aussendezeitpunkt.

Es ist besonders vorteilhaft, wenn die n Flächennormalen der n Lichtfächer Winkelabstände ($a_{1,2}$, $a_{2,3}$, $a_{3,4}$, bis $a_{n-2,n-1}$, $a_{n-1,n}$) aufweisen, die zwischen jeweils zwei benachbarten Lichtfächern im Wesentlichen gleich sind.

Ebenso ist es besonders vorteilhaft, wenn die n x m Flächennormalen der n x m Empfindlichkeitsfächer m Winkelabstände ($b_{1,2}$, $b_{2,3}$, $b_{3,4}$, bis $b_{m-2,m-1}$, $b_{m-1,m}$) in der Horizontalen aufweisen, die zwischen jeweils zwei benachbarten Empfindlichkeitsfächern im Wesentlichen gleich sind.

Es ist besonders vorteilhaft, das weiter oben beschriebene Laser-Modul in einem zuvor beschriebenen LIDAR-System einzusetzen.

Die Erfindung umfasst des Weiteren ein Laser-Modul mit einem linearen Laser-Array aus n Lasern, mit n als ganzer positiver Zahl. Die n-Laser sind bevorzugt auf einem Modulträger und/oder einem Treiber-IC montiert. Jeder Laser-Strahl jedes Lasers weist eine Laser-Strahlachse auf. Alle Laser-Strahlachsen und/oder mindestens zwei Laserstrahlachsen schneiden sich in einem Punkt. Darauf aufbauend kann eine Zusammenstellung von p Laser-Modulen, mit p als ganze positive Zahl, definiert werden, bei der jedes Laser-Modul ein lineares Laser-Array aus n Lasern aufweist, mit n als ganzer positiver Zahl, und wobei die Laser eines jeden Moduls in gleicher Weise durchnummeriert werden können und wobei jeder Laser-Strahl jedes Lasers eine Laser-Strahlachse aufweist und wobei sich die Laser-Strahlachsen der jeweils k-ten Laser, mit 0<k≤n, aller p Laser-Module in einem gemeinsamen Punkt schneiden und/oder wobei sich die Laser-Strahlachsen der jeweils k-ten Laser, mit 0<k≤n, von mindestens zwei der p Laser-Module in einem Punkt schneiden.

Besser ist es jedoch, wenn sich die Laser-Strahlachsen sämtlicher n x p Laser aller p Laser-Module in einem gemeinsamen Punkt schneiden. Alternativ können sich zumindest zwei Laser-Strahlachsen von mindestens zwei Lasern der n x p Laser aller p Laser-Module in einem Punkt schneiden. Das Treiber-IC ist bevorzugt die besagte integrierte Schaltung. Ein solches Treiber-IC hat bevorzugt eine rechteckige Form. Das Treiber-IC weist dann zwei Schmalseiten und zwei Langseiten als Randabschnitte auf. Das Treiber-IC weist bevorzugt an einem ersten Randabschnitt Rechteckform, der von der einen Schmalseite gebildet ist, Kontakte oder einen Kontakt DisC auf, die dazu bestimmt und geeignet sind einen oder mehrere Rückseitenkontakte von Diodenlasern zu kontaktieren. Das IC weist an einem zweiten Randabschnitt seiner Rechteckform, der von der anderen Schmalseite gebildet ist, Kontakte VDDA, GNDA, VDDD, GNDD, VDDP, GNDP, VDDH, GND auf, die der Energieversorgung des Treiber-ICs und/oder der besagen Laser D1 bis Dn und/oder der zu diesen gehörenden Energiespeicher, d.h. der Kondensatoren C1 bis Cn dienen. Der erste Randabschnitt liebt dabei dem zweiten Randabschnitt gegenüber.

Das Treiber-IC weist bevorzugt an einem dritten Randabschnitt seiner Rechteckform, der von der einen Längsseite gebildet ist, mindestens einen Transfer-Kontakt für ein Signal auf, das an andere Treiber-ICs weitergegeben werden kann. Das Treiber-IC weist an einem vierten Randabschnitt seiner Rechteckform, der von der anderen Langseite gebildet ist, einen weiteren Transfer-Kontakt auf, der elektrisch mit dem Transferkontakt eines anderen Treiber-ICs verbunden ist.

Bevorzugt ist einer der Transferkontakte ein Kontakt für ein Rücksetzsignal RES, das das Treiber-IC in einen definierten Zustand versetzt. Bevorzugt ist ein Transferkontakt ein Kontakt für ein Trigger-Signal TRIG, das das Treiber-IC in einem vorbestimmten Signalzustand dazu veranlasst, seine Laser D1 bis Dn anzusteuern, sofern dies aufgrund des Systemzustands vorgesehen ist. Bevorzugt sind einer oder mehrere Transfer-Kontakte für den Empfangs zur Kontaktierung von Signalen eines Datenbusses bestimmt. Der eine oder die mehreren Transfer-Kontakte an dem einen Randabschnitt des Treiber-ICs sind bevorzugt mit einem oder mehreren korrespondieren Transfer-Kontakten an der gegenüberliegenden Kante eines benachbarten Treiber-ICs direkt elektrisch verbunden. Es ist aber auch denkbar, dass ein linearer Datenbus (z.B. ein LIN-Bus) zumindest zeitweise durch die Treiber-ICs als Busknoten unterbrochen wird und interne Vorrichtungsteile des Treiber-ICs die Daten auf der einen Seite des Treiber-ICs in Empfang nehmen und auf der anderen Seite des ICs gegebenenfalls auch modifiziert weitersenden können. In dem Fall werden die Signale des einen oder der mehreren Transfer-Kontakte an dem einen Randabschnitt des Treiber-ICs vor der Weiterleitung an einen oder mehrere korrespondiere Transfer-Kontakten an dem gegenüberliegenden Randabschnitt eines benachbarten Treiber-ICs in einer Teilvorrichtung des Treiber-ICs, insbesondere in einer Datenbusschnittstelle, verarbeitet.

Des Weiteren umfasst diese Erfindung eine Zusammenstellung von Laser-Modulen zu insbesondere einem LIDAR-System mit mindestens zwei Laser-Modulen, also mit mindestens einem ersten Laser-Modul und einem zweiten Laser-Modul, wobei die Laser-Module im Wesentlichen eine Quader-Form mit zwei Schmalseiten und zwei Langseiten haben und wobei die Laser-Module mit Ihren Langseiten nebeneinander angeordnet sind.

Die Laser-Module weisen jeweils ein Treiber-IC in einem quaderförmigen Gehäuse, wie zuvor beschrieben, auf, das auf einem Träger nebeneinander angeordnet sind.

Die Treiber-ICs der Laser-Module sind typischerweise hinsichtlich der genutzten Transfer-Kontakte ihrer Treiber-ICs baugleich. Jeweils ein Transfer-Kontakt des Treiber-ICs des ersten Laser-Moduls ist dann bevorzugt mit dem korrespondierenden Transfer-Kontakt des Treiber-ICs des zweiten Laser- Moduls mittels eines einzigen Bonddrahts pro solch eines Transfer-Kontakt-Paars elektrisch verbunden. Dies hat den Vorteil, dass nur geringe Verluste entstehen. Die ist insbesondere für eine schnelle synchrone Übertragung des Trigger-Signals TRIG vorteilhaft, da alle Laser zeitlich aufeinander abgestimmt sukzessive zünden und somit ihr Strahlungspaket aussenden sollen.

Die Erfindung verwendet ferner vorteilhafterweise ein spezielles Kondensator-Array für ein Laser-Modul und/oder für eine Zusammenstellung von Laser-Modulen und/oder für die Verwendung zusammen mit einem Treiber-IC, wie jeweils zuvor beschrieben. Das Kondensator-Array hat z.B. eine Rechteckform und weist eine Oberseite und eine Unterseite auf. Das Kondensator-Array weist auf seiner Oberseite n Kontakte K1' bis Kn' aufgereiht längs eines ersten Randes des Rechtecks auf. Das Kondensator-Array weist einen weiteren Kontakt KG' auf, der sich längs eines zweiten Randes des Rechtecks auf der Oberseite des Kondensator-Arrays erstreckt. Der zweite Rand des Rechtecks liegt dem ersten Rand des Rechtecks gegenüber. Der weitere Kontakt KG' erstreckt sich längs der dritten und vierten Ränder um eine Distanz, die kürzer ist als die Erstreckung der dritten und vierten Ränder des Rechtecks und endet im Abstand zu den Kontakten K1' bis Kn'. Das Kondensator-Array weist einen Unterseitenkontakt KR auf, der die Unterseite des Kondensator-Arrays bedeckt. Jeder der n Kontakt K1' bis Kn' bildet mit dem Rückseitenkontakt KR eine Kapazität C1 bis Cn, wobei der weitere Kontakt KG' mit dem Rückseitenkontakt KR eine weitere Kapazität CVDD bildet und wobei die Kondensatoren C1 bis Cn und CVDD ein gemeinsames Dielektrikum aufweisen, das sich zwischen den n Kontakten K1' bis Kn' und dem weiteren Kontakt KG' einerseits und dem Unterseitenkontakt KR andererseits erstreckt.

Die vorgestellten Vorrichtungen können als LIDAR-System oder als Teil eines solchen LIDAR-Systems in einer mobilen Vorrichtung verwendet werden. Dabei kann beispielsweise die mobile Vorrichtung insbesondere ein Roboter oder ein Flugkörper oder ein Raumflugkörper oder ein Schiffskörper oder ein Wasserfahrzeug oder ein Fahrzeug oder ein Schienenfahrzeug oder Flugzeug oder ein Raumfahrzeug sein. Durch Oszillation der mobilen Vorrichtung kann die Auflösung der Abstandsinformation der beleuchteten Szene erhöht werden.

Die vorgestellten Vorrichtungen können als LIDAR-System oder als Teil eines solchen LIDAR-Systems in der Automatisierungstechnik eingesetzt werden. Sie können beispielsweise in einer Vorrichtung zur Erfassung der Form eines Gegenstands oder eines Gebäudes oder in einer Vorrichtung zur Automatisierung von Prozessen oder in einer Vorrichtung zum dreidimensionalen Erfassen der Form dreidimensionaler Körper eingesetzt werden.

Das vorgeschlagene Laser-Modul ermöglicht die Erzeugung kurzer Lichtimpulse für ein LIDAR-System, das keine beweglichen Teile erfordert. Die Vorteile sind darauf allerdings nicht beschränkt.

Das Lichtmodul, das gemeinsame Kondensatorbauteil, die Zusammenstellung mehrerer Lichtmodule, das Schaltungs-Die und die integrierte Schaltung zum Schalten elektrischer Ströme, wie sie vorstehend beschrieben und in der Anspruchsfassung hinsichtlich ihrer Merkmale definiert sind, sind als selbstständige Erfindungen aufzufassen, die auch unabhängig voneinander umgesetzt werden können. Dasselbe gilt für die Merkmale der einzelnen Unteransprüche der Anspruchsfassung, die selbstständige Erfindung definieren, also nicht zwingend ausschließlich im Zusammenhang mit anderen Merkmalen anderer Unteransprüche stehen müssen.

Die vorstehend und/oder nachfolgend beschriebenen Merkmale der Erfindung bzw. der einzelnen Aspekte der Erfindung sind auch dann, wenn sie im Zusammenhang mit anderen Merkmalen beschrieben sind, als voneinander unabhängige, einzelne Merkmale zu verstehen, die sowohl einzeln als auch mit den mit ihnen gegebenenfalls im Zusammenhang beschriebenen weiteren Merkmalen selbstständig realisierbar und erfindungswesentlich sind.

Sofern im Vorstehenden und Nachfolgenden von "Licht" der Dioden oder von Reflexionslicht die Rede ist, ist damit in erster Linie Licht in einem Wellenlängenbereich außerhalb desjenigen für sichtbares Licht gemeint. Die Erfindung lässt sich aber auch mit sichtbarem Licht realisieren.

Die Erfindung wird nachfolgend anhand mehrerer Ausführungsbeispiele näher beschrieben. Im Einzelnen zeigen dabei:

Fig. 1 den Strahlengang eines beispielhaften LIDAR-Systems mit beispielhaft n = 4 Lasern und beispielhaft m = 256 Fotodetektoren eines Sensors in der Aufsicht und der Seitenansicht, wobei der erste Laser einen Laserpuls abgibt und dessen Laserflächen die erste Zeile eines Bildes beleuchtet, die von den Fotodioden der ersten Zeile des Sensors durch Lichtreflektion erfasst wird,

Fig. 2 den Strahlengang des LIDAR-Systems mit den vier Lasern und den 256 Fotodetektoren in der Aufsicht und der Seitenansicht, wobei der zweite Laser einen Laserpuls abgibt,

Fig. 3 den Strahlengang des LIDAR-Systems mit den vier Lasern und den 256 Fotodetektoren in der Aufsicht und der Seitenansicht, wobei der dritte Laser einen Laserpuls abgibt,

Fig. 4 den Strahlengang des LIDAR-Systems mit den vier Lasern und den 256 Fotodetektoren in der Aufsicht und der Seitenansicht, wobei der vierte Laser einen Laserpuls abgibt,

Fig. 5 eine beispielhafte Verschaltung für das vorgeschlagene LIDAR-System,

Fig. 6 einen vorgeschlagenen Aufbau eines Laser-Moduls für das LIDAR-System der Fig. 5,

Fig. 7 eine schematische Darstellung des hybriden Aufbaus aus dem Träger mit Schaltungs-Die und mit verschiedenen elektrischen und elektronischen Bauteilen in Die-zu-Die-Verbindung zu Anschlussfeldern auf der einen Hauptseite des Trägers,

Fig. 8 eine Anordnung mit mehreren Laser-Modulen der Fig. 6,

Fign. 9A, 9B, 9C ein Kondensator-Array C1 bis C4 Und CVDD für die Verwendung in einem Laser-Modul entsprechend der Fig. 7 in Aufsicht, Seitenansicht und die interne Verschaltung des Kondensator Arrays,

Fig. 10 die Struktur eines vorgeschlagenen Treiber-ICs in der Aufsicht,

Fig. 11 die Anreihung der Laser-Module auf Treiber-IC-Ebene,

Fig. 12 die Ausrichtung der Laser-Module der Fig. 11 längs einer gebogenen Linie,

Fig. 13 eine Draufsicht auf ein alternatives Lichtmodul mit 16 Laserdioden auf einem einzigen Träger bei Anordnung längs einer Krümmungslinie,

Fig. 14 eine beispielhafte Powell-Linse,

Fig. 15 eine beispielhafte Anordnung des Sendesystems mit der Senderlinse und des Empfängersystems mit der Empfängerlinse,

Fig. 16 ein reales Messergebnis als Punktwolke in einem beispielhaften kartesischen Koordinatensystem als Zielkoordinatensystem mit n = 16 Lasern und m = 256 Fotodetektoren in der Fotodetektorenzeile,

Fig. 17 eine erfindungsgemäße Drohne mit an ihr angebrachtem LIDAR-Modul,

Fig. 18 die optimale Positionierung der Abtastpunkte auf einer ebenen Fläche, die in einem gewissen Abstand zum Sensorsystem aufgestellt ist und deren Flächennormale parallel zur Messachse des Sensorsystems ausgerichtet ist,

Fig. 19 eine Linse ohne Korrekturpolynome,

Fig. 20 eine Linse mit den Parametern AR2=0.01, AR3=0.0006, PB2=-0.0085, PB3=0.0008, PB4=0, B6=0, PC2=0, PC3=0,

| | |
|---|---|
| Fig. 21 | eine Linse mit den Parametern AR2=0.01, AR3=0.0005, PB2=-0.015, PB3=0.0015, PB4=-0.000024, PB6=0, PC2=0, PC3=0, |
| Fig. 22 | eine Linse mit den Parametern AR2=0.028, AR3=-0.0028, PB2=-0.0115, PB3=0.00038, PB4=-0.000034, PB6=0.00000013, PC2=0.028, PC3=-0.0032, |
| Fig. 23 | eine beispielhafte, auf das wesentliche reduzierte, Schaltung nach dem Stand der Technik für die Ansteuerung einer Laserdiode LD mittels einer Treiberschaltung I und einer nicht näher spezifizierten Vortreiberschaltung und eines Feldeffekttransistors M, |
| Fig. 24 | in den Figurenteilen (a) bis (f) vereinfacht das Grundkonzept der Selbstähnlichkeit auf Basis des Schaltplans und des Schaltungslayouts, |
| Fig. 25 | in dem Figurenteil (a) ein vereinfacht dargestelltes Layout einer Grundstruktur der erfindungsgemäßen selbstähnlichen Struktur als Stick-Layout und in dem Figurenteil (b) wie weitere Grundstrukturen kombiniert werden, so dass sich letztendlich die erfindungsgemäße selbstähnliche Struktur ergibt, und |
| Fig. 26 | eine vereinfachte Darstellung der der Selbstähnlichkeit des Schaltungslayouts. |

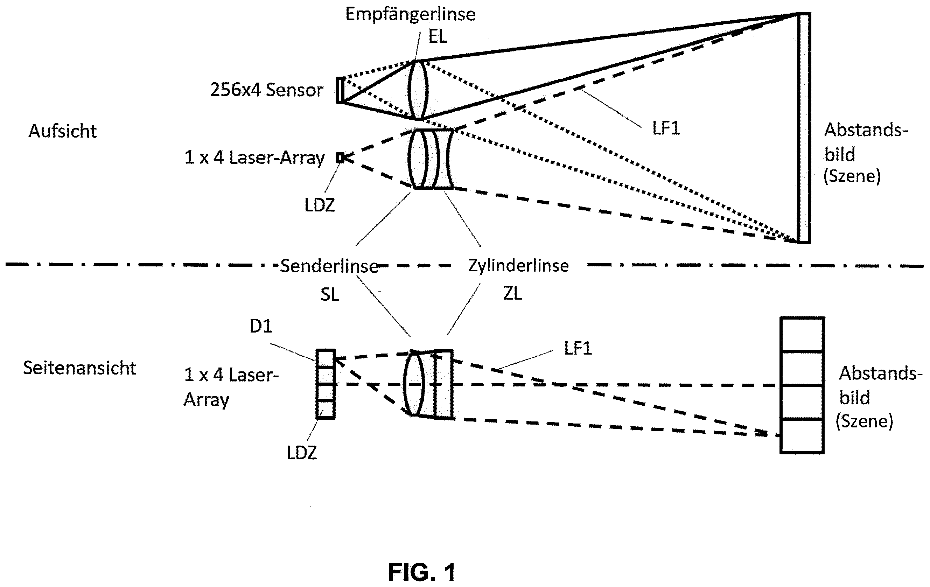

In den Ausführungsbeispielen der Fign. 1 bis 4 sind schematisch die Komponenten eines LIDAR-Systems gezeigt, das einen Sender in Form einer Laserdiodenreihe LDZ aus n = vier Lasern D1, D2, D3, D4 sowie einen Empfänger in Form eines 2D (Fotodioden-)Sensors S mit vier Zeilen und einer Anzahl von n = 256 Fotodioden pro Zeile sowie Linsen (Senderlinse SL und Zylinderlinse ZL) zum Auffächern der Strahlen der Laser zu einem stark elliptischen Querschnitt zur Beleuchtung einer Zeile eines aufzunehmenden Entfernungsbildes und eine Linse (Empfängerlinse EL) zur Abbildung der jeweils beleuchteten Zeile aufweist.

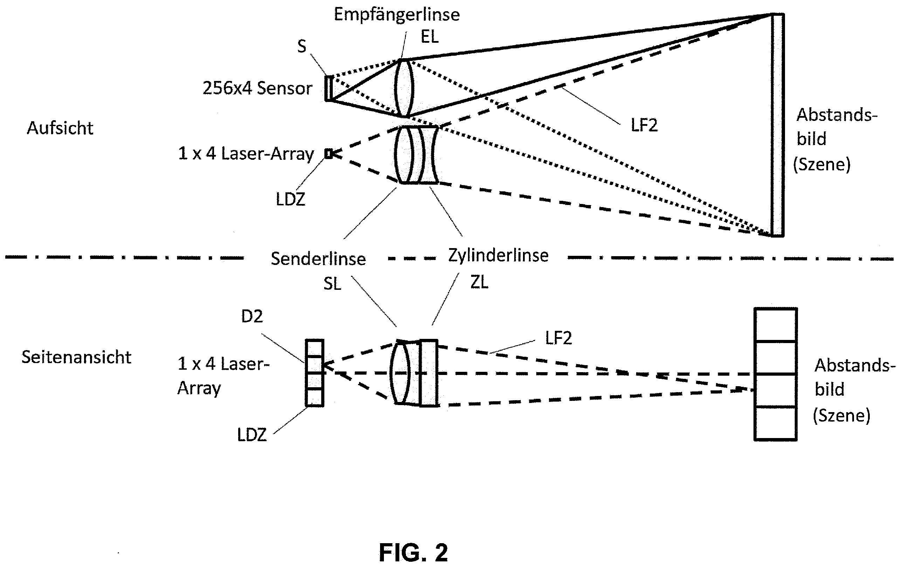

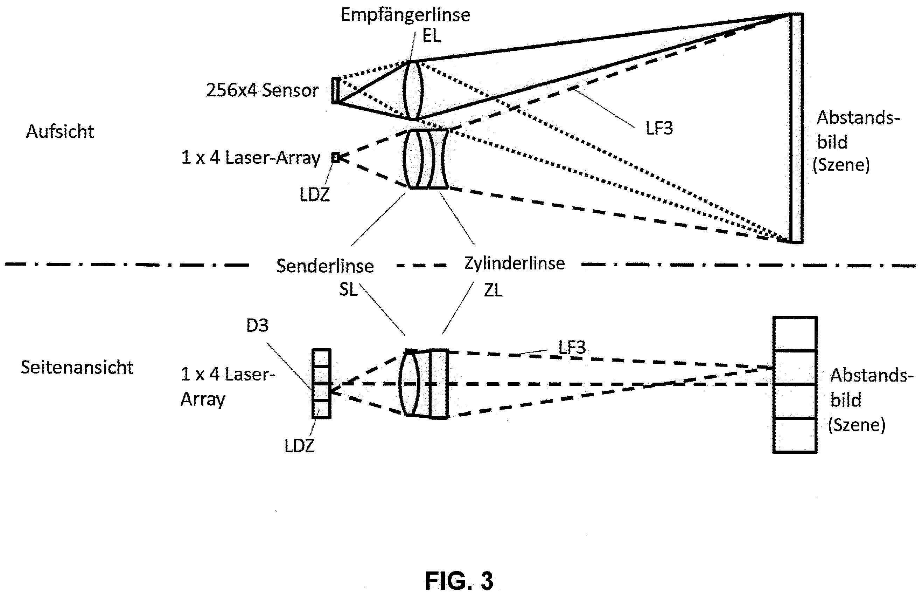

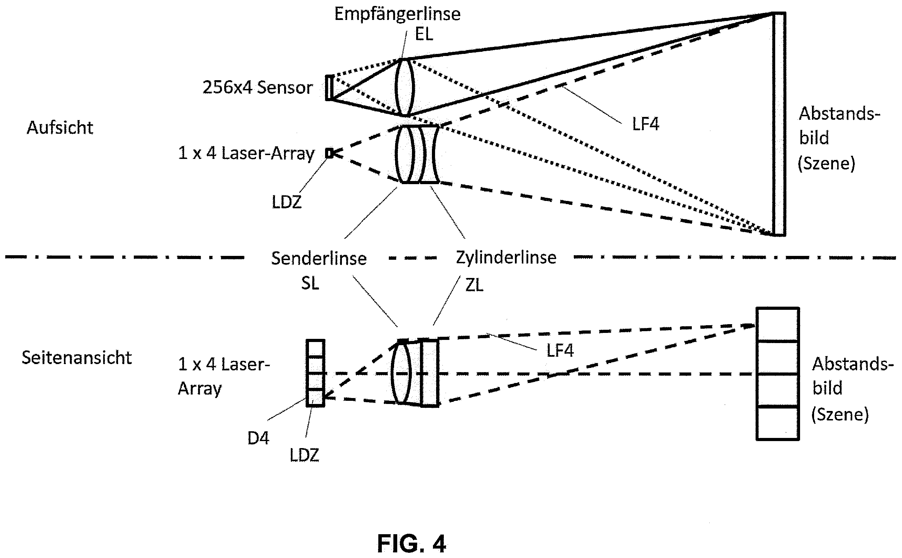

Fig. 1 zeigt den Strahlengang des LIDAR-Systems in der Aufsicht und der Seitenansicht, wenn der erste Laser D1 einen Laserpuls abgibt. Der erste Laser D1 gibt einen Lichtpuls ab, der durch die Linse SL, ZL, die vorzugsweise eine Powell-Linse aufweist, zu einem ersten Lichtfächer LF1 aufgeweitet wird. Der erste Lichtfächer LF1 ist gestrichelt gezeigt. Der erste Lichtfächer LF1 beleuchtet einen ersten Streifen des Raumes oder der Szene (Abstandsbild) vor dem LIDAR-System. Eine Empfängerlinse EL bildet diesen ausgeleuchteten ersten (Bild-)Streifen auf eine Zeile des Sensors S ab. In Fig. 1 (sowie auch in den Fign. 2 bis 4) ist die Abbildung der beiden Bildpunkten an den beiden Enden des beleuchteten Bildstreifens auf die beiden Fotodioden an den beiden Enden der betreffenden Zeile von Fotodioden des Sensors S durch die gepunkteten und die durchgezogenen Linien verdeutlicht. Der ausgeleuchtete erste Bildstreifen ist von dem zweiten ausgeleuchteten Bildstreifen (Fig. 2), von dem dritten ausgeleuchteten Bildstreifen (Fig. 3) und von dem vierten ausgeleuchteten Bildstreifen (Fig. 4) verschieden. In dem Beispiel der Fig. 1 umfasst das Sensor-Array pro Zeile 256 Fotodioden. Diese Sensorzeile nimmt somit einen Bildstreifen auf. Bevorzugt ist die Empfängerlinse EL ebenfalls eine Powell-Linse.

Fig. 2 zeigt den Strahlengang des LIDAR-Systems in der Aufsicht und der Seitenansicht, wenn der zweite Laser D2 einen Laserpuls abgibt. Der zweite Laser D2 gibt einen Lichtpuls ab, der durch die Linse SL, ZL, die vorzugsweise eine Powell-Linse aufweist, zu einem zweiten Lichtfächer LF2 aufgeweitet wird. Der zweite Lichtfächer LF2 ist gestrichelt gezeigt. Der zweite Lichtfächer LF2 beleuchtet einen zweiten Streifen des Raumes oder der Szene (Abstandsbild) vor dem LIDAR-System. Eine Empfängerlinse EL bildet diesen ausgeleuchteten zweiten Streifen auf eine Zeile des Sensors S ab. Der ausgeleuchtete zweite Bildstreifen ist von dem ersten ausgeleuchteten Bildstreifen der Fig. 1, von dem dritten ausgeleuchteten Bildstreifen der Fig. 3 und von dem vierten ausgeleuchteten Bildstreifen der Fig. 4 verschieden.

Fig. 3 zeigt den Strahlengang des LIDAR-Systems in der Aufsicht und der Seitenansicht, wobei der dritte Laser D3 einen Laserpuls abgibt. Der dritte Laser D3 gibt einen Lichtpuls ab, der durch die Linse SL, ZL, die vorzugsweise eine Powell-Linse aufweist, zu einem dritten Lichtfächer LF3 aufgeweitet wird. Der dritte Lichtfächer LF3 ist gestrichelt gezeigt. Der dritte Lichtfächer LF3 beleuchtet einen dritten Streifen des Raumes oder der Szene (Abstandsbild) vor dem LIDAR-System. Eine Empfängerlinse EL bildet diesen ausgeleuchteten dritten Streifen auf eine Zeile des Sensors S ab. Der ausgeleuchtete dritte Bildstreifen ist von dem zweiten ausgeleuchteten Bildstreifen der Fig. 2, von dem ersten ausgeleuchteten Bildstreifen der Fig. 1 und von dem vierten ausgeleuchteten Bildstreifen der Fig. 4 verschieden.

Fig. 4 zeigt den Strahlengang des LIDAR-Systems in der Aufsicht und der Seitenansicht, wobei der vierte Laser D4 einen Laserpuls abgibt. Der vierte Laser D4 gibt einen Lichtpuls ab, der durch die Linse SL, ZL, die vorzugsweise eine Powell-Linse aufweist, zu einem vierten Lichtfächer LF4 aufgeweitet wird. Der vierte Lichtfächer LF4 ist gestrichelt bezeigt. Der vierte Lichtfächer LF4 beleuchtet einen vierten Streifen des Raumes oder der Szene (Abstandsbild) vor dem LIDAR-System. Eine Empfängerlinse EL bildet diesen ausgeleuchteten vierten Streifen auf eine Zeile des Sensors S ab. Der ausgeleuchtete vierte Bildstreifen ist von dem zweiten ausgeleuchteten Streifen der Fig. 2, von dem dritten ausgeleuchteten Bildstreifen der Fig. 3 und von dem ersten ausgeleuchteten Bildstreifen der Fig. 1 verschieden.

Fig. 5 zeigt eine beispielhafte Schaltung für das vorgeschlagene LIDAR-System. Eine Steuerschaltung CTR veranlasst eine der n Aufladeschaltungen B1 bis Bn über eine dieser Aufladeschaltung zugeordnete Aufladeleitung K1 bis Kn, einen Kondensator C1 bis Cn zu laden. Jede der n Aufladeleitungen K1 bis Kn weist dabei einen (vor allem parasitären) Widerstand RZ1 bis RZn und eine parasitäre Induktivität LZ1 bis LZn auf. Jede der Aufladeleitungen K1 bis Kn ist bevorzugt mit einem ersten Anschluss genau eines von n Kondensatoren C1 bis Cn verbunden. Der zweite Anschluss jedes der n Kondensatoren C1 bis Cn ist mit dem Bezugspotenzial über eine Leitung verbunden. Jede der Leitungen zwischen dem zweiten Anschluss eines Kondensators C1 bis Cn und dem Bezugspotenzial umfasst einen parasitären Widerstand RC1 bis RCn und eine parasitäre Induktivität LC1 bis LCn. Die Anode bevorzugt genau eines der n Laser D1 bis Dn ist bevorzugt mit dem ersten Anschluss bevorzugt genau eines der n Kondensatoren C1 bis Cn über bevorzugt genau eine von n Entladeleitungen K1' bis Kn' verbunden. Die Kathoden der n Laser D1 bis Dn sind zu einem gemeinsamen ersten Sternpunkt DisC zusammengeschaltet. Dieser gemeinsame Sternpunkt wird mit Eintreffen des Pulssignals $G_{dis}$ durch den Ansteuerschalter $T_{dis}$ mit dem Bezugspotenzial GND verbunden. Mit dem Bezugspotential GND sind auch die zweiten Anschlüsse der n Kondensatoren C1 bis Cn verbunden.

Ein beispielhafter Buffer Buf erzeugt aus dem Pulsvorsignal PL das Pulssignal $G_{dis}$ zum Öffnen des Ansteuerschalters $T_{dis}$. Bevorzugt kann die Steuerschaltung CTR dieses Pulsvorsignal PL erzeugen, wenn der Ladevorgang für den zu ladenden Kondensator durch die zugehörige Aufladeschaltung B1 bis Bn abgeschlossen und die betreffende Aufladeschaltung B1 bis Bn neutral geschaltet ist.

Ein Stützkondensator CVDD ist bevorzugt Teil des Kondensator-Arrays KA der n Kondensatoren C1 bis Cn. Der Stützkondensator CVDD stabilisiert die Versorgungsspannung VDD oder eine andere systemrelevante Spannung. Er dient dazu, Auswirkungen der bei Zündung der Laser entstehenden Stromstöße auf andere mit der Versorgungsspannung VDD angeschlossene Komponenten eines z.B. Fahrzeugs mit der Versorgungsspannung VDD als Bordnetzspannung zu verhindern.

Der Stützkondensator CVDD ist an seinem ersten Anschluss über eine Leitungsinduktivität LZV und über einen Leitungswiderstand RZV mit der Versorgungsspannung VDD verbunden.

Der Stützkondensator CVDD ist an seinem zweiten Anschluss über einen Leitungswiderstand RCV und über eine Leitungsinduktivität LCV mit dem Bezugspotenzial GND verbunden.

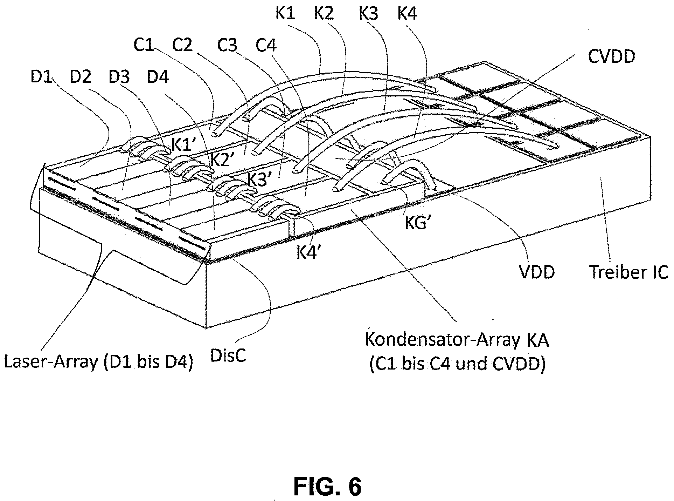

Fig. 6 zeigt ein Ausführungsbeispiel des Aufbaus eines Laser-Moduls für das LIDAR-System der Fig. 5.

Basis des Moduls ist das Treiber-IC. Das Treiber-IC ist bevorzugt eine monolithisch integrierte Schaltung. Es umfasst bevorzugt die Steuerschaltung CTR und alle anderen mikrointegrierbaren (z.B. CMOS-)Schaltungsteile der Fig. 5. Dies können beispielsweise (aber nicht ausschließlich) die Steuerschaltung CTR, der Buffer Buf, der Ansteuerschalter $T_{dis}$ und die n Aufladeschaltungen B1 bis Bn sein. Des Weiteren kann die Steuerschaltung CTR beispielsweise einen Mikrorechner mit Speicher, Schnittstellen und CPU umfassen. Diese bilden zusammen die Ansteuerschaltung. In dem Beispiel der Fig. 6 werden beispielhaft n = 4 Laser D1 bis D4 verwendet, die z.B. auf einem gemeinsamen Kristall gefertigt sind und ein lineares Laser-Array bilden. Die Unterseite dieses Kristalls bildet die gemeinsame Kathode der Laserdioden, die als erster Sternpunkt DisC mit einem Ansteuerschalter elektrisch verbunden ist, der in dem Kristall des Treiber-ICs gefertigt ist und an dessen aktiver Oberfläche liegt. Durch die Flip-Chip-Montage ist es möglich, diese Verbindung mit nur geringen parasitären Induktivitäts- und Widerstandswerten zu realisieren, was die Flankensteilheit der Laserpulse erhöht. Die thermische Kühlung der n Laser erfolgt über den Kristall des Treiber-ICs. Die vier Kondensatoren C1 bis C4 sind ebenfalls als ein gemeinsames Bauteil ausgeführt. In dem Beispiel der Fig. 6 sind die zweiten Anschlüsse der vier Kondensatoren C1 bis C4 durch einen gemeinsamen Kontakt miteinander verbunden. Der erste Anschluss eines jeden Kondensators C1 bis C4 ist mit dem ihm zugeordneten Laser der vier Laser D1 bis D4 über jeweils eine der vier Entladeleitungen K1' bis K4' verbunden. Die Entladeleitungen K1' bis K4' sind durch die gewählte Anordnung besonders kurz. Die gezeigte Mehrfach-Bonddrahtverbindung der Entladeleitungen K1' bis K4' führt zu einer weiteren Reduktion der parasitären Induktivität und damit zu einer weiteren Erhöhung der Flankensteilheit. Ebenso führen die kurzen Bonddrähte der Verbindung zwischen dem (zweiten) Sternpunkt DisK als gemeinsamer Verbindungspunkt der Kondensatoren C1 bis Cn und dem Bezugspotenzial zusammen mit der Mehrfach-Bonddrahtverbindung zu einer Reduktion der parasitären Induktivität dieser Leitungsverbindung. Auch dies erhöht die Flankensteilheit des ausgesandten Lichtpulses.

Die relativ langen Bonddrähte der Aufladeleitungen K1 bis Kn sind für die Flankensteilheit eher förderlich, da sie ein Abfließen der elektrischen Ladung der Kondensatoren C1 bis Cn über diese Aufladeleitungen K1 bis Kn verhindern bzw. weitestgehend unterdrücken.

Ein Stützkondensator CVDD kann Teil des Kondensator-Arrays KA sein, wie gezeigt. Der Stützkondensator CVDD ist auf einer Unterseite mit einem zweiten Anschluss mit einem sehr geringen Leitungswiderstand RCV und einer sehr geringen Leitungsinduktivität LCV mit dem Bezugspotenzial GND verbunden. Der erste Anschluss des Stützkondensators CVDD ist mit dem virtuellen Knoten KG' der Versorgungsspannung VDD verbunden. Der virtuelle Knoten KG' der Versorgungsspannung VDD ist mit sehr kurzen Bonddrähten mit der Versorgungsspannung VDD verbunden. Dadurch ist der virtuelle Knoten KG' der Versorgungsspannung VDD mit einem sehr geringen Leitungswiderstand RZV und einer sehr geringen Leitungsinduktivität LZV mit der Versorgungsspannung VDD verbunden.

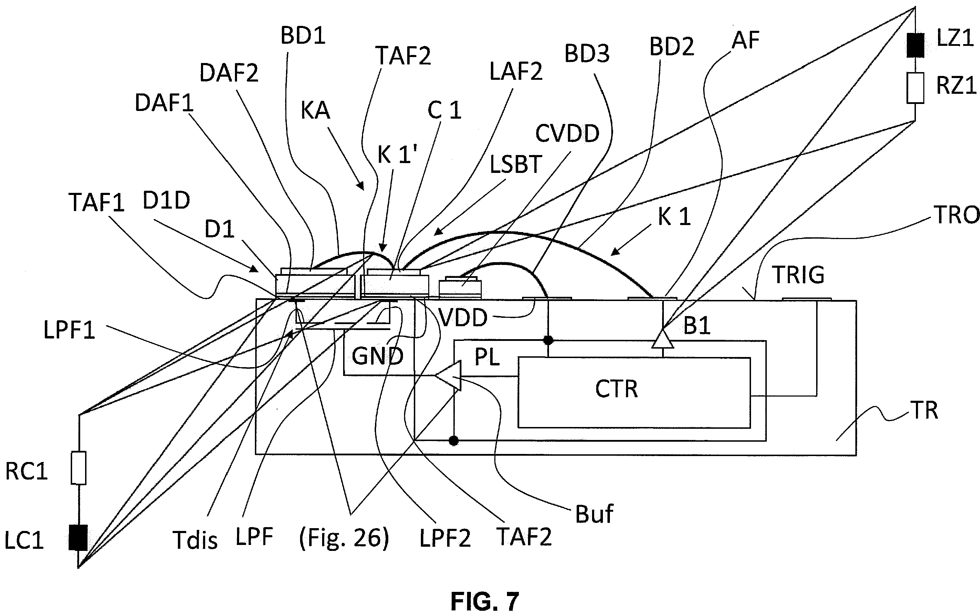

In Fig. 7 ist als Realisierung der Schaltung nach Fig. 5 schematisch ein Hybrid-Aufbau des Laser-Moduls gezeigt, das als Träger TR eine beispielsweise Kunststoffvergussmasse aufweist. In dem Träger TR ist ein Schaltungs-Die und ein Leiterrahmen eingebettet; beides ist der Übersichtlichkeit wegen nicht dargestellt. Die Steuerschaltung CTR, der Transistor-Treiber Buf und die Aufladeschaltungen B1 bis Bn sind als integrierte Schaltungen des Schaltungs-Die ausgeführt. Ferner befindet sich möglichst nahe der Oberseite des Schaltungs-Die der Transistor $T_{dis}$. Wie in den Fign. 5 und 7 gezeigt, weist der Transistor $T_{dis}$ einen Leitungspfad LPF auf, dessen Endbereiche LPF1, LPF2 über ein erstes Leitungspfad-Anschlussfeld TAF1 und ein zweites Leitungspfad-Anschlussfeld TAF2 elektrisch zur Oberseite TRO geführt sind. Auf dem ersten Leitungspfad-Anschlussfeld TAF1 befinden sich die Laserdioden D1 bis Dn, die mit dem unterseitigen ersten Anschlussfeld DAF1 ihres betreffenden Dies D1D durch Die-zu-Die-Bonding elektrisch mit dem ersten Leitungspfad-Anschlussfeld TAF1 verbunden sind. In gleicher Weise sind die Kondensatoren C1 bis Cn mit den bzw. dem zweiten Leitungspfad-Anschlussfeld TAF2 des Transistors $T_{dis}$ verbunden. Hierzu ist jeder Kondensator C1 beispielsweise als separates Ladungsspeicherbauteil LSBT ausgebildet, wobei auch sämtliche Kondensatoren C1 bis Cn in Kombination ein gemeinsames Ladungsspeicherbauteil bilden können (siehe in diesem Zusammenhang beispielhaft das Kondensator-Array KA der Fig. 6). Die Ladungsspeicherbauteile LSBT weisen ein unterseitiges erste Anschlussfeld LAF1 auf, das durch Die-zu-Die-Bonding mit dem zweiten Leitungspfad-Anschlussfeld TAF2 elektrisch verbunden ist.

Oberseitig sowohl des Laserdioden-Dies D1D als auch des Ladungsspeicherbauteils LSBT befindet sich jeweils ein zweites Anschlussfeld DAF2 und LAF2, die mittels eines kurzen ersten Bonddrahts BD1 elektrisch miteinander verbunden sind. Diese ersten Bonddrähte BD1 bilden die Leitungen K1' bis Kn'.

Zusätzlich sind die Kondensatoren C1 bis Cn jeweils über längere zweite Bonddrähte BD2 mit an der Oberseite TRO des Trägers TR befindlichen Anschlussfeldern AF der ihnen jeweils zugeordneten Aufladeschaltung B1 bis Bn elektrisch verbunden. Gezeigt ist darüber hinaus noch ein dritter Bonddraht BD3, der das Versorgungsspannungs-Potenzial VDD, das an einem oberseitigen Anschlussfeld des Trägers TR anliegt, mit dem Stütz- oder Pufferkondensator CVDD verbunden ist, der seinerseits mit seinem zweiten Kontakt mit dem Bezugspotenzial GND verbunden ist. Hierzu ist der Stütz- bzw. Pufferkondensator CVDD als separates oder im Kondensator-Array KA integriertes Bauteil ausgeführt, das ebenfalls beispielsweise durch Die-zu-Die-Bonding mit dem zweiten Leitungspfad-Anschlussfeld TAF2, an dem das Bezugspotenzial anliegt, elektrisch verbunden ist.

In Fig. 7 ist durch die sich spreizenden Linienpaare visualisiert, welche parasitären Komponenten im Entladeschaltkreis und im Aufladeschaltkreis der Schaltung nach Fig. 5 den einzelnen Komponenten des Hybrid-Aufbaus entsprechen. Hierbei ist zu beachten, dass letztendlich auch der Leiterrahmen, der in Fig. 7 nicht gezeigt ist, und die internen Verbindungen im ebenfalls in Fig. 7 nicht gezeigten Schaltungs-Die zu den parasitären Komponenten beitragen.

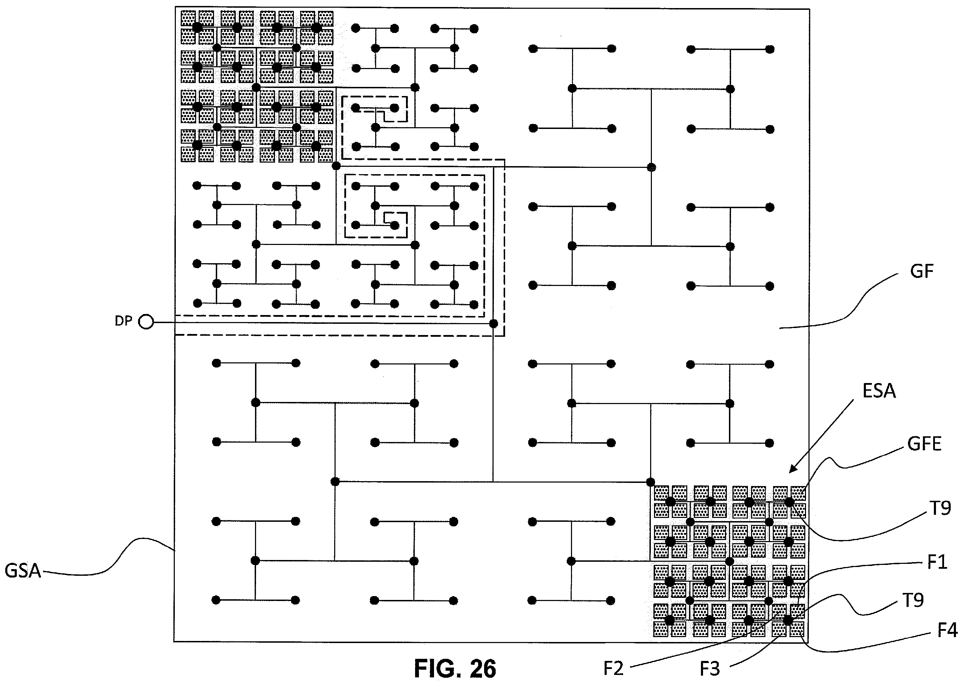

In Fig. 7 ist dann schließlich auch noch angedeutet, dass die Fign. 26 ff eine Darstellung des Details aus Treiber Buf und Transistor $T_{dis}$ zeigt. Der Ausgang des Treibers Buf ist mit dem Steueranschluss $GT_{dis}$ des Transistors verbunden

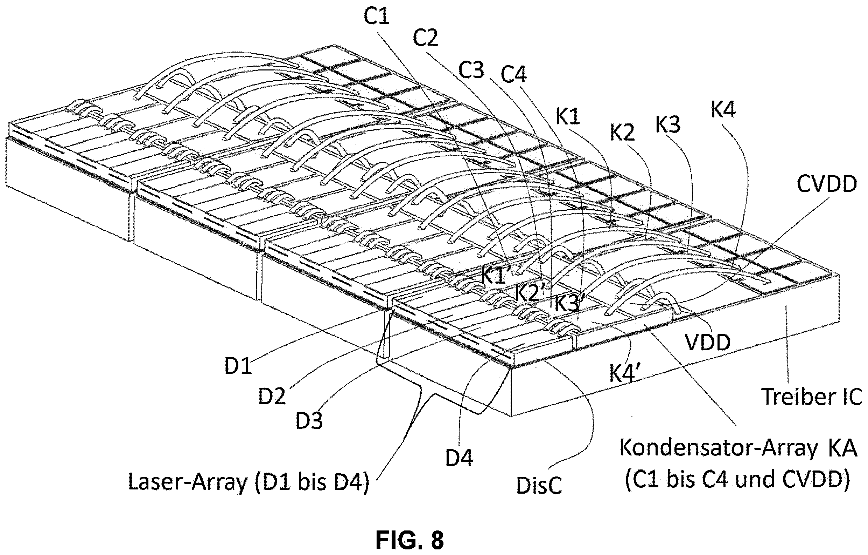

Fig. 8 zeigt eine Anordnung mit mehreren Laser-Modulen der Fig. 6. Bevorzugt wird die Ansteuerlogik und die Steuerung dabei so gestaltet, dass immer nur einer der Laser sämtlicher Laser-Module einen Lichtpuls erzeugt, wobei die Ansteuerung sämtlicher nebeneinander angeordneter Laser zeitlich aufeinanderfolgend von einem Laser zum z.B. jeweils benachbarten Laser erfolgt.

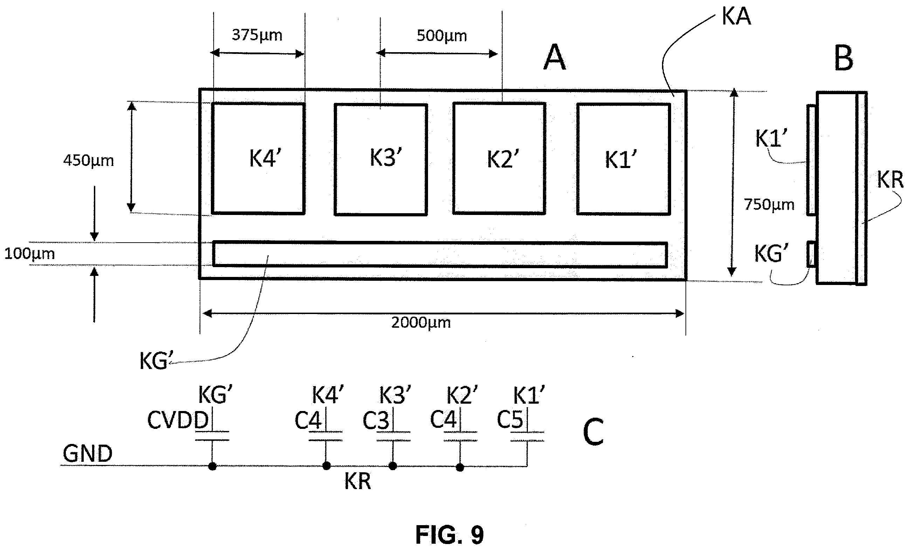

Die Fign. 9A, 9B und 9C zeigen ein Kondensator-Array KA mit den Kondensatoren C1 bis C4 und CVDD für die Verwendung in einem Laser-Modul entsprechend der Fig. 8 in der Aufsicht (Fig. 9A), in einer Seitenansicht (Fig. 9B) und die interne Verschaltung des Kondensator-Arrays (Fig. 9C).

Das Kondensator-Array KA aus C1 bis Cn und CVDD ist bevorzugt rechteckig. Die Kontaktflächen für die Entladeleitungen K1' bis Kn' sind auf der Oberseite bevorzugt längs eines ersten Randes des Rechtecks nebeneinander angeordnet (siehe Fig. 9A). Der Abstand von der Mitte einer Kontaktfläche für den Anschluss einer Entladeleitung zur Mitte der Kontaktfläche für den Anschluss der nächsten Entladeleitung entspricht dabei bevorzugt dem Abstand der geometrischen Schwerpunkte des entsprechenden Lasers (siehe D1 bis Dn in Fig. 6). Die Laser und diese Kontaktflächen des Kondensator-Arrays KA weisen also bevorzugt den gleichen Pitch = Abstand von Mitte zu Mitte auf. In dem Beispiel der Fig. 9 ist dieser Abstand beispielhaft 500 $\mu$m.

Längs des dem ersten Rand des Rechtecks gegenüberliegenden zweiten Rand des Rechtecks erstreckt sich die Kontaktfläche für den virtuellen Knoten KG' der Versorgungsspannung VDD, die dem ersten Anschluss des Stützkondensators CVDD entspricht.

Bevorzugt erstreckt sich die Kontaktfläche für den virtuellen Knoten KG' der Versorgungsspannung VDD entlang des gesamten zweiten Randes des Rechtecks. In dem Beispiel der Fig. 9 beträgt die Länge dieser Erstreckung etwas weniger als 2000 $\mu$m.

Die gegebenenfalls n Kontaktflächen für die Anschlüsse der Entladeleitungen K1' bis Kn' nehmen daher nur einen Abschnitt längs des ersten Randes des Rechtecks ein, der kleiner als 1/n der Länge des ersten Randes des Rechtecks ist. In dem Beispiel der Fig. 9 ist diese Erstreckung nur 375 $\mu$m. Die Fläche dieser Kontakte ist in der Fig. 9 beispielhaft 0,17 mm$^2$.

Die Erstreckung der gegebenenfalls n Kontaktflächen für die Entladeleitungen K1' bis Kn' längs des dritten und vierten Randes des Rechtecks, die in diesem Beispiel 450 $\mu$m beträgt, ist daher typischerweise länger als die Erstreckung der Kontaktfläche für den virtuellen Knoten KG' der Versorgungsspannung VDD, die in diesem Beispiel 100 $\mu$m beträgt. Die Größe der Kontaktfläche für den virtuellen Knoten KG' der Versorgungsspannung VDD beträgt in etwa 0,2 mm$^2$.

Ein Unterseitenkontakt KR des Kondensator-Arrays KA (siehe Fig. 9B) bildet den gemeinsamen Kontakt zum Anschluss des gemeinsamen Bezugspotenzials GND.

Das Material zwischen den Kontaktflächen für die Knoten K1' bis Kn' und KG' bildet das Dielektrikum des Kondensator-Arrays KA. Zwischen jeweils einer Kontaktfläche für die Knoten K1' bis Kn' und KG' und dem Unterseitenkontakt KR bildet sich dann so jeweils einer der Kondensatoren C1 bis Cn und CVDD aus.

Das Beispiel der Fig. 9 ist zur besseren Übersicht (wie auch die anderen Beispiele dieser Beschreibung) auf n = 4 gerichtet, was aber in keiner Weise einschränkend zu verstehen ist.

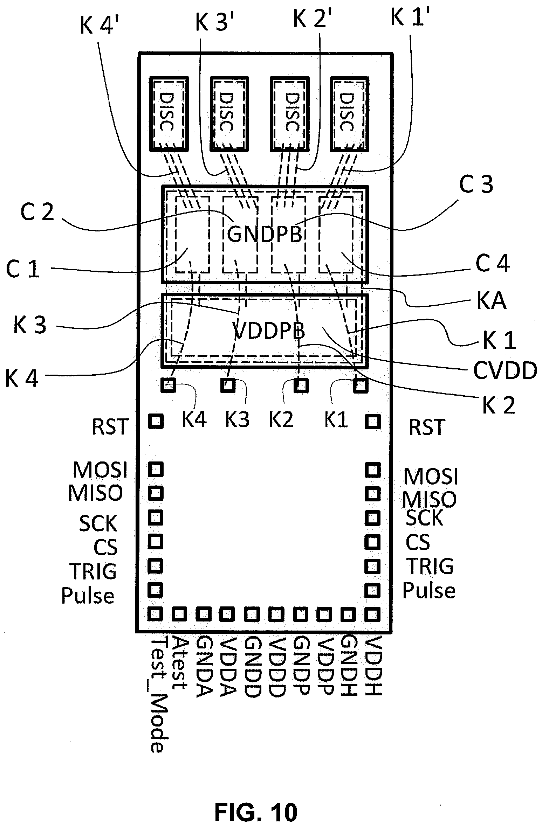

Fig. 10 zeigt die Struktur eines einzelnen vorgeschlagenen Treiber-ICs in der Aufsicht. Die Struktur ist grob vereinfacht und auf die wesentlichen Merkmale beschränkt.

Wie an anderen Stellen in dieser Beschreibung bereits erwähnt, ist die Anzahl n der Laser D1 bis Dn des Moduls auf n = 4 zur besseren Übersicht beispielhaft beschränkt. Für eine andere Anzahl n von Lasern können die Prinzipien dieser Beschreibung entsprechend angewendet werden. Hier wird n statt der Anzahl 4 verwendet, auch wenn die Figur n = 4 zeigt. Dabei ist n stets als eine ganz positive Zahl zu verstehen.

Auf der Oberseite des Treiber ICs befinden sich beispielhaft vier Kontaktflächen für die Rückseitenkontakte der beispielhaften vier Laser D1 bis D4 des Laser-Moduls. Jede der vier Kontaktflächen ist mit dem ersten Sternpunkt DisC verbunden. Statt vier separaten Kontaktflächen ist natürlich auch eine einzelne Kontaktfläche denkbar.

Bezogen auf die Ausrichtung der Darstellung des Treiber-ICs in Fig. 10 befindet sich unterhalb der Kontaktflächen DisC eine Kontaktfläche GND, die mit dem Bezugspotenzial GND verbunden wird. Auf diese Kontaktfläche wird das Kondensator-Array KA aufgesetzt. Dies verbindet den Unterseitenkontakt KR des Kondensator-Arrays KA mit dem Bezugspotenzial GND.

Ebenfalls auf die Ausrichtung der Darstellung des Treiber-ICs bezogen, befindet sich unterhalb der Kontaktfläche GND eine Kontaktfläche VDD für die Bonddrähte, durch die der erste Anschluss des Stützkondensators CVDD des Kondensator-Arrays KA, der der virtuelle Knoten KG' der Versorgungsspannung VDD ist, mit der Versorgungsspannung VDD verbunden wird.

Unterhalb der Kontaktfläche VDD (wiederum bezogen auf die Ausrichtung der Darstellung des Treiber-ICs) befinden sich die n Bondflächen (hier beispielhaft n = 4) für die Ausgänge der Treiberschaltungen B1 bis Bn (hier n = 4). Mittels langer Bonddrähte, die die Aufladeleitungen K1 bis Kn (hier n = 4) darstellen, werden von dort als Energiereserven der Laser D1 bis Dn (hier n = 4) dienenden die Kondensatoren C1 bis Cn durch die Treiberschaltungen B1 bis Bn geladen.

In dem Beispiel der Fig. 10 benötigt das vorgeschlagene Treiber-IC mehrere Versorgungsspannungen über mehrere Versorgungsspannungskontakte VDDA, GNDA, VDDD, GNDD, VDDP, GNDP, VDDH, GNDH. Es wurde bei der Entstehung der Erfindung erkannt, dass es günstig ist, die Versorgungsspannungen dem Treiber-IC niederohmig über dessen den Lasern gegenüberliegende Kante zuzuleiten, da so jedes Treiber-IC seine eigene niederohmige Zuleitung aufweisen kann.

Des Weiteren wurde erkannt, dass Signale, die auch hochohmig an die Treiber-ICs angelegt werden können, quer durch die ICs durchgeschleift werden können. In dem Beispiel der Fig. 10 sind dies beispielsweise das Rücksetzsignal RST, das horizontal mit einem entsprechenden Anschluss auf der gegenüberliegenden Seite des Treiber-ICs verbunden ist. Des Weiteren ist dies in dem Beispiel der Fig. 10 als Beispiel für einen Datenbus ein SPI-Datenbus gezeigt. Der Eingang des SPI-Datenbusses MOSI und der Ausgang des SPI-Datenbusses MISO und der Takt des SPI-Datenbusses SCK haben Entsprechungen auf der gegenüberliegenden Seite des Treiber-ICs. Auch ein Auswahlsignal (Englisch: Chip-Select CS) wird durchgeschleift. Das Zündsignal zum Abfeuern des Laser-Pulses wird dem Anschluss TRIG an der einen Seite des Treiber-ICs zugeführt und zur anderen Seite unverändert durchgeschleift.

Mit der Flanke dieses Zündsignals werden die Laser der Module abgefeuert.

Ein weiteres optionales Beispiel für ein Signal, das allen Treiber-ICs zugeführt wird und ebenfalls durchgeschleift wird, wird an den Anschluss Pulse gelegt. Es kann sich beispielsweise um ein Diagnose-Signal einer Diagnoseschnittstelle handeln.

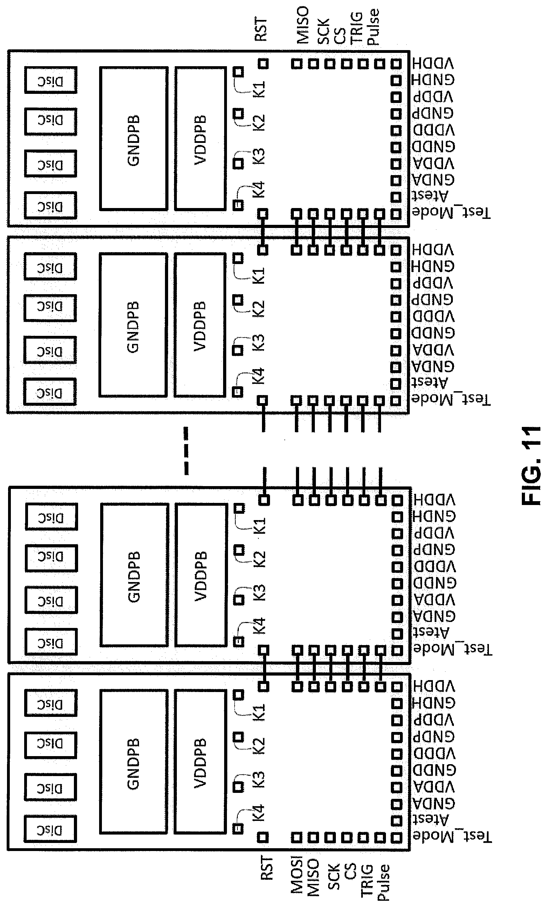

Fig. 11 zeigt die Aneinanderreihung mehrerer Laser-Module der Fig. 10 auf Treiber-IC-Ebene.

Die Kontaktflächen an den Längsseiten zweier benachbarter Treiber-ICs sind durch Bonddrähte miteinander verbunden. Es wird deutlich, dass diese Konstruktion die niederohmige Versorgung aller Laser-Module mit elektrischer Energie sicherstellt, da die Steuersignale durchgeschleift werden.

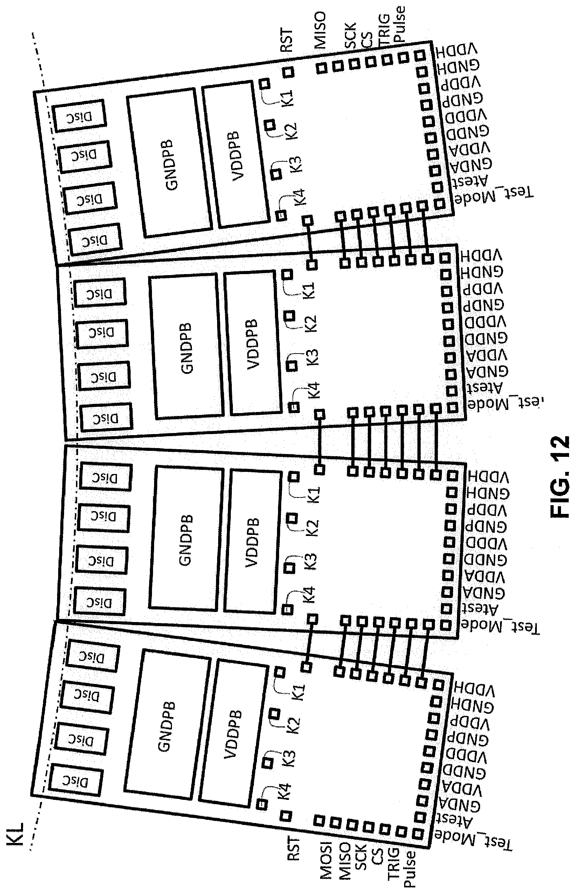

Fig. 12 zeigt die Ausrichtung der Laser-Module der Fig. 11 längs einer gebogenen Linie KL. Dies hat den Vorteil, dass die Erzeugung des Laserstrahlfächers sich massiv vereinfacht. Zum Ersten können die Laser-Module senkrecht zu dieser gekrümmten Linie KL ausgerichtet sein. Zum Zweiten können innerhalb eines Laser-Moduls die Laser längs dieser gekrümmten Linie KL ausgerichtet sein, so dass letztlich alle Laser aller Module längs dieser gekrümmten Line KL ausgerichtet sind. Die gekrümmte Linie KL kann konvex oder konkav sein. Der Laserstrahl jedes Lasers jedes Laser-Moduls weist eine Laserstrahlachse auf. Sind nur die Laser-Module längs der gekrümmten Linie KL ausgerichtet und ist diese gekrümmte Linie KL ein Kreisbogenabschnitt, so schneiden sich die Laserstrahlachsen der jeweils ersten Laser D1 sämtlicher Laser-Module in einem gemeinsamen Punkt im Raum. Dieser kann auch hinter den Lasern liegen.

Sind die Laser D1 bis Dn eines Laser-Moduls längs einer gekrümmten Kreislinie KL ausgerichtet, so schneiden sich die Laserstrahlachsen der Laser D1 bis Dn dieses Laser-Moduls in einem Punkt.

Sind die Laser D1 bis Dn aller Laser-Module längs einer gekrümmten gemeinsamen Kreislinie KL ausgerichtet, so schneiden sich die Laserstrahlachsen der Laser D1 bis Dn sämtlicher Laser-Module in einem Punkt.

Eine Ausrichtung nur eines Teils der Laser und/oder nur eines Teils der Laser-Module längs der gekrümmten Linie KL soll nicht ausgeschlossen werden.

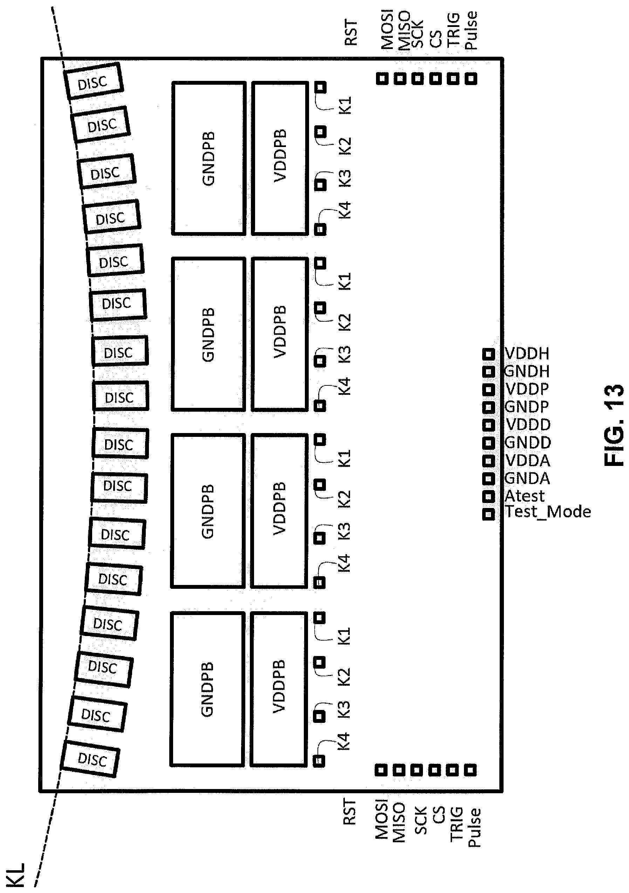

Die Erfindung ist nicht auf die Anordnung oder Aneinanderreihung von mehreren Lichtmodulen mit beispielsweise jeweils vier Laserdioden-Dies beschränkt. So kann beispielsweise die Anordnung der mindestens vier in den Fign. 8, 11 und 12 gezeigten Lichtmodule auch durch ein einziges Lichtmodul realisiert sein, auf dem dann die Laserdioden-Dies entweder entlang einer geraden Linie oder entlang der Krümmungslinie KL angeordnet sind (siehe Fig. 13). Längs des Außenrandes eines derartigen in seinen Abmessungen größeren Lichtmoduls sind Anschlussfelder für die zuvor genannten, an das bzw. an die Lichtmodule anzulegenden Signale und Spannungen angeordnet. Das Gesamtlichtmodul kann entweder ein gemeinsames und damit großflächiges Kondensator-Array KA oder aber mehrere Kondensator-Teilarrays aufweisen.

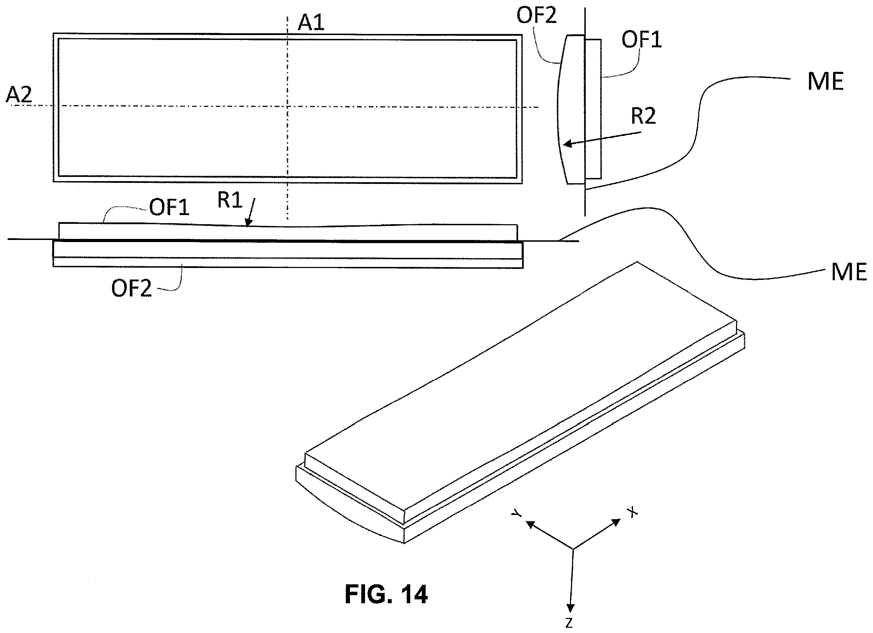

Fig. 14 zeigt eine beispielhafte Powell-Linse. Die Oberfläche ist auf der ersten Oberfläche OF1 um eine erste Achse A1 gewölbt und auf der zweiten Oberfläche OF2 um eine zweite Achse A2 gewölbt. Dabei sind die beiden Achsen senkrecht zueinander orientiert. Mit ME ist die x-y-Mittenebene in der auf die z-Erstreckung (Erstreckung in Richtung der optischen Achse) der Linse bezogene Linsenmitte bezeichnet.

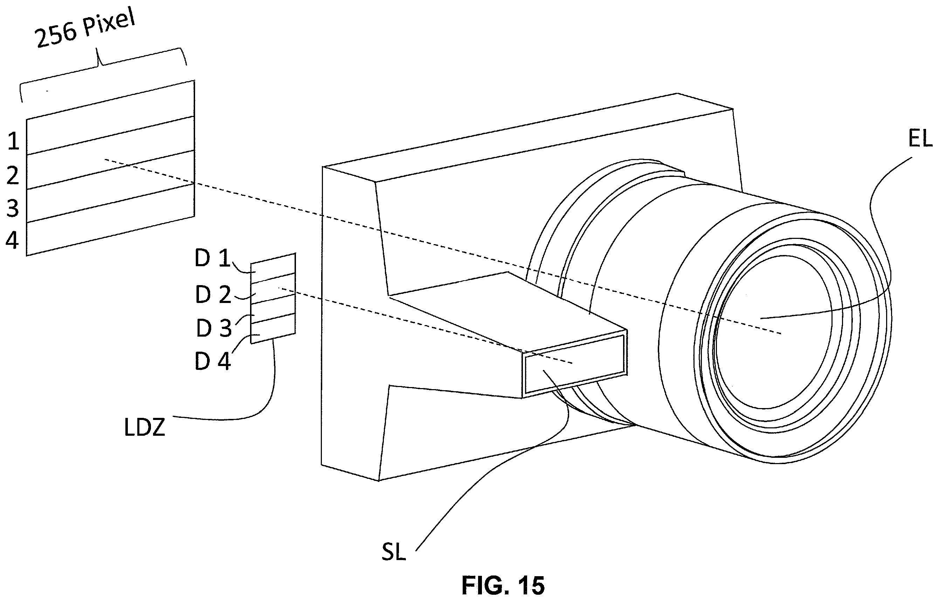

Fig. 15 zeigt eine beispielhafte Anordnung des Sendesystems mit der Senderlinse und des Empfängersystems mit der Empfängerlinse. In Explosionsdarstellung und schematisch sind die Laserdioden-(Array-)Reihen LDZ mit n = 4 Laserdioden, wie oben beispielhaft beschrieben, und der Sensor S mit n = 4 Zeilen mit jeweils z.B. 256 Pixeln gezeigt. Werden z.B. vier Laser-Module eingesetzt, wie in den Fign. 8, 11 und 12 gezeigt, so ergäbe sich eine Laserdiodenreihe LDZ mit 16 Laserdioden und ein Fotosensor mit 16 Zeilen á z.B. 256 Pixeln.

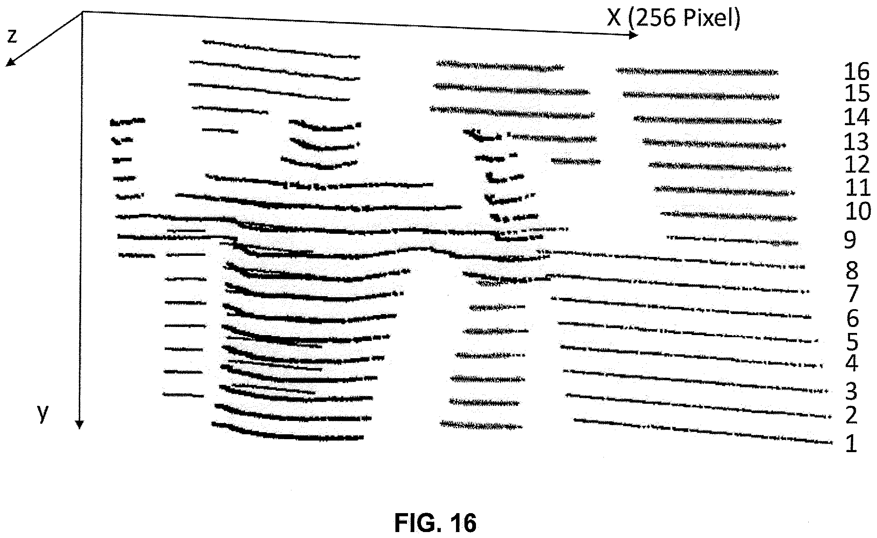

Fig. 16 zeigt ein reales Messergebnis als Punktwolke in einem beispielhaften kartesischen Koordinatensystem als Zielkoordinatensystem mit n = 16 Lasern und m = 256 Fotodetektoren in der Fotodetektorenzeile.

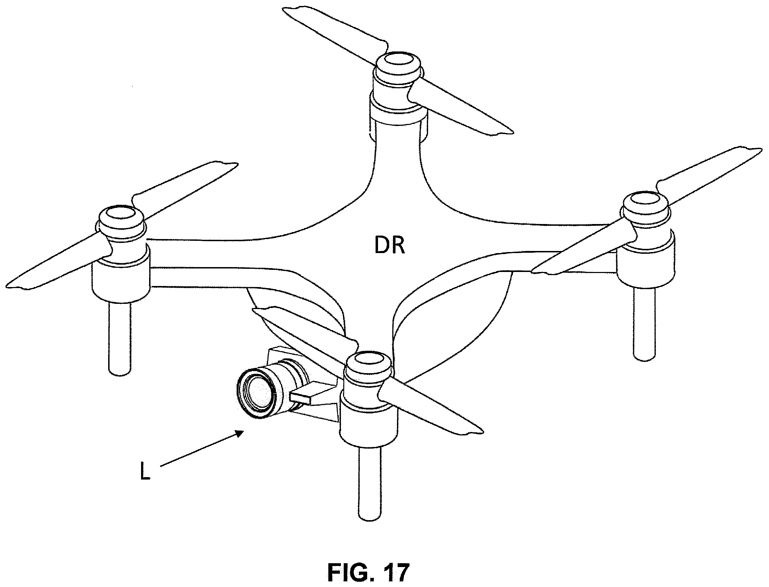

Fig. 17 zeigt eine erfindungsgemäße Drohne mit montiertem erfindungsgemäßem LIDAR-System. Das erfindungsgemäße Lidar-System kann für Drohen sehr gut eingesetzt werden, weil es besonders leicht ist und keine mechanischen Teile, wie beispielsweise Schwingspiegel aufweist.

Andere Lösungen aus dem Stand der Technik sind nicht so kompakt und können diese Informationen nicht bei diesem kleinen Gewicht und dem kleinen Energieverbrauch liefern.

Das vorgeschlagene LIDAR-System kann aber auch in anderen Fahrzeugen, Schwimmkörpern, Flugkörper, Schienenfahrzeugen, als Scanner in der Automatisierungstechnik und dergleichen eingesetzt werden. Von Vorteil ist es, wenn das Fahrzeug oszillierende Nick-Bewegungen vollführt, so dass die "Lücken" im Abstandsbild, die durch den Abstand benachbarter Fotodetektorzeilen des Sensors begründet sind, abgetastet werden könne, womit die Bildauflösung erhöht werden kann. Pro Nickwinkel wird ein vollständiges Abstandsbild aufgenommen und die Informationen der Fotodetektorzeilen dann anschließend zum vollständigen Bild zusammengesetzt. Dadurch erhält man also dann auch Informationen über Bereiche des Abstandsbildes, die, ohne dass Nickbewegungen durchgeführt werden, auf die Zwischenräume zwischen benachbarten Fotodetektorzeilen des Sensors abgebildet würden.

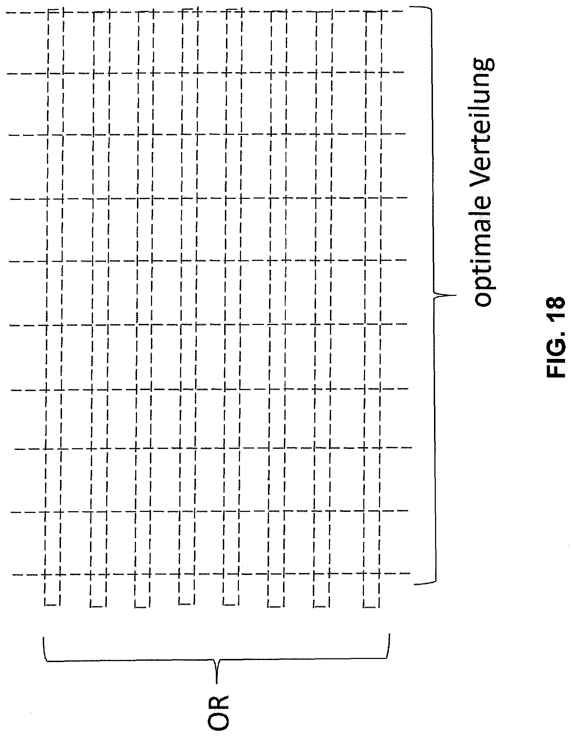

Fig. 18 soll das Problem einer möglicherweise auftretenden Inhomogenität der Lichtintensitätsverteilung des Laserlichts innerhalb eines Beleuchtungsstreifens verdeutlichen. In der Waagerechten sind als Rechtecke die Abbilder der Laserdiodenstrahlen nach dem Passieren des Senderoptikelements SLE gezeigt. Der Strahl einer Laserdiode hat typischerweise einen elliptischen Querschnitt. Wird nun längs einer Hauptachse dieser Querschnittsellipse oder dieses Querschnittsovals die Intensität ermittelt und in ein xy-Diagramm eingetragen, dass als x-Achse die Position längs dieser Hauptachse und als y-Achse die Strahlungsintensität aufweist, so zeigen Laserdioden hier typischerweise eine gaußförmige Intensitätsverteilung. Durch die Optik wird der Laserstrahl einer Laserdiode nun in einer Richtung aufgeweitet, so dass sich im Idealfall im Fernfeld auf einer Projektionsfläche senkrecht zur optischen Achse der Aufweitungslinse und des Lasers ein rechteckförmiger, gleichmäßig ausgeleuchteter Bereich ergeben sollte. Aufgrund von Abbildungsfehlern ist dies aber nicht der Fall. In Fig. 18 sind senkrechte Linien gezeigt. Die Fläche eines Rechteckstücks eines der waagerechten Rechtecke, die sich zwischen je zwei senkrechten Linien befindet, soll bei Beleuchtung durch den diesem Rechteck zugehörigen Laser stets die gleiche Lichtmenge von Rechteckstück zu Rechteckstück erhalten. Im Idealfall sollten also alle Rechteckstücke gleich sein und, wie in Fig. 18 dargestellt, positioniert sein. Im Realfall weist die Optik aber Fehler auf und der Laserstrahlquerschnitt zeigt eine gaußförmige statt einer rechteckförmigen Intensitätsverteilung über den Querschnitt.

Die Fign. 18 bis 22 zeigen jeweils nur den linken oberen Quadranten des Projektionsfeldes des Senderoptikelements SLE, das rechteckförmig ist und somit vier durch zwei zueinander senkrechte Symmetrieachsen getrennte Quadranten aufweist.

Die Kamera mit den Fotodetektoren bildet die bestrahlten Punkte auf die n Fotodetektorenzeilen mit je q Fotodetektoren ab. In den Beispielen der Fign. 18 bis 22 wird davon ausgegangen, dass das Fotodetektoren-Array n = 16 Zeilen und q = 256 Pixel aufweist. Jeder der n Laser des Laser-Moduls beleuchtet dabei eine Zeile. Die Optik weitet dann den Laserstrahl eines j-ten Lasers der n Laser mit $1 \leq j \leq n = 16$ der Breite der Zeile entsprechend auf. Der Laserstrahl des j-ten Lasers wird somit in der Horizontalen aufgeweitet. Die Dichte bzw. der Abstand der senkrechten Linien der Fig. 18 repräsentiert die gewünschte Energiedichte im Fernfeld. Jeder der n Laser des Laser-Moduls beleuchtet somit eine Zeile des Bildes, die dann durch eine Zeile des Fotodetektor-Arrays, hier beispielhaft ein Fotodetektor-Array mit 16 Fotodetektorzeilen mit jeweils 256 Fotodetektoren, abgetastet wird. Die normale Intensitätsverteilung über die Zeile ohne Korrektur ist aufgrund der gaußförmigen Intensitätsverteilung innerhalb des Laserstrahlquerschnitts ebenfalls eine Gaußverteilung. Das zu beheben ist die Aufgabe der hier beschriebenen Optik.

Jede der n Fotodetektorzeilen ist in den Beispielen der Fign. 18 bis 22 genau einem Laser zugeordnet.

Stattdessen kann aber durch eine Defokussierung auch jeder der n Laser r Fotodetektorzeilen mittels Reflexion im Fahrzeugumfeld beleuchten. Die Anzahl der möglichen Fotodetektorenzeilen ist dann r+n. Somit ist es sinnvoll, in dem Fall dann (n+r) x q Fotodetektoren zu verwenden, die in r+n Fotodetektorzeilen organisiert sind. Jedem der n Laser sind dann genau r Fotodetektorzeilen zugeordnet.

Statt der Defokussierung können auch Multisegmentlinsen verwendet werden.

Die n Laser sind bevorzugt innerhalb des Laser-Moduls in einem eindimensionalen Laser-Array senkrecht zur Aufweitungsebene der Fotodetektorzeilen angeordnet.

Der Vollständigkeit halber sollte erwähnt werden, dass aus Platzgründen an anderer Stelle in diesem Dokument beispielhaft von n = 4 Laser pro Laser-Modul ausgegangen wird, um die Darstellung zu vereinfachen.

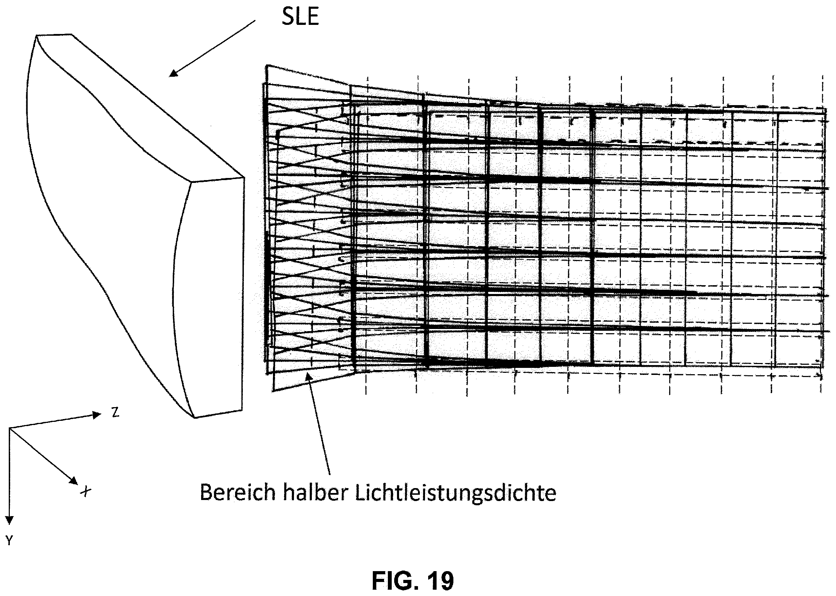

Fig. 19 zeigt die erste Linse ohne Korrekturpolynome. Lediglich die Parameter B2 und B3 sind von 0 verschieden. Die Gleichungen lauten dementsprechend:

$$z = R0Y - Sign(R0Y)*Sqrt(R0Y^2-y^2)+PB2*x^2+ PB3*|x^3|$$

und z =-d.

Wie anhand von Fig. 19 zu erkennen ist, weicht die Energieverteilung an den Rändern und vor allem in den Ecken signifikant von der gewünschten Verteilung der Fig. 18 ab.

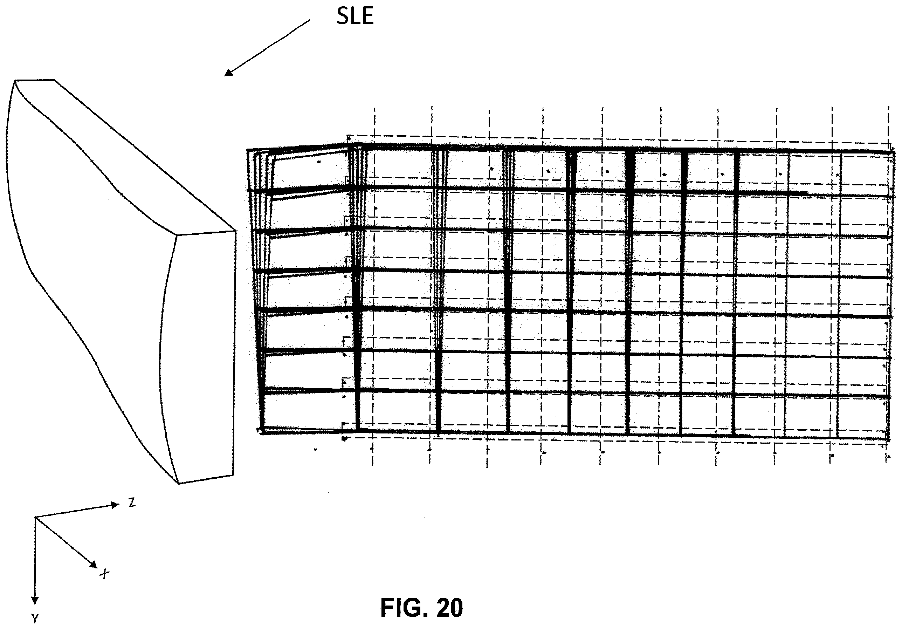

Fig. 20 zeigt eine Linse entsprechend den Parametern der ersten Linse mit AR2=0.01, AR3=0.0006, PB2=-0.0085, PB3=0.0008, PB4=0, PB6=0, PC2=0, PC3=0. Die Gleichungen lauten somit nun:

$$z = RY+AR2*x^2+AR3*|x^3|- Sign(RY)*Sqrt(RY2-y^2)+PB2*x^2+ PB3*|x^3|$$

mit RY = R0Y+AR2*x^2+AR3*|x^3| und z =-d.

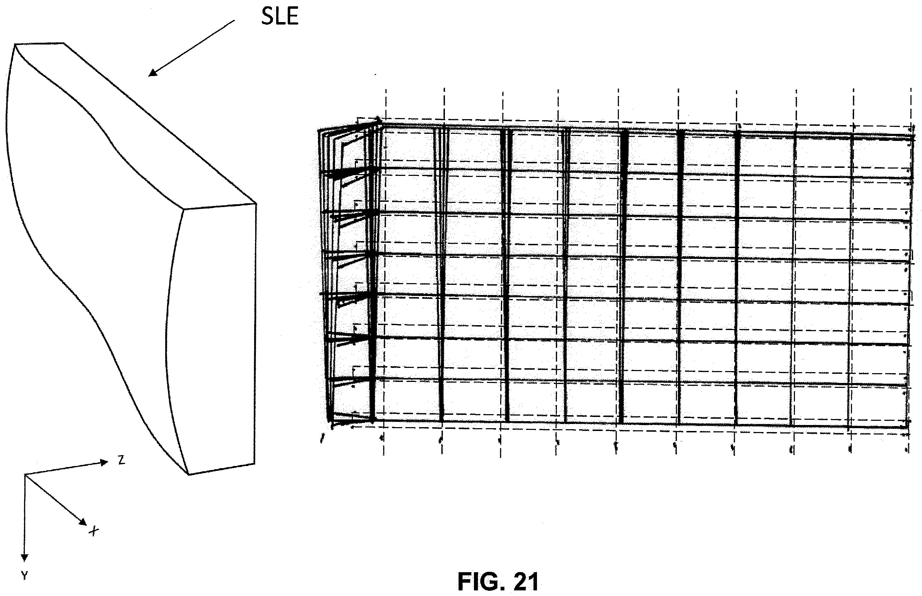

Fig. 21 zeigt eine Linse entsprechend den Parametern der zweiten Linse mit AR2=0.01, AR3=0.0005, PB2=-0.015, PB3=0.0015, PB4=-0.000024, PB6=0, PC2=0, PC3=0. Die Gleichungen lauten somit nun:

$$z = RY+AR2*x^2+AR3*|x^3|- Sign(RY)*Sqrt(RY^2-y^2)+PB2*x^2+ PB3*|x^3|+PB4*x4$$

mit RY = R0Y+AR2*x^2+AR3*|x^3| und z =-d.

Die Verteilung der Energie ist schon fast optimal.

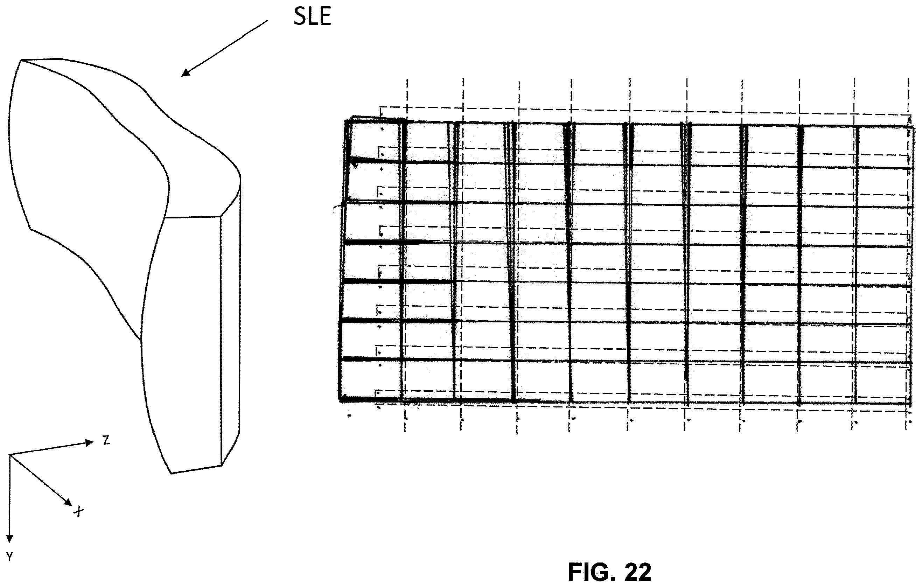

Fig. 22 zeigt eine Linse entsprechend den Parametern der dritten Linse mit AR2=0.028, AR3=-0.0028, PB2=-0.0115, PB3=0.00038, PB4=-0.000034, PB6=0.00000013, PC2=0.028, PC3=-0.0032. Die Gleichungen lauten somit nun:

$$z = RY+AR2*x^2+AR3*|x^3|- Sign(RY)*Sqrt(Ry^2-y^2)+PB2*X^2+ PB3*|x^3|+PB4*x^4+PB6*x^6+PC2*x^2+PC3*|x^3|$$

mit RY = ROY+AR2*x^2+AR3*|x^3| und z =-(d+PC2*x^2+PC3*|x^3|).

Wie der Fig. 22 zu entnehmen ist, ist die Verteilung nun nahezu optimal und die Fehler sind im Realfall vernachlässigbar.

In verschiedenen technischen Anwendungen werden Laserdioden oder Leuchtdioden von Treiberschaltungen angesteuert, und zwar typischerweise mittels kurzer Hochstrompulse. In den Treiberschaltungen fließen bei kurzen Schaltzeiten hohe Ströme. In den Treiberschaltungen verwendete, hochstromfähige CMOS-Transistoren mit geringem Drain-Source-Widerstand erstrecken sich über große Flächen, was die Schaltgeschwindigkeit durch die limitierte Ausbreitungsgeschwindigkeit des Gate-Signals begrenzt. Als ein Anwendungsbeispiel sei ein LIDAR-System genannt.

Bei einer erfindungsgemäßen selbstähnlichen Struktur einer Treiberschaltung der eingangs beschriebenen Art wird die Aufgabe erfindungsgemäß dadurch gelöst, dass Treiberschaltung und Vortreiber, in Blöcke zerteilt werden, die jeweils einen kleinen Teil des Treibertransistors mit entsprechendem Vortreiber enthalten. Treiberschaltung und Vortreiber in einem Block sind so dimensioniert, dass die gewünschte Schaltzeit innerhalb des Blocks erreicht wird. Um die gewünschte Treiberstromstärke zu erreichen, werden mehrere Blöcke zusammengeschlossen und um eine weitere Stufe des Vortreibers erweitert. Dieses Zusammenschalten der einzelnen Blöcke erfolgt in einer erfindungsgemäßen selbstähnlichen Struktur, wie nachfolgend erläutert wird. Dabei wird das Gate-Signal balanciert zu den Sub-Blöcken geführt, um ein gleichzeitiges Schalten zu erzielen. Durch eine Verschachtelung von hierarchisch aufgebautem Vortreiber und Treiberschaltung sowie direkte Anbindung aller kritischen Netze über die Chip-Oberseite und balancierte Signalverdrahtung ermöglicht die vorgestellte Architektur auf Basis selbstähnlicher Unterstrukturen massiv skalierbare Hochstrom-Schalter bei gleichbleibend hoher Schaltgeschwindigkeit.

Die Unterteilung der Treiberschaltung in einzelne Blöcke, im Folgenden als Grundstrukturen bezeichnet, und die Kombination dieser Grundstrukturen zu einer selbstähnlichen Struktur wird an Hand der Figuren näher erklärt. Für eine einfachere Darstellung wird im Folgenden nicht mehr zwischen Treiberschaltung und Vortreiber unterschieden und vereinfachend nur noch von Treiber gesprochen.

Grundstruktur im Sinne dieser Beschreibung bezeichnet diejenige Struktur, die bei einer selbstähnlichen Struktur in verschiedenen Maßstäben und Verschachtelungen in ähnlicher Weise ständig wiederkehrt.

Das erfindungsgemäße Konzept der Verschachtelung eines immer gleichbleibenden Designs der Verschaltung jedes Ausgangs einer Einzeltreiberschaltung einer Stufe mit den Eingängen der Einzeltreiberschaltungen der nächsten Stufe (und zwar sowohl auf Layout- als auch auf Schaltungsebene) hat den Vorteil, dass die Länge des Schaltungswegs vom Eingang der Einzeltreiberschaltung der ersten Stufe bis zu den Ausgängen jeder Einzeltreiberschaltung der letzten Stufe immer gleich ist. Auch ist der Verlauf und die Struktur dieser Signalwege ähnlich bzw. symmetrisch oder gruppenweise punktsymmetrisch, so dass sich insgesamt auch gleiche Parasitäten wie beispielsweise parasitäre Induktivitäten und parasitäre ohmsche Widerstände sowie gegebenenfalls parasitäre Kapazitäten, ergeben. All das sorgt dafür, dass das vergleichsweise große Steuerelektrodenfeld eines Leistungstransistors an einer Vielzahl von einzelnen Teilbereichen gleichzeitig mit dem Ansteuersignal versorgt wird, welches seinerseits vorzugsweise digital erzeugt wird und infolge der Vielzahl von Stufen in jedem Teilbereich der Steuerelektrodenfläche elektrisch stabilisiert ist. Hierfür sorgt insbesondere die Umsetzung der Einzeltreiberschaltungen als digitale Inverterschaltungen.

Das hier vorgestellte Konzept umfasst eine Selbstähnlichkeit auf Schaltungsebene und eine Selbstähnlichkeit auf Layout-Ebene. Beide Arten der Selbstähnlichkeit werden hier jede für sich und gemeinsam beansprucht.

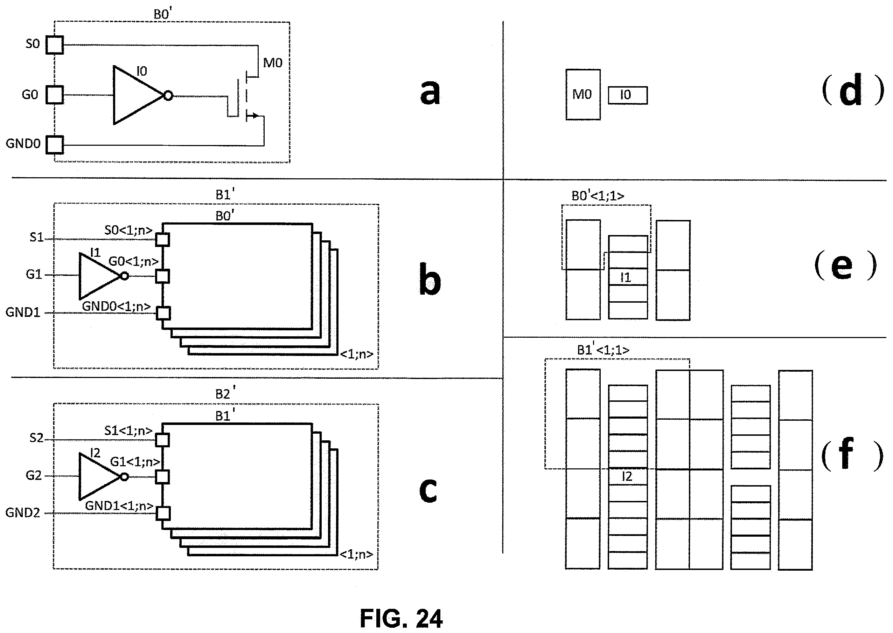

Fig. 24 zeigt vereinfacht das Grundkonzept der Erfindung zu Grunde liegenden Selbstähnlichkeit der Schaltungsarchitektur auf Basis des Schaltplans und des Schaltungslayouts. Die Fig. 24 umfasst sechs Fign. 24(a) bis 24(f), die im Folgenden erläutert werden. Die drei Fign. 24(a) bis 24(c) auf der linken Seite zeigen vereinfacht das Konzept der selbstähnlichen Struktur auf Schaltplanseite. Die drei Fign. 24(d) bis 24(f) auf der rechten Seite zeigen vereinfacht das Konzept der selbstähnlichen Struktur auf der entsprechenden Layout-Seite.

Die Fig. 24(a) zeigt den beispielhaft dargestellten Schaltplan einer ersten Struktur B0'. Die erste Struktur B0' weist einen ersten Anschluss S0 der ersten Struktur B0' und einen zweiten Anschluss G0 der ersten Struktur B0' und einen dritten Anschluss GND0 der ersten Struktur B0' auf. Die erste Struktur B0' umfasst einen ersten Teil I0 eines ersten Treibers und einen ersten Teil M0 eines ersten Feldeffekttransistors. Der erste Teil I0 des ersten Treibers weist einen ersten und einen zweiten Anschluss auf. Der erste Teil M0 des ersten Feldeffekttransistors weist einen Gate-Anschluss und einen Drain-Anschluss und einen Source-Anschluss auf. Der erste Anschluss S0 der ersten Grundstruktur B0' ist mit dem Drain-Anschluss des ersten Teils M0 des ersten Feldeffekttransistors elektrisch leitend verbunden. Der dritte Anschluss GND0 der ersten Struktur B0' ist mit dem Source-Anschluss des ersten Teils M0 des ersten Feldeffekttransistors elektrisch leitend verbunden. Der zweite Anschluss G0 der ersten Struktur B0' ist mit dem ersten Anschluss des ersten Teils I0 des ersten Treibers elektrisch leitend verbunden. Der zweite Anschluss des ersten Teils I0 des ersten Treibers ist mit dem Gate-Anschluss des ersten Teils M0 des ersten Feldeffekttransistors elektrisch leitend verbunden.

Die Fig. 24(d) zeigt dementsprechend die vereinfachte Layout-Darstellung der ersten Struktur B0'. Der erste Teil M0 des ersten Feldeffekttransistors und der erste Teil I0 des ersten Treibers sind als benachbarte Rechtecke dargestellt.

Fig. 24(b) zeigt die beispielhafte Kombination von n Strukturen B0' der Fig. 24(a) zu einer ersten Grundstruktur B1'. Die Variable n steht hierbei für eine natürliche Zahl größer 1. Bevorzugt ist n gleich 4. Die erste Grundstruktur B1' weist einen ersten Anschluss S1 der ersten Grundstruktur B1' und einen zweiten Anschluss G1 der ersten Grundstruktur B1' und einen dritten Anschluss GND1 der ersten Grundstruktur B1' auf. Die erste Grundstruktur B1' umfasst n Strukturen B0'. Die n ersten Anschlüsse S0<1;n> der n Strukturen B0' sind mit dem ersten Anschluss S1 der ersten Grundstruktur B1' elektrisch leitend verbunden.

Die n dritten Anschlüsse GND0<1;n> der n Strukturen B0' sind mit dem dritten Anschluss GND1 der ersten Grundstruktur B1' elektrisch leitend verbunden.

Die erste Grundstruktur B1' umfasst einen ersten Teil I1 eines zweiten Treibers. Der erste Teil I1 des zweiten Treibers weist einen ersten Anschluss und einen zweiten Anschluss auf.

Der erste Anschluss des ersten Teils I1 des zweiten Treibers ist mit dem zweiten Anschluss G1 der ersten Grundstruktur B1' elektrisch leitend verbunden. Der zweite Anschluss des ersten Teils I1 des zweiten Treibers ist mit den n zweiten Anschlüssen G0<1;n> der n Strukturen B0' elektrisch leitend verbunden.

Fig. 24(e) zeigt eine vereinfachte Layout-Darstellung der ersten Grundstruktur B1'. Die erste Grundstruktur B1' umfasst hier vier Strukturen B0' und den ersten Teil I1 des zweiten Treibers. Durch die benachbarte Positionierung von Teilen des ersten Treibers wird ein weiterer Teil des ersten Treibers oder der gesamte erste Treiber gebildet. Durch die benachbarte Positionierung von Teilen des ersten Feldeffekttransistors wird ein weiterer Teil des ersten Feldeffekttransistors oder der gesamte erste Feldeffekttransistor gebildet.

Fig. 24(c) zeigt die Kombination von n ersten Grundstrukturen B1' der Fig. 24(b) zu einer ersten selbstähnlichen Struktur B2'. Die Variable n steht hierbei für eine natürliche Zahl größer 1. Bevorzugt ist n gleich 4. Die erste selbstähnliche Struktur B2' weist einen ersten Anschluss S2 der ersten selbstähnlichen Struktur B2' und einen zweiten Anschluss G2 der ersten selbstähnlichen Struktur B2' und einen dritten Anschluss GND2 der ersten selbstähnlichen Struktur B2' auf. Die erste selbstähnliche Struktur B2' umfasst n erste Strukturen B1'. Die n ersten Anschlüsse S1<1;n> der n ersten Grundstrukturen B1' sind mit dem ersten Anschluss S1 der ersten selbstähnlichen Struktur B2' elektrisch leitend verbunden. Die n dritten Anschlüsse GND1<1;n> der n ersten Grundstrukturen B1' sind mit dem dritten Anschluss GND2 der ersten selbstähnlichen Struktur B2' elektrisch leitend verbunden.

Die erste selbstähnliche Struktur B2' umfasst einen ersten Teil I2 eines dritten Treibers. Der erste Teil I3 des dritten Treibers weist einen ersten Anschluss und einen zweiten Anschluss auf.

Der erste Anschluss des ersten Teils I2 des dritten Treibers ist mit dem zweiten Anschluss G2 der ersten selbstähnlichen Struktur B2' elektrisch leitend verbunden. Der zweite Anschluss des ersten Teils I3 des dritten Treibers ist mit den n zweiten Anschlüssen G1<1;n> der n ersten Grundstrukturen B1' elektrisch leitend verbunden.

Fig. 24(f) zeigt eine vereinfachte Layout-Darstellung der ersten selbstähnlichen Struktur B2'. Die erste selbstähnliche Struktur B2' umfasst hier vier erste Grundstrukturen B1' und den ersten Teil I2 des dritten Treibers. Durch die benachbarte Positionierung von Teilen des ersten Treibers wird ein weiterer Teil des ersten Treibers oder der gesamte erste Treiber gebildet. Durch die benachbarte Positionierung von Teilen des ersten Feldeffekttransistors wird ein weiterer Teil des ersten Feldeffekttransistors oder der gesamte erste Feldeffekttransistor gebildet.

Die Erweiterung zu größeren selbstähnlichen Strukturen auf Basis der ersten selbstähnlichen Struktur B2' und ihrer kleinsten selbstähnlichen Einheit, der ersten Grundstruktur B1', lässt sich beliebig fortsetzen.

Bei weiterer Vereinfachung der Darstellung des Layouts wird die Selbstähnlichkeit der Struktur und die Unterteilung der Treiber und Transistoren in verschiedene Blöcke noch deutlicher.

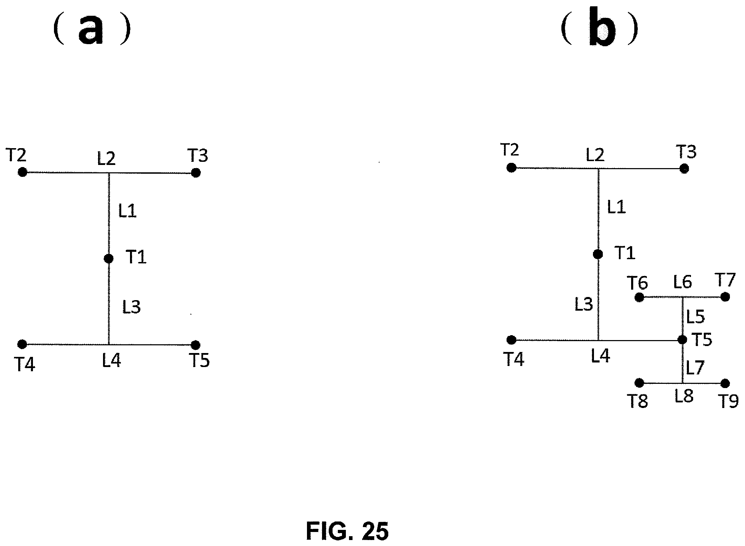

Fig. 25(a) zeigt auf der linken Seite ein vereinfacht dargestelltes Layout einer Grundstruktur der erfindungsgemäßen selbstähnlichen Struktur als Stick-Layout. In Fig. 25(b) ist gezeigt, wie weitere Grundstrukturen kombiniert werden, so dass sich letztendlich die erfindungsgemäße selbstähnliche Struktur ergibt.

In der Fig. 25 sind Treiberteile als schwarze Punkte vereinfacht dargestellt. Treiberteil im Sinne dieser Erfindung bezeichnet einen für sich alleine funktionsfähigen Teil eines Treibers. Ein Treiber kann daher in mehrere, eventuell räumlich voneinander getrennte Treiberteile aufgeteilt werden, die auf Grund ihrer Anordnung in der erfindungsgemäßen selbstähnlichen Struktur, gemeinsam dieselbe Funktionalität erbringen wie ein nicht räumlich aufgeteilter Treiber. In dieser Beschreibung werden die Begriffe "Treiberteil" und "Teil eines Treibers" synonym verwendet.

Teile von Feldeffekttransistoren sind in Fig. 25(b) als rechteckige, gepunktete Flächen F1, F2, F3, F4 vereinfacht dargestellt. Feldeffekttransistorteil im Sinne dieser Erfindung bezeichnet einen für sich alleine funktionsfähigen Teil eines Feldeffekttransistors. Ein Feldeffekttransistor kann daher in mehrere, eventuell räumlich voneinander getrennte Feldeffekttransistorteile aufgeteilt werden, die auf Grund ihrer Anordnung in der erfindungsgemäßen selbstähnlichen Struktur, gemeinsam dieselbe Funktionalität erbringen wie ein nicht räumlich aufgeteilter Feldeffekttransistor. In dieser Beschreibung werden die Begriffe "Feldeffekttransistorteil" und "Teil eines Feldeffekttransistors" synonym verwendet.

Zunächst wird die in Fig. 25(a) gezeigte Grundstruktur beschrieben. Ein erster Treiberteil T1 ist über eine erste Leitung L1 mit einer zweiten Leitung L2 elektrisch leitend verbunden. Die erste Leitung L1 und die zweite Leitung L2 verlaufen rechtwinklig zu einander. Die Verbindungsstelle der ersten Leitung L1 und der zweiten Leitung L2 liegt im Streckenmittelpunkt der zweiten Leitung L2. Die zweite Leitung L2 verbindet einen zweiten Treiberteil T2 und einen dritten Treiberteil T3 elektrisch leitend miteinander. Der zweite Treiberteil T2 und der dritte Treiberteil T3 sind symmetrisch zu der Verbindungstelle der ersten Leitung L1 und der zweiten Leitung L2 angeordnet.

Der erste Treiberteil T1 ist über eine dritte Leitung L3 mit einer vierten Leitung L4 elektrisch leitend verbunden. Die dritte Leitung L3 und die vierte Leitung L4 verlaufen in diesem Beispiel rechtwinklig zu einander. Die Verbindungsstelle der dritten Leitung L3 und der vierten Leitung L4 liegt im Streckenmittelpunkt der vierten Leitung L4. Die vierte Leitung L4 verbindet einen vierten Treiberteil T4 und einen fünften Treiberteil T5 elektrisch leitend miteinander. Der vierte Treiberteil T4 und der fünfte Treiberteil T5 sind symmetrisch zu der Verbindungstelle der dritten Leitung L3 und der vierten Leitung L4 angeordnet.

Der erste Treiberteil T1 liegt somit im Mittelpunkt eines gedachten Rechtecks, an dessen Eckpunkten der zweite Treiberteil T2 und der dritte Treiberteil T3 und der vierte Treiberteil T4 und der fünfte Treiberteil T5 platziert sind.

Die beschriebene Grundstruktur kann wie im Folgenden beschrieben fortgesetzt werden, wobei immer weitere solcher Grundstrukturen entstehen. Dies wird anhand der Fig. 25(b) erläutert. Der fünfte Treiberteil T5 der beschriebenen Grundstruktur ist hier im geometrischen Zentrum einer weiteren Grundstruktur. Der fünfte Treiberteil T5 ist über eine fünfte Leitung L5 mit einer sechsten Leitung L6 elektrisch leitend verbunden. Die fünfte Leitung L5 und die sechste Leitung L6 sind rechtwinklig zu einander angeordnet. Die Verbindungsstelle der fünften Leitung L5 und der sechsten Leitung L6 liegt im Mittelpunkt der sechsten Leitung L6. Die sechste Leitung L6 verbindet einen sechsten Treiberteil T6 und einen siebten Treiberteil T7 elektrisch leitend miteinander. Der sechste Treiberteil T6 und der siebte Treiberteil T7 sind symmetrisch zu der Verbindungstelle der fünften Leitung L5 und der sechsten Leitung L6 angeordnet.

Der fünfte Treiberteil T5 ist über eine siebte Leitung L7 mit einer achten Leitung L8 elektrisch leitend verbunden. Die siebte Leitung L7 und die achte Leitung L8 sind rechtwinklig zu einander angeordnet. Die Verbindungsstelle der siebten Leitung L7 und der achten Leitung L8 liegt im Mittelpunkt der achten Leitung L8. Die achte Leitung L8 verbindet einen achten Treiberteil T8 und einen neunten Treiberteil T9 elektrisch leitend miteinander. Der achte Treiberteil T8 und der neunte Treiberteil T9 sind symmetrisch zu der Verbindungstelle der siebten Leitung L7 und der achten Leitung L8 angeordnet.

Somit liegt in dieser neuen Grundstruktur jetzt der fünfte Treiberteil T5 im Mittelpunkt eines Rechtecks an dessen Eckpunkten der sechste Treiberteil T6 und der siebte Treiberteil T7 und der achte Treiberteil T8 und der neunte Treiberteil T9 platziert sind. Entsprechend kann auch jeder andere Treiberteil, der an einem Eckpunkt eines solchen Rechtecks liegt, das Zentrum einer weiteren Grundstruktur sein. Der erste Treiberteil T1 könnte ebenfalls auf dem Eckpunkt eines solchen Rechtecks einer nicht gezeichneten, weiteren Grundstruktur liegen.

Darüber hinaus kann jeder Treiberteil, der auf dem Eckpunkt eines solchen Rechtecks liegt, also im gezeichneten Beispiel der zweite Treiberteil T2 oder der dritte Treiberteil T3 oder der vierte Treiberteil T4 oder der fünfte Treiberteil T5 oder der sechste Treiberteil T6 oder der siebte Treiberteil T7 oder der achte Treiberteil T8 oder der neunte Treiberteil T9, mit vier Feldeffekttransistorteilen elektrisch leitend verbunden sein.

In Fig. 25(b) ist dies anhand des zweiten Treiberteils T2 gezeigt. Der zweite Treiberteil T2 ist mit einem ersten Feldeffekttransistorteil F1 und mit einem zweiten Feldeffekttransistorteil F2 und mit einem dritten Feldeffekttransistorteil F3 und mit einem vierten Feldeffekttransistorteil F4 elektrisch leitend verbunden. Hierbei liegt der erste Feldeffekttransistorteil F1 über dem dritten Feldeffekttransistorteil F3 und links von dem zweiten Feldeffekttransistorteil F2. Der vierte Feldeffekttransistorteil F4 liegt unterhalb des zweiten Feldeffekttransistorteil F2 und rechts von dem dritten Feldeffekttransistorteil F3. Der zweite Treiberteil T2 liegt somit im Zentrum des von den vier Feldeffekttransistorteilen F1, F2, F3, F4 gebildeten Rechtecks.

Die vier Feldeffekttransistorteile F1, F2, F3, F4 bilden als gemeinsame Funktionseinheit zusammen einen Feldeffekttransistor. Um die Ausbreitung eines Feldeffekttransistors mit geringem Drain-Source-Widerstand über große Flächen zu vermeiden, wurde der Feldeffekttransistor entsprechend in vier Feldeffekttransistorteile F1, F2, F3, F4 aufgeteilt. Analog werden die Treiber in die beschriebenen Treiberteile aufgeteilt.

Fig. 26 zeigt eine vereinfachte Darstellung der der Erfindung zu Grunde liegenden Selbstähnlichkeit des Schaltungslayouts. Treiberteile sind als schwarze Punkte vereinfacht dargestellt. Teile von Feldeffekttransistoren sind als rechteckige, gepunktete Flächen vereinfacht dargestellt. Fig. 26 zeigt nun eine umfangreichere Kombination der in Fig. 25 beschriebenen Grundstrukturen zu einer größeren selbstähnlichen Struktur. Nach dem in Fig. 25 beschriebenen Prinzip könnte an jedem Treiberteil wieder eine solche Grundstruktur ergänzt werden und die gezeigte selbstähnliche Struktur ließe sich beliebig fortsetzten. Die Feldeffekttransistorteile sind hier nur für einige Grundstrukturen beispielhaft eingezeichnet und könnten ebenfalls an weiteren Grundstrukturen ergänzt werden.

Die Fig. 26 zeigt die Aufsicht auf ein Layout der erfindungsgemäßen selbstähnlichen Struktur. Es ist hier zu erkennen, dass nur eine Metallisierungslage benötigt wird, da alle elektrisch leitenden Verbindungen in derselben Ebene liegen. Die Einspeisung eines Signals erfolgt an einem ersten Signalanschluss DP. Der erste Signalanschluss DP ist bevorzugt mit einem Treiberteil elektrisch leitend verbunden, welcher im geometrischen Zentrum der selbstähnlichen Struktur liegt. Hierdurch wird die aus der Symmetrie der Grundstruktur, bzw. der selbstähnlichen Struktur, resultierende balancierte Signalverdrahtung ausgenutzt.

Eine solche selbstähnliche Struktur einer Treiberschaltung, bei der Treiber und Transistoren verschachtelt aufgeteilt sind, ermöglicht zumindest in einigen Realisierungen eine Erhöhung der maximal erreichbaren Schaltgeschwindigkeit gegenüber Schaltungen mit diskreten Bauteilen und gegenüber integrierten Schaltungen mit unverschachtelten und/oder nicht selbstähnlich strukturierten Treibern. Daher kann die erfindungsgemäße selbstähnliche Struktur einer Treiberschaltung bei allen Anwendungen eingesetzt werden, die von kurzen Schaltzeiten bei hohen Strömen profitieren. Die verschachtelten Treiber und Vortreiber können auf einem Die im CMOS-Prozess gefertigt werden, was monolithische Treiber-ICs mit zusätzlichen CMOS-üblichen Funktionen (Digitale Konfiguration, integrierte Puls-Shaping- und Diagnose-Schaltungen) ermöglicht. Gegenüber einer CMOS-Architektur mit getrennten Treiber- und Vortreiber-Blöcken lässt sich die verschachtelte Architektur nach der Erfindung besser skalieren, wobei man schnellere Anstiegszeiten und kompaktere Systemlösungen als mit diskreten Aufbauten erreicht.

Die Vorteile sind hierauf aber nicht beschränkt. Insbesondere ist die zuvor beschriebene Treiberschaltung nicht auf die Anwendung für den Pulsbetrieb einer Leucht- oder Laserdiode beschränkt oder etwa auf die Anwendung eines derartigen Pulsbetriebs bei einer LIDAR-Vorrichtung beschränkt. So kann der Pulsbetrieb des Transistors auch in einem Schaltnetzteil, einem DC-DC-Konverter und überall dort eingesetzt werden, wo es darum geht, steile Anstiegsflanken elektrischer Signale zu erzeugen.

Die Treiberschaltung wurde vorstehend anhand von Begriffen wie "Treiberteil" und "Feldeffekttransistorteil" erläutert. Diese Begriffe sind gleichzusetzen mit Einzeltreiberschaltung (als Treiberteil) und Einzeltransistor (als Feldeffekttransistorteil). In Fig. 26 ist mit GSA der Gesamtsteueranschluss des Transistors $T_{dis}$ bezeichnet. Dieser Gesamtsteueranschluss weist eine Steueranschluss-Gesamtfläche GF auf, die in eine Vielzahl von Steueranschluss-Einzelflächen GFE für Einzeltransistoren (nicht dargestellt) des Transistors $T_{dis}$ regelmäßig unterteilt ist. Jeweils vier dieser Steueranschluss-Einzelflächen bzw. vier Einzelsteueranschlüsse ESA sind die vier Ausgänge einer Einzeltreiberschaltung T1 bis T9 zugeordnet (siehe beispielsweise die Einzeltreiberschaltungen T2 und T9 in Fig. 26, deren Ausgänge mit den vier Einzeltransistoren entsprechend F1 bis F4 verbunden sind).

In Fig. 25(a) ist beispielsweise die vorletzte Stufe der Treiberschaltung gezeigt. In Fig. 25(b) ist dann die letzte Stufe der Treiberschaltung gezeigt, und zwar lediglich für die von T5 ausgehende Treiberschaltungsstruktur, die beispielsweise dem unteren rechten Eckbereich der Fig. 26 entspricht.

Wie insbesondere anhand von Fig. 26 zu erkennen ist, weist die dort gezeigte Treiberschaltung vier Stufen auf, wobei der mit dem Anschluss DP verbundene kreisrunde Punkt die Einzeltreiberschaltung der ersten Stufe zeigt und die Einzeltreiberschaltungen entsprechend den runden Punkten T6, T7, T8 und T9 (siehe auch Fig. 25) die Einzeltreiberschaltungen der letzten Stufe zeigen. Die im Ausführungsbeispiel der Fign. 25 und 26 H-förmigen Strukturen verkleinern sich von Stufe zu Stufe. Der Vorteil dieser regelmäßigen Anordnung von selbstähnlichen Strukturen ist, dass die Signallaufwege ausgehend vom Anschluss DP bis zu den Einzeltreiberschaltungen der vierten Stufe stets gleich lang und auch stets gleich bzw. schaltungstechnisch ähnlich ausgebildet sind. Dies ist in Fig. 26 anhand zweier gestrichelter Linien verdeutlicht, die ausgehend vom Anschluss DP zu unterschiedlichen Einzeltreiberschaltungen der vierten Stufe führen.

Durch die besondere Ausgestaltung der Verschachtelung der einzelnen Treiberstufen der Treiberschaltung ist es möglich, die in Digital-Schaltungstechnik ausgeführte Treiberschaltung mit einer Vielzahl von Digital-Ausgängen zu versehen, die nun gleichmäßig über die vergleichsweise große Elektrode des in Analog-Schaltungstechnik ausgeführten Leistungstransistors verteilt sind und an denen bei Anlegen eines Signals am Eingang der Treiberschaltung zeitgleich Digital-Ausgangssignale ausgegeben werden. Jedes Digital-Ausgangssignal "versorgt" nun eine Steueranschluss-Einzelfläche eines Einzeltransistors, wobei nun sämtliche Einzeltransistoren gleichzeitig schalten und damit der Gesamttransistor schnell und effektiv einen Strompuls erzeugt, der hochenergetisch ist und den Laser zur Erzeugung eines kräftigen Lichtpulses veranlasst.

## GLOSSAR

Powell-Linsen

Powell-Linsen dienen der Erzeugung eines linienförmigen Strahlprofils aus einem ellipsen- oder ovalförmigen Gauß-Strahl (also mit einer gaußförmigen Intensitätsverteilung). Entlang der Linie wird bevorzugt eine homogene Intensitätsverteilung erzeugt, senkrecht dazu bleibt die Gaußverteilung des Lasers erhalten. Linienoptiken lassen sich mit einem Öffnungswinkel von wenigen Grad bis über 90° herstellen.

Die Powell Funktion ist jedoch nur eine sekundäre Aufgabe dieser Linsen im Rahmen der hier beschriebenen technischen Lehre. Die primäre Aufgabe ist die Fokussierung aller Laserstrahlen in vertikaler Richtung. Eine Optik, die diese Funktion erfüllt wird im Sinne dieser Schrift bereits als Powell-Linse bezeichnet und von den Ansprüchen umfasst. Die Fokussierung aller Laserstrahlen in vertikaler Richtung wird beispielsweise durch die andere Seite der beispielsweise in den Fign. 14 und 19 bis 22 abgebildeten Linsen erzielt. Die Powell-Funktion wäre insofern als nicht unbedingt nötig, da auch eine Gaußverteilung in horizontaler Richtung für den hier beschriebenen Zweck akzeptabel wäre. In einem solchen Fall würde die Vorrichtung eine größere Messreichweite in Vorwärtsrichtung als seitwärts Richtung aufweisen, was je nach Anwendungsfall tatsächlich gewollt sein kann. Es ist möglich beide Funktionen in einer Oberfläche zu integrieren. Die andere Seite einer solchen Linse ist dann gegebenenfalls flach. Diese Linse wäre ebenfalls von den Ansprüchen umfasst. Eine solche Linse im Sinne der Erfindung zeichnet sich also durch eine vertikale Fokussierung aus. Man könnte dann auch konsequenterweise bei einer solchen Linse statt von einer Powell-Linse von einer "Scanlinse" sprechen, die von der Erfindung natürlich mit umfasst ist.

## BEZUGSZEICHENLISTE

| | |
|---|---|
| A1 | erste Achse |
| A2 | zweite Achse |
| AF | Anschlussfeld der Aufladeschaltung |

| | |
|---|---|
| B0' | erste Struktur |
| B1 | erste Aufladeschaltung für den ersten Kondensator C1, der den ersten Laser D1 für eine Lichtpulserzeugung mit elektrischer Energie versorgt |
| B1' | erste Grundstruktur |
| B2 | zweite Aufladeschaltung für den zweiten Kondensator C2, der den zweiten Laser D2 für eine Lichtpulserzeugung mit elektrischer Energie versorgt |
| B2' | erste selbstähnliche Struktur |
| B3 | dritte Aufladeschaltung für den dritten Kondensator C3, der den dritten Laser D3 für eine Lichtpulserzeugung mit elektrischer Energie versorgt |
| BD1 | erster Bonddraht |
| BD2 | zweiter Bonddraht |
| BD3 | dritter Bonddraht |
| Bn | n-te Aufladeschaltung für den n-ten Kondensator Cn, der den n-ten Laser Dn gegebenenfalls mit elektrischer Energie im Falle einer Lichtpulserzeugung versorgt |
| Buf | Treiber, der das Pulsvorsignal PL zum Pulssignal $G_{dis}$ verstärkt |
| C1 | erster Kondensator als Energiereserve für den ersten Laser D1 |
| C2 | zweiter Kondensator als Energiereserve für den zweiten Laser D2 |
| C3 | dritter Kondensator als Energiereserve für den dritten Laser D3 |
| Cn | n-ter Kondensator als Energiereserve für den n-ten Laser Dn |
| CS | Auswahlsignal |
| CTR | Steuerschaltung, die die n Aufladeschaltungen B1 bis Bn steuert und das Pulsvorsignal PL erzeugt. Die Steuerschaltung veranlasst eine der n Aufladeschaltungen, typischerweise einen der n Kondensatoren vor der Erzeugung eines Lichtpulses durch einen der n Laser zu laden, schaltet dann bevorzugt alle Aufladeschaltungen bevorzugt ab bzw. die Ladeausgänge bevorzugt aller Aufladeschaltungen hochohmig und schließt dann den Ansteuerschalter $T_{dis}$, was die Lichtpulserzeugung initiiert. Die Steuerschaltung wiederholt diesen Vorgang, bis alle n Laser bevorzugt genau einmal einen Lichtpuls abgegeben haben und beginnt dann wieder von vorne mit dem nächsten Durchgang |
| CVDD | Stützkondensator zur Stabilisierung der Betriebsspannung VDD |
| D1 | erster Laser |
| D1D | Laserdioden-Die |
| D2 | zweiter Laser |
| D3 | dritter Laser |
| D4 | vierter Laser |
| DAF1 | erstes Anschlussfeld eines Laserdioden-Dies |
| DAF2 | zweites Anschlussfeld eines Laderdioden-Dies |
| DisC | erster Sternpunkt und Kontaktfläche für den ersten Sternpunkt. Am ersten Sternpunkt sind bevorzugt die Kathoden der Laser D1 bis Dn angeschlossen. Der erste Sternpunkt wird bei Eintreffen eines Pulssignals $G_{dis}$ durch den Ansteuerschalter $T_{dis}$) mit dem Bezugspotenzial GND verbunden. Sofern einer der Kondensatoren C1 bis Cn zuvor geladen wurde, erfolgt dann die Entladung dieses Kondensators über den entsprechenden Laser, der dann einen Lichtpuls abgibt. |
| DisK | zweiter Sternpunkt als gemeinsamer Verbindungspunkt der Kondensatoren C1 bis Cn |
| Dn | n-ter Laser |
| DP | erster Signalanschluss |
| DR | Drohne |
| EL | Empfangslinse |
| ESA | Einzelsteueranschluss eines Einzeltransistors |
| F1 | erster Feldeffekttransistorteil |
| F2 | zweiter Feldeffekttransistorteil |
| F3 | dritter Feldeffekttransistorteil |
| F4 | vierter Feldeffekttransistorteil |
| G0 | zweiter Anschluss der ersten Struktur B0' |
| G1 | zweiter Anschluss der ersten Grundstruktur B1' |
| G0<1;n> | n zweite Anschlüsse der n Strukturen B0' |
| G1<1;n> | n zweite Anschlüsse der n ersten Grundstrukturen B1' |
| $G_{dis}$ | Pulssignal |
| GF | Steueranschluss-Gesamtfläche |
| GFE | Steueranschluss-Einzelfläche |
| GND | Kontaktfläche für Bezugspotenzial, Bezugspotenzial |

| | |
|---|---|
| GNDA | analoges Bezugspotenzial |
| GNDD | digitales Bezugspotenzial |
| GNDH | Bezugspotenzial für die hohe Versorgungsspannung |
| GNDP | Bezugspotenzial der Schnittstellen |
| GND0 | dritter Anschluss der ersten Struktur B0' |
| GND1 | dritter Anschluss der ersten Grundstruktur B1' |
| GND2 | dritter Anschluss der ersten selbstähnlichen Struktur B2' |
| GND0<1;n> | n dritte Anschlüsse der n Strukturen B0' |
| GND1<1;n> | n dritte Anschlüsse der n ersten Grundstrukturen B1' |
| GSA | Gesamtsteueranschluss des Transistors |
| $GT_{dis}$ | Steueranschluss des Transistors |
| HV | erstes Bezugspotential |
| I | Treiberschaltung |
| I0 | erster Teil des ersten Treibers |
| I1 | erster Teil des zweiten Treibers |
| I2 | erster Teil des dritten Treibers |
| L1 | erste Leitung |
| L2 | zweite Leitung |
| L3 | dritte Leitung |
| L4 | vierte Leitung |
| L5 | fünfte Leitung |
| L6 | sechste Leitung |
| L7 | siebte Leitung |
| L8 | achte Leitung |
| LD | Laserdiode |
| M | Feldeffekttransistor |
| M0 | erster Teil des ersten Feldeffekttransistors |
| K1 | erste Aufladeleitung, über die die erste Aufladeschaltung B1 den ersten Kondensator C1 vor einer Lichtpulserzeugung durch den ersten Laser D1 lädt |
| K1' | erste Entladeleitung, über die der erste Laser D1 den ersten Kondensator C1 entlädt, wenn der Ansteuerschalter $T_{dis}$ durch das Pulssignal $G_{dis}$ geschlossen ist |
| K2 | zweite Aufladeleitung, über die die zweite Aufladeschaltung B2 den zweiten Kondensator C2 vor einer Lichtpulserzeugung durch den zweiten Laser D2 lädt |
| K2' | zweite Entladeleitung, über die der zweite Laser D2 den zweiten Kondensator C2 entlädt, wenn der Ansteuerschalter $T_{dis}$ durch das Pulssignal $G_{dis}$ geschlossen ist |
| K3 | dritte Aufladeleitung, über die die dritte Aufladeschaltung B3 den dritten Kondensator C3 vor einer Lichtpulserzeugung durch den dritten Laser D3 lädt |
| K3' | dritte Entladeleitung, über die der dritte Laser D3 den dritten Kondensator C3 entlädt, wenn der Ansteuerschalter $T_{dis}$ durch das Pulssignal $G_{dis}$ geschlossen ist |
| KA | Kondensator-Array |
| KG' | virtueller Knoten der Versorgungsspannung VDD |
| KL | optionale gekrümmte Linie, längs derer die Laser-Module und/oder deren Laser ausgerichtet werden. |
| Kn | n-te Aufladeleitung, über die die n-te Aufladeschaltung Bn den n-ten Kondensator Cn vor einer Lichtpulserzeugung durch den n-ten Laser Dn lädt |
| Kn' | n-te Entladeleitung, über die der n-te Laser Dn den n-ten Kondensator Cn entlädt, wenn der Ansteuerschalter $T_{dis}$ durch das Pulssignal $G_{dis}$ geschlossen ist |
| KR | Unterseitenkontakt des Kondensator-Arrays |
| L | LIDAR-System |
| LAF1 | erstes Anschlussfeld des Ladungsspeicherbauteils |
| LAF2 | zweites Anschlussfeld des Ladungsspeicherbauteils |
| LC1 | Induktivität der Leitung, mit der der zweite Kontakt des ersten Kondensators C1 an das Bezugspotenzial angeschlossen ist |
| LC2 | Induktivität der Leitung, mit der der zweite Kontakt des zweiten Kondensators C2 an das Bezugspotenzial angeschlossen ist |
| LC3 | Induktivität der Leitung, mit der der zweite Kontakt des dritten Kondensators C3 an das Bezugspotenzial angeschlossen ist |
| LCn | Induktivität der Leitung, mit der der zweite Kontakt des n-ten Kondensators Cn an das Bezugspotenzial angeschlossen ist |

| | |
|---|---|
| LCV | Leitungsinduktivität zwischen dem zweiten Anschluss des Stützkondensators CVDD und dem Bezugspotenzial GND |
| LF1 | erster Lichtfächer des ersten Lasers D1 |
| LF2 | zweiter Lichtfächer des zweiten Lasers D2 |
| LF3 | dritter Lichtfächer des dritten Lasers D3 |
| LF4 | vierter Lichtfächer des vierten Lasers D4 |
| LDZ | Laserdiodenreihe |
| LPF | Leitungspfad des Transistors |
| LPF1 | erster Endbereich des Leitungspfads |
| LPF2 | zweiter Endbereich des Leitungspfads |
| LSBT | Ladungsspeicherbauteil |
| LZ1 | Induktivität der ersten Aufladeleitung K1, über die die erste Aufladeschaltung B1 den ersten Kondensator C1 vor einer Lichtpulserzeugung durch den ersten Laser D1 lädt |
| LZ2 | Induktivität der zweiten Aufladeleitung K2, über die die zweite Aufladeschaltung B2 den zweiten Kondensator C2 vor einer Lichtpulserzeugung durch den zweiten Laser D2 lädt |
| LZ3 | Induktivität der dritten Aufladeleitung K3, über die die dritte Aufladeschaltung B3 den dritten Kondensator C3 vor einer Lichtpulserzeugung durch den dritten Laser D3 lädt |
| LZn | Induktivität der n-ten Aufladeleitung Kn, über die die n-te Aufladeschaltung Bn den n-ten Kondensator Cn vor einer Lichtpulserzeugung durch den n-ten Laser Dn lädt |
| LZV | Leitungsinduktivität der Zuleitung zum Stützkondensator CVDD |
| ME | Mittenebene der Linse |
| MOSI | Eingang des SPI-Datenbusses |
| MISO | Ausgang des SPI-Datenbusses |
| OF1 | erste Linsenoberfläche |
| OF2 | zweite Linsenoberfläche |
| PL | Powell-Linse |
| Pulse | Beispielsignal, das allen Modulen zugeführt wird |
| R1 | beispielhafter erster lokaler Radiusvektor für die Krümmung der ersten Oberfläche OF1 um eine beispielhafte erste Achse A1 |
| R2 | beispielhafter zweiter lokaler Radiusvektor für die Krümmung der zweiten Oberfläche OF2 um eine beispielhafte zweite Achse A2 |
| PL | Pulsvorsignal |
| RC1 | Widerstand der Leitung, mit der der zweite Kontakt des ersten Kondensators C1 an das Bezugspotenzial angeschlossen ist |
| RC2 | Widerstand der Leitung, mit der der zweite Kontakt des zweiten Kondensators C2 an das Bezugspotenzial angeschlossen ist |
| RC3 | Widerstand der Leitung, mit der der zweite Kontakt des dritten Kondensators C3 an das Bezugspotenzial angeschlossen ist |
| RCn | Widerstand der Leitung, mit der der zweite Kontakt des n-ten Kondensators Cn an das Bezugspotenzial angeschlossen ist |
| RCV | Leitungswiderstand zwischen dem zweiten Anschluss des Stützkondensators CVDD und dem Bezugspotenzial GND |
| RST | Rücksetzsignal |
| RZ1 | Widerstand der ersten Aufladeleitung K1, über die die erste Aufladeschaltung B1 den ersten Kondensator C1 vor einer Lichtpulserzeugung durch den ersten Laser D1 lädt |
| RZ2 | Widerstand der zweiten Aufladeleitung K2, über die die zweite Aufladeschaltung B2 den zweiten Kondensator C2 vor einer Lichtpulserzeugung durch den zweiten Laser D2 lädt |
| RZ3 | Widerstand der dritten Aufladeleitung K3, über die die dritte Aufladeschaltung B3 den dritten Kondensator C3 vor einer Lichtpulserzeugung durch den dritten Laser D3 lädt |
| RZV | Leitungswiderstand der Zuleitung zum Stützkondensator CVDD |
| RZn | Widerstand der n-ten Aufladeleitung Kn, über die die n-te Aufladeschaltung Bn den n-ten Kondensator Cn vor einer Lichtpulserzeugung durch den n-ten Laser Dn lädt |
| S | Fotosensor |
| S0 | erster Anschluss der ersten Struktur B0' |
| S1 | erster Anschluss der ersten Grundstruktur B1' |
| S2 | erster Anschluss der ersten selbstähnlichen Struktur B2' |
| S0<1;n> | n erste Anschlüsse der n Strukturen B0' |
| S1<1;n> | n erste Anschlüsse der n ersten Grundstrukturen B1' |

| SCK | Taktsignal des SPI-Datenbusses |
| SL | Sendelinse |
| SLE | Senderoptikelement |
| TAF1 | erstes Leitungspfad-Anschlussfeld |
| TAF2 | zweites Leitungspfad-Anschlussfeld |
| $T_{dis}$ | Ansteuerschalter bevorzugt als Transistor ausgebildet |
| TR | Träger |
| TRIG | Anschluss für das Zündsignal |
| TRO | Oberseite des Trägers |
| T1 | erster Treiberteil |
| T2 | zweiter Treiberteil |
| T3 | dritter Treiberteil |
| T4 | vierter Treiberteil |
| T5 | fünfter Treiberteil |
| T6 | sechster Treiberteil |
| T7 | siebter Treiberteil |
| T8 | achter Treiberteil |
| T9 | neunter Treiberteil |
| VDD | Versorgungsspannung und Kontaktfläche für Versorgungsspannung |
| VDDA | analoge Versorgungsspannung |
| VDDD | digitale Versorgungsspannung |
| VDDH | hohe Versorgungsspannung |
| VDDP | Versorgungsspannung der Schnittstellen |
| ZL | Zylinderlinse |

## LITERATURLISTE

DE-A-195 14 062
DE-C- 195 46 563
DE-A-199 14 362
DE-B-10 2006 036 167
DE-A-10 2008 021 588
DE-A-10 2008 062 544
DE-A-10 2009 060 873
DE-A-10 2014 105 482
DE-A-10 2016 116 368
DE-A-10 2016 116 369
DE-A-10 2016 116 875
DE-A-10 2017 100 879
DE-A-10 2017 121 713
DE-A-10 2018 106 860
DE-A-10 2018 106 861
EP-A-2 002 519
EP-A-3 301 473
EP-A-3 660 574
US-A-2018/0045882
US-A-2020/0264426
US-B-6 697 402
US-B-9 115 146
US-B-9 185 762
US-B-9 368 936
US-B-10 193 304
WO-A-2008/035983
WO-A-2018/154139
WO-A-2019/234180

**Patentansprüche**

1. Lichtmodul mit

    - einem mit einer Oberseite (TRO) versehenen Träger (TR), in dem ein Schaltungs-Die mit integrierten Schaltungen angeordnet ist,
    - wobei das Schaltungs-Die eine Oberseite aufweist,
    - einem in der Oberseite des Schaltungs-Dies ausgebildeten Transistor ($T_{dis}$) oder Leistungstransistor,
    - wobei der Transistor ($T_{dis}$) einen leitend oder sperrend schaltbaren Leitungspfad (LPF) mit einem ersten Endbereich (LPF1) und einem zweiten Endbereich (LPF2) aufweist, von denen der erste Endbereich (LPF1) mit einem ersten Leitungspfad-Anschlussfeld (TAF1) und der zweite Endbereich (LPF2) mit einem zweiten Leitungspfad-Anschlussfeld (TAF2) elektrisch verbunden ist, die beide an der Oberseite (TRO) des Trägers (TR) freiliegen, und wobei der Transistor ($T_{dis}$) einen Steueranschluss ($GT_{dis}$) zum Leitend- und Sperrendschalten des Leitungspfad (LPF) aufweist,
    - einem eine Leuchtdiode aufweisenden Leuchtdioden-Die (D1D) oder einem eine Laserdiode aufweisenden Leuchtdioden-Die, mit einer ein erstes Anschlussfeld (DAF1) aufweisenden Unterseite und einer ein zweites Anschlussfeld (DAF2) aufweisenden Oberseite,
    - wobei das Leuchtdioden-Die (D1D) mit seinem ersten Anschlussfeld (DAF1) auf dem ersten Leitungspfad-Anschlussfeld (TAF1) des Transistors ($T_{dis}$) liegend angeordnet ist und diese beiden Anschlussfelder elektrisch miteinander verbunden sind,
    - einem einen Ladungsspeicher (C1 bis Cn) aufweisenden Ladungsspeicherbauteil (LSBT), das eine ein erstes Anschlussfeld (LAF1) aufweisende Unterseite und eine ein zweites Anschlussfeld (LAF2) aufweisende Oberseite aufweist,
    - wobei das Ladungsspeicherbauteil (LSBT) mit seinem ersten Anschlussfeld (LAF1) auf dem zweiten Leitungspfad-Anschlussfeld (TAF2) des Transistors ($T_{dis}$) liegend angeordnet ist und diese beiden Anschlussfelder elektrisch miteinander verbunden sind,
    - mindestens einem ersten Bonddraht (BD1), der das zweite Anschlussfeld (DAF1) des Leuchtdioden-Dies (D1D) elektrisch mit dem zweiten Anschlussfeld (LAF2) des Ladungsspeicherbauteils (LSBT) verbindet,
    - einer in dem Schaltungs-Die integrierten, einen Ausgang aufweisenden Aufladeschaltung (B1 bis Bn) zum Aufladen des Ladungsspeicherbauteils (LSBT) mit elektrischer Ladung und
    - einer in dem Schaltungs-Die integrierten Steuerschaltung (CTR) zur Ansteuerung des Transistors ($T_{dis}$) und der Aufladeschaltung (B1 bis Bn),
    - wobei der Aufladeschaltung (B1 bis Bn) ein an der Oberseite (TRO) des Trägers (TR) freiliegendes Ladungsanschlussfeld (AF) zugeordnet ist, mit dem der Ausgang der Aufladeschaltung (B1 bis Bn) elektrisch verbunden ist,
    - wobei das Ladungsanschlussfeld (AF) der Aufladeschaltung (B1 bis Bn) mit dem zweiten Anschlussfeld (LAF2) des Ladungsspeicherbauteils (LSBT) über mindestens einen zweiten Bonddraht (BD2) elektrisch verbunden ist, und
    - wobei die Steuerschaltung (CTR) die Aufladeschaltung (B1 bis Bn) zum Laden des Ladungsspeicherbauteils (LSBT) bis zu einem für die Erzeugung eines Lichtpulses durch das Leuchtdioden-Die (D1D) erforderlichen Aufladungsgrad ansteuert und danach den Transistor ($T_{dis}$) zum Leitendschalten seines Leitungspfades (LPF) ansteuert.

2. Lichtmodul nach Anspruch 1, **dadurch gekennzeichnet,**

    - **dass** der mindestens eine erste Bonddraht (BD1) eine erste parasitäre Induktivität und einen ersten parasitären ohmschen Widerstand aufweist,
    - **dass** der mindestens eine zweite Bonddraht (BD2) eine zweite parasitäre Induktivität und einen zweiten parasitären ohmschen Widerstand aufweist,
    - **dass** die elektrische Verbindung des ersten Anschlussfeldes (DAF1) des Leuchtdioden-Dies (D1D) mit dem ersten Endbereich (LPF1) des Leitungspfads (LPF) des Transistors ($T_{dis}$) eine dritte parasitäre Induktivität und einen dritten parasitären ohmschen Widerstand aufweist und
    - **dass** die elektrische Verbindung zwischen dem ersten Anschlussfeld (LAF1) des Ladungsspeicherbauteils (LSBT) und dem zweiten Endbereich (LPF2) des Leitungspfads (LPF) des Transistors ($T_{dis}$) eine vierte parasitäre Induktivität und einen vierten parasitären ohmschen Widerstand aufweist,
    - **dass** die elektrische Verbindung des Ausgangs der Aufladeschaltung (B1 bis Bn) mit dem der Aufladeschaltung (B1 bis Bn) zugeordneten Ladungsanschlussfeld (AF) eine fünfte parasitäre Induktivität und einen fünften parasitäre ohmschen Widerstand aufweist,

- wobei die erste parasitäre Induktivität, die dritte parasitäre Induktivität und die vierte parasitäre Induktivität in Summe eine Größe aufweisen, die kleiner ist als die Größe der dritten parasitären Induktivität und der fünften parasitären Induktivität in Summe oder weniger als 1/2 oder weniger als 1/4 oder weniger als 1/5 der dritten parasitären Induktivität und der fünften parasitären Induktivität in Summe beträgt.

3. Lichtmodul nach Anspruch 1 oder 2, **dadurch gekennzeichnet,**

- **dass** die elektrisch miteinander verbundenen Komponenten, nämlich das Leuchtdioden-Die (D1D), das Ladungsspeicherbauteil (LSBT), der mindestens eine erste Bonddraht (BD1) und der Transistor ($T_{dis}$) mit seinem Leitungspfad (LPF) zusammen einen Entladeschaltkreis bilden, der eine erste parasitäre Induktivität und einen ersten parasitären ohmschen Widerstand aufweist,
- **dass** das Ladungsspeicherbauteil (LSBT) mit seiner elektrischen Verbindung mit dem Ausgang der Aufladeschaltung (B1 bis Bn) über den mindestens einen zweiten Bonddraht (BD2) einen Aufladeschaltkreis bilden, der eine zweite parasitäre Induktivität und einen zweiten parasitären ohmschen Widerstand aufweist,
- wobei die erste parasitäre Induktivität kleiner ist als die zweite parasitäre Induktivität oder weniger als 1/2 oder weniger als 1/4 oder weniger als 1/5 der zweiten Induktivität beträgt.

4. Lichtmodul nach einem der Ansprüche 1 bis 3, **gekennzeichnet durch**

- mehrere Leuchtdioden-Dies (D1D) und mehrere Ladungsspeicherbauteile (LSBT),
- wobei jedem Leuchtdioden-Die (D1D) ein Ladungsspeicherbauteil (LSBT) zugeordnet ist,
- wobei die Oberseite (TRO) des Trägers (TR) für jedes Leuchtdioden-Die (D1D) ein freiliegendes erstes Leitungspfad-Anschlussfeld (TAF1), das elektrisch mit dem ersten Endbereich (LPF1) des Leitungspfads (LPF) des Transistors ($T_{dis}$) verbunden ist, und für jedes Ladungsspeicherbauteil (LSBT) ein freiliegendes zweites Leitungspfad-Anschlussfeld (TAF2) aufweist, das elektrisch mit dem zweiten Endbereich (LPF2) des Leitungspfads (LPF) des Transistors ($T_{dis}$) verbunden ist,
- wobei in dem Schaltungs-Die für jedes Ladungsspeicherbauteil (LSBT) eine diesem zugeordnete Aufladeschaltung (B1 bis Bn) integriert ist und an der Oberseite (TRO) des Trägers (TR) für jede Aufladeschaltung (B1 bis Bn) ein Ladungsanschlussfeld (AF) freiliegend angeordnet ist,
- wobei jedes Leuchtdioden-Die (D1D) mit seinem ersten Anschlussfeld (DAF1) auf dem zugeordneten ersten Leitungspfad-Anschlussfeld (TAF1) des Transistors ($T_{dis}$) aufliegend angeordnet ist und diese beiden Anschlussfelder elektrisch miteinander verbunden sind,
- wobei jedes Ladungsspeicherbauteil (LSBT) mit seinem ersten Ladungsanschlussfeld (LAF1) auf dem zugeordneten zweiten Leitungspfad-Anschlussfeld (TAF2) des Transistors ($T_{dis}$) aufliegend angeordnet ist und diese beiden Anschlussfelder elektrisch miteinander verbunden sind,
- wobei das zweite Anschlussfeld (DAF2) jedes Leuchtdioden-Dies (D1D) mit dem zweiten Anschlussfeld (LAF2) des dem jeweiligen Leuchtdioden-Die (D1D) zugeordneten Ladungsspeicherbauteils (LSBT) mittels mindestens eines ersten Bonddrahts (BD1) verbunden ist,
- wobei das Ladungsanschlussfeld (AF) jeder Aufladeschaltung (B1 bis Bn) mit dem zweiten Anschlussfeld (LAF2) des der jeweiligen Aufladeschaltung (B1 bis Bn) zugeordneten Ladungsspeicherbauteils (LSBT) mittels mindestens eines zweiten Bonddrahts (BD2) verbunden ist und
- wobei die Steuerschaltung (CTR) die Aufladeschaltungen (B1 bis Bn) sequentiell zum Laden der jeweiligen Ladungsspeicherbauteile (LSBT) bis zu einen für die Erzeugung eines Lichtpulses durch die dem jeweiligen Ladungsspeicherbauteil (LSBT) zugeordneten Leuchtdioden-Dies (D1D) erforderlichen Aufladungsgrad ansteuert und vor der Ansteuerung der nächsten Aufladeschaltung (B1 bis Bn) den Transistor ($T_{dis}$) zum Leitendschalten seines Leitungspfads (LPF) ansteuert.

5. Lichtmodul nach einem der Ansprüche 1 bis 4, **dadurch gekennzeichnet, dass** das mindestens eine Leuchtdioden-Die (D1D) als ein Laserdioden-Die mit einer als Kantenemitter ausgebildeten Laserdiode realisiert ist.

6. Lichtmodul nach einem der Ansprüche 1 bis 5, **gekennzeichnet durch** ein an der Oberseite (TRO) des Trägers (TR) freiliegendes erstes Versorgungsspannungs-Anschlussfeld für ein Versorgungsspannungs-Potential (VDD), wobei an das zweite Leitungspfad-Anschlussfeld (TAF2) des Transistor ($T_{dis}$) oder, sofern mehrere derartige zweite Leitungspfad-Anschlussfelder vorhanden sind, an sämtliche dieser zweiten Leitungspfad-Anschlussfelder des Transistors oder an ein für alle diese zweiten Leitungspfad-Anschlussfelder gemeinsames zweites Leitungspfad-Anschlussfeld ein Versorgungsspannungs-Bezugspotential (GND) anlegbar ist.

7. Lichtmodul nach einem der Ansprüche 1 bis 6, **dadurch gekennzeichnet, dass** der Träger (TR) eine Vergussmasse aufweist, in die ein mehrere Leiterzungen aufweisender Leiterrahmen und das mit den Leiterzungen elektrisch verbundenen Schaltungs-Die eingebettet sind, wobei die Leiterzungen die an der Oberseite (TRO) des Trägers (TR) freiliegenden Anschlussfelder aufweisen.

8. Lichtmodul nach einem der Ansprüche 1 bis 7, **dadurch gekennzeichnet,**

   - **dass** der Transistor ($T_{dis}$) des Schaltungs-Die in diesem als ein in Analog-Schaltungstechnik ausgeführter, spannungsgesteuerter, einen Gesamtsteueranschluss (GSA) und einen Gesamtleitungspfad aufweisenden Gesamttransistor zum Leiten eines elektrischen Stroms über den Gesamtleitungspfad und zum Sperren des Stroms ausgebildet ist,
   - wobei sich der Gesamtsteueranschluss (GSA) über eine Steueranschluss-Gesamtfläche (GF) des Schaltungs-Dies erstreckt,
   - **dass** die Steuerschaltung (CTR) eine in Digital-Schaltungstechnik ausgeführte Treiberschaltung zum Ansteuern des Gesamtsteueranschlusses (GSA) des Gesamttransistors zum Leiten und Sperren des Stroms aufweist, oder dass das Schaltungs-Die eine in Digital-Schaltungstechnik ausgeführte, von der Steuerschaltung steuerbare Treiberschaltung zum Ansteuern des Gesamtsteueranschlusses (GSA) des Gesamttransistors zum Leiten und Sperren des Stroms aufweist,
   - wobei der Gesamttransistor in eine Vielzahl von in Analog-Schaltungstechnik ausgeführten Einzeltransistoren unterteilt ist oder eine Vielzahl derartiger Einzeltransistoren aufweist,
   - wobei jeder Einzeltransistor einen Einzelsteueranschluss (ESA) aufweist und sich die Einzelsteueranschlüsse (ESA) der Einzeltransistoren jeweils über Steueranschluss-Einzelflächen des Dies erstrecken, die gleich groß und/oder gleichmäßig über die Steueranschluss-Gesamtfläche (GF) des Gesamttransistors verteilt sind,
   - wobei die Treiberschaltung eine Vielzahl von Einzeltreiberschaltungen (T1 bis T9) mit jeweils einem Eingang und u Ausgängen, mit u als ganze natürliche Zahl größer als oder gleich 2, aufweist, die hierarchisch in verschiedene Stufen unterteilt sind, wobei der Ausgang einer Einzeltransistorschaltung einer i-ten Stufe, mit i gleich 1 bis v und v als ganze natürliche Zahl größer als oder gleich 2, mit den Eingängen von u Einzeltreiberschaltungen der (i+1)-ten Stufe, verbunden ist,
   - wobei die Anordnung aus einer Einzeltreiberschaltung der i-ten Stufe und den Einzeltreiberschaltungen der (i+1)-ten Stufe, deren Eingänge mit den Ausgängen der Einzeltreiberschaltung der i-ten Stufe verbunden sind, eine selbstähnliche Struktur bildet
   - wobei die selbstähnlichen Strukturen einer i-ten Stufe flächenmäßig größer ist als die selbstähnlichen Strukturen einer (i+1)-ten Stufe und die selbstähnlichen Strukturen der i-ten Stufe mit einer (i+1)-ten Stufe mit der selbstähnlichen Struktur einer i-ten Stufe, aus der sie hervorgegangen ist, ineinander verschachtelt sind, und
   - wobei die Ausgänge der Einzeltreiberschaltungen (T1 bis T9) der v-ten Stufe mit den Steueranschluss-Einzelflächen (GFE) der Einzeltransistoren verbunden sind.

9. Lichtmodul nach Anspruch 8, **dadurch gekennzeichnet, dass** jede Einzeltreiberschaltung (T1 bis T9) einen Eingang und vier Ausgänge aufweist, dass jede der Einzeltreiberschaltungen (T1 bis T9) der i-ten Stufe und die vier Einzeltreiberschaltungen (T1 bis T9) der (i+1)-ten Stufe mitsamt der elektrischen Verbindung der vier Ausgänge der Einzeltreiberschaltung (T1 bis T9) der i-ten Stufe mit den Eingängen der vier Einzeltreiberschaltungen (T1 bis T9) der (i+1)-ten Stufe eine H-förmige Struktur bildet, wobei die Einzeltreiberschaltungen (T1 bis T9) der (i+1)-ten Stufe an den vier Enden der H-förmigen Struktur angeordnet sind und die Einzeltreiberschaltung (T1 bis T9) der i-ten Stufe in der Mitte zwischen den vier Enden angeordnet ist, und dass die H-förmigen Strukturen von Stufe zu Stufe die gleiche Ausrichtung aufweisen.

10. Lichtmodul nach Anspruch 9, **dadurch gekennzeichnet, dass** jede Einzeltreiberschaltung einen Eingang und zwei Ausgänge aufweist, dass jede der Einzeltreiberschaltung der i-ten Stufe in der Mitte zwischen den beiden Einzeltreiberschaltungen der (i+1)-ten Stufe angeordnet ist sowie mitsamt der elektrischen Verbindung der beiden Ausgänge der Einzeltreiberschaltung der i-ten Stufe mit den Eingängen der beiden Einzeltreiberschaltungen der (i+1)-ten Stufe eine geradlinige Struktur bildet und dass diese selbstähnlichen Strukturen von Stufe zu Stufe jeweils um 90° verdreht zueinander sind.

11. Lichtmodul nach einem der Ansprüche 8 bis 10, **dadurch gekennzeichnet, dass** die Einzeltreiberschaltungen (T1 bis T9) als Inverterschaltungen ausgebildet sind und dass die Einzeltransistoren als Leistungstransistoren oder MOSFET ausgebildet sind.

12. Lichtmodul nach einem der Ansprüche 1 bis 11, **dadurch gekennzeichnet, dass** die Oberseite (TRO) des Trägers (TR) eine rechteckige Form mit zwei Längsrändern und zwei im Vergleich zu diesen Längsrändern kürzeren Querrändern aufweist, wobei das mindestens eine erste Leitungspfad-Anschlussfeld (TAF1) des Transistors ($T_{dis}$) an einem der beiden Querränder angeordnet ist und an dem anderen Querrand Anschlussfelder für die Energieversorgung der Steuerschaltung (CTR), der mindestens einen Aufladeschaltung (B1 bis Bn), des mindestens einen Ladungsspeicherbauteils (LSBT) und des mindestens einen Leuchtdioden-Dies (D1D) angeordnet sind.

13. Lichtmodul nach Anspruch 12, **dadurch gekennzeichnet, dass** an jedem der Längsränder der Oberseite (TRO) des Trägers (TR) eines von zwei Transfersignal-Anschlussfeldern mindestens eines Paares von Transfersignal-Anschlussfeldern angeordnet sind, die elektrisch miteinander verbunden sind und der Zuführung von für das Schaltungs-Die bestimmten Transfersignalen wie z.B. ein Rücksetzsignal, ein Diagnosesignal, ein Buskommunikationssignal, ein Triggersignal für die Auslösung der Erzeugung eines Lichtpulses durch das mindestens eine Leuchtdioden-Die, dienen, wobei die Transfersignale bei Nebeneinanderanordnung mehrerer Lichtmodule nebeneinander von einem Lichtmodul zum jeweils benachbarten Lichtmodul oder von einem Lichtmodul nach Verarbeitung in dessen Schaltungs-Die zum jeweils benachbarten Lichtmodul weiterleitbar sind.

14. Anordnung mehrerer Lichtmodule nach Anspruch 13, **dadurch gekennzeichnet, dass** die Lichtmodule unter zueinander benachbarter Anordnung der Längsränder ihrer Oberseiten oder bei paralleler Ausrichtung der Längsränder nebeneinander angeordnet sind, wobei die Transfersignal-Anschlussfelder gleicher Paare von Transfersignal-Anschlussfeldern zweier jeweils benachbarter Lichtmodule untereinander elektrisch verbunden sind.

15. Anordnung nach Anspruch 14, **dadurch gekennzeichnet, dass** die Leuchtdioden-Dies (D1D) sämtlicher nebeneinander angeordneter Lichtmodule auf einer gemeinsamen kreisbogenförmig gekrümmten Linie oder auf einer geraden Linie angeordnet sind.

## Claims

1. A light module comprising:

   - a carrier (TR) provided with an upper side (TRO), in which a circuit die with integrated circuits is arranged,
   - the circuit die having an upper side,
   - a transistor ($T_{dis}$) or power transistor formed in the upper side of the circuit die,
   - the transistor ($T_{dis}$) having a conduction path (LPF) which can be switched to a conducting or blocking state, said path having a first end portion (LPF1) and a second end portion (LPF2), of which the first end portion (LPF1) is electrically connected with a first conduction path terminal field (TAF1) and the second end portion (LPF2) is electrically connected with a second conduction path terminal field (TAF2), which are both exposed at the upper side (TRO) of the carrier (TR), and the transistor ($T_{dis}$) comprising a control terminal ($GT_{dis}$) for switching the conduction path (LPF) to a conducting or blocking state,
   - a light-emitting diode die comprising a light-emitting diode die (D1D) or a light-emitting diode die comprising a laser diode, with a lower side comprising a first terminal field (DAF1) and an upper side comprising a second terminal field (DAF2),
   - the light-emitting diode die (D1D) being arranged with its first terminal field (DAF1) located on the first conduction path terminal field (TAF1) of the transistor ($T_{dis}$) and these two terminal fields being electrically connected with one another,
   - a charge storage component (LSBT) comprising a charge storage (C1 to Cn), said component comprising a lower side having a first terminal field (LAF1) and an upper side having a second terminal field (LAF2),
   - the charge storage component (LSBT) being arranged with its first terminal field (LAF1) located on the second conduction path terminal field (TAF2) of the transistor ($T_{dis}$) and these two terminal fields being electrically connected with one another,
   - at least one first bonding wire (BD1) which electrically connects the second terminal field (DAF1) of the light-emitting diode die (D1D) with the second terminal field (LAF2) of the charge storage component (LSBT),
   - a charging circuit (B1 to Bn) for charging the charge storage component (LSBT) with electric charge, the circuit being integrated in the circuit die and having an output, and
   - a control circuit (CTR) for driving the transistor ($T_{dis}$) and the charging circuit (B1 bis Bn), the control circuit being integrated in the circuit die,
   - the charging circuit (B1 bis Bn) having assigned thereto a charge terminal field (AF) exposed on the upper side (TRO) of the carrier (TR), with which the output of the charging circuit (B1 bis Bn) is electrically connected,
   - the charge terminal field (AF) of the charging circuit (B1 bis Bn) being electrically connected with the second terminal field (LAF2) of the charge storage component (LSBT) via at least one second bonding wire (BD2), and
- the control circuit (CTR) controlling the charging circuit (B1 bis Bn) to charge the charge storage component (LSBT) up to a degree of charge necessary for the generation of a light pulse by the light-emitting diode die (D1D), the driver circuit subsequently driving the transistor ($T_{dis}$) to switch its conduction path (LPF) to a conducting state.

2. The light module according to claim 1, **characterized in that**

- the at least one first bonding wire (BD1) has a first parasitic inductance and a first parasitic ohmic resistance,
- the at least one second bonding wire (BD2) has a second parasitic inductance and a second parasitic ohmic resistance,
- the electric connection of the first terminal field (DAF1) of the light-emitting diode die (D1D) with the first end portion (LPF1) of the conduction path (LPF) of the transistor ($T_{dis}$) comprises a third parasitic inductance and a third parasitic ohmic resistance, and
- the electric connection between the first terminal field (LAF1) of the charge storage component (LSBT) and the second end portion (LPF2) of the conduction path (LPF) of the transistor ($T_{dis}$) comprises a fourth parasitic inductance and a fourth parasitic inductance,
- the electric connection of the output of the charging circuit (B1 bis Bn) with the charge terminal field (AF) assigned to the charging circuit (B1 bis Bn) comprises a fifth parasitic inductance and a fifth parasitic ohmic resistance,
- wherein the first parasitic inductance, the third parasitic inductance and the fourth parasitic inductance have a magnitude that is, in total, less than the total of the magnitude of the third parasitic inductance and the fifth parasitic inductance or less than 1/2 or less than 1/4 or less than 1/5 of the total of the third parasitic inductance and the fifth parasitic inductance.

3. The light module according to claim 1 or 2, **characterized in that**

- the electrically interconnected components, i.e. the light-emitting diode die (D1D), the charge storage component (LSBT), the at least one first bonding wire (BD1) and the transistor ($T_{dis}$) with its conduction path (LPF) together form a discharging circuit with a first parasitic inductance and a first parasitic ohmic resistance,
- the charge storage component (LSBT) with its electric connection to the output of the charging circuit (B1 bis Bn) forms a charging circuitry via the at least one second bonding wire (BD2), which circuitry has a second parasitic inductance and a second parasitic ohmic resistance,
- wherein the first parasitic inductance is smaller than the second parasitic inductance or smaller than 1/2 or smaller than 1/4 or smaller than 1/5 of the second inductance.

4. The light module according to any one of claims 1 to 3, **characterized by**

- a plurality of light-emitting diode dies (D1D) and a plurality of charge storage components (LSBT),
- each light-emitting diode die (D1D) having a charge storage component (LSBT) assigned thereto,
- the upper side (TRO) of the carrier (TR) comprising, for each light-emitting diode die (D1D), an exposed first terminal field (TAF1) that is electrically connected with the first end portion (LPF1) of the conduction path (LP) of the transistor ($T_{dis}$), and, for each charge storage component (LSBT), an exposed second terminal field (TAF2) that is electrically connected with the second end portion (LPF2) of the conduction path (LP) of the transistor ($T_{dis}$),
- wherein in the circuit die for each charge storage component (LSBT), a charging circuit (B1 bis Bn) assigned thereto is integrated, and a charge terminal field (AF) is arranged exposed on the upper side (TRO) of the carrier (TR) for each charging circuit (B1 bis Bn),
- each light-emitting diode die (D1D) being arranged with its first terminal field (DAF1) lying on the first conduction path terminal field (TAF1) of the transistor ($T_{dis}$) and these two terminal fields being electrically connected with one another,
- each charge storage component (LSBT) being arranged with its first charge terminal field (LAF1) lying on the associated second conduction path terminal field (TAF2) of the transistor ($T_{dis}$) and these two terminal fields being electrically connected with one another,
- the second terminal field (DAF2) of each light-emitting diode die (D1D) being connected, by means of at least one first bonding wire (BD1), with the second terminal field (LAF2) of the charge storage component (LSBT) assigned to the respective light-emitting diode die (D1D),
- the charge terminal field (AF) of each charging circuit (B1 to Bn) being connected, by means of at least one second bonding wire (BD2), with the second terminal field (LAF2) of the charge storage component (LSBT) assigned to the respective charging circuit (B1 to Bn), and
- the control circuit (CTR) sequentially controlling the charging circuits (B1 bis Bn) to charge the respective charge storage components (LSBT) up to a charge degree necessary to generate a light pulse by the light-emitting diode die (D1D) assigned to the respective charge storage component (LSBT) and, prior to controlling the next charging circuit (B1 bis Bn), controlling the transistor ($T_{dis}$) to switch its conduction path (LPF) to be conductive.

5. The light module according to any one of claims 1 to 4, **characterized in that** the at least one light-emitting diode die (D1D) is realized as a laser diode die with a laser diode configured as an edge emitter.

6. The light module according to any one of claims 1 to 5, **characterized in that** a first supply voltage terminal field for a supply voltage potential (VDD) is provided exposed on the upper side (TRO) of the carrier (TR), a supply voltage reference potential (GND) being adapted to be supplied to the second conduction path terminal field (TAF2) of the transistor ($T_{dis}$) or, if a plurality of such second conduction path terminal fields are present, to all of these second conduction path terminal fields of the transistor or to a second conduction path terminal field common to all of these second conduction path terminal fields.

7. The light module according to one of claims 1 to 6, **characterized in that** the carrier (TR) comprises a potting compound in which a lead frame with a plurality of conductor tongues and the circuit die electrically connected with the conductor tongues are embedded, wherein the conductor tongues comprising the terminal fields exposed on the upper side (TRO) of the carrier (TR).

8. The light module according to any one of claims 1 to 7, **characterized in that**

   - if the transistor of the circuit die ($T_{dis}$) is formed therein as a voltage-controlled overall transistor, implemented in analog circuit technology and having an overall control terminal (GSA) and an overall conduction path, for conducting an electric current via the overall conduction path and for blocking the current,
   - the overall control terminal (GSA) extending over an overall control terminal surface (GF) of the circuit die,
   - if the control circuit (CTR) comprises a driver circuit, implemented in digital circuit technology, for driving the overall driver terminal (GSA) of the overall transistor for conducting and blocking the current, or that the circuit die comprises a driver circuit, implemented in digital circuit technology and controllable by the control circuit for driving the overall control terminal (GSA) of the overall transistor for conducting and blocking the current,
   - the overall transistor being subdivided into a plurality of single transistors implemented in analog circuit technology or comprising a plurality of such single transistors,
   - each individual transistor comprising an individual control terminal (ESA) and the individual control terminals (ESA) of the individual transistors each extending over individual control terminal areas of the die which are equal in size and/or are uniformly distributed over the overall control terminal area (GF) of the overall transistor,
   - the driver circuit comprises a plurality of individual driver circuits (T1 to T9), each with one input and u outputs, where u is a natural integer greater than or equal to 2, being hierarchically divided into different stages, the output of an individual transistor circuit of an i-th stage, where i is 1 to v and v is a natural integer greater than or equal to 2, being connected with the inputs of u individual driver circuits of the (i-1)-th stage,
   - the arrangement of an individual driver circuit of the i-th stage and the individual driver circuits of the (i+1)-th stage, whose inputs being connected with the outputs of the individual driver circuit of the i-th stage, forming a self-similar structure,
   - the self-similar structures of an i-th stage being larger in area than the self-similar structures of an (i+1)-th stage, and the self-similar structures of the i-th stage being interleaved with an (i+1)-th stage with the self-similar structure of an i-th stage from which it originates, and
   - the outputs of the individual driver circuits (T1 to T9) of the v-th stage being connected with the individual control terminal areas (GFE) of the individual transistors.

9. The light module according to claim 8, **characterized in that** each individual driver circuit (T1 to T9) comprises one input and four outputs, that each of the individual driver circuits (T1 to T9) of the i-th stage and the four individual driver circuits (T1 to T9) of the (i+1)-stage together with the electric connection of the four outputs of the individual driver circuit (T1 to T9) of the i-th stage with the inputs of the four individual driver circuits (T1 to T9) of the (i+1)-th stage forms an H-shaped structure, wherein the individual driver circuits (T1 to T9) of the (i+1)-th stage are arranged at the four ends of the H-shaped structure and the individual driver circuit (T1 to T9) of the i-th stage is arranged in the middle between the four ends, and that the H-shaped structures have the same orientation from stage to stage.

10. The light module according to claim 9, **characterized in that** each individual driver circuit comprises one input and two outputs, that each of the individual driver circuits of the i-th stage is arranged in the middle between the two individual driver circuits of the (i+1)-th stage and, together with the electric connection of the two outputs of the individual driver circuit of the i-th stage with the inputs of the two individual driver circuits of the (i+1)-stage, forms a straight structure, and that these self-similar structures are respectively rotated by 90° to each other from stage to stage.

11. The light module according to any one of claims 8 to 10, **characterized in that** the individual driver circuits (T1 to T9) are configured as inverter circuits and that the individual transistors are configured as power transistors or MOSFET.

12. The light module according to one of claims 1 to 11, **characterized in that** the upper side (TRO) of the carrier (TR) has a rectangular shape with two longitudinal edges and two transverse edges shorter in comparison to these longitudinal edges, the at least one first conduction path terminal field (TAF1) of the transistor ($T_{dis}$) being arranged at one of the two transverse edges and terminal fields for the power supply of the control circuit (CTR), the at least one charging circuit (B1 to Bn), the at least one charge storage component (LSBT) and the at least one light-emitting diode (D1D) being arranged at the other transverse edge.

13. The light module according to claim 12, **characterized in that** on each of the longitudinal edges of the upper side (TRO) of the carrier (TR), one of two transfer signal terminal fields of at least one pair of transfer signal terminal fields is arranged, which are electrically connected with each other and serve to supply transfer signals intended for the circuit die, such as e.g. a reset signal, a diagnosis signal, a bus communication signal, a trigger signal for triggering the generation of a light pulse by the at least one light-emitting diode, the transfer signals being adapted to be transferred, if a plurality of light modules is arranged side-by-side, from one light module to the respective adjacent light module or from one light module, after processing in the circuit die thereof, to the respective adjacent light module.

14. An arrangement of a plurality of light modules according to claim 13, **characterized in that** the light modules are arranged side by side with the longitudinal edges of their upper sides or when the longitudinal edges are aligned in parallel, the transfer signal terminal fields of identical pairs of transfer signal terminal fields of two respectively adjacent light modules being electrically interconnected.

15. The arrangement according to claim 14, **characterized in that** f the light-emitting diodes (D1D) of all light modules arranged side by side are arranged on a common arcuately bent line or on a straight line.

**Revendications**

1. Module lumineux avec

- un support (TR) muni d'une face supérieure (TRO), dans lequel une puce de circuit avec des circuits intégrés est disposée,
- la puce de circuit ayant une face supérieure,
- un transistor ($T_{dis}$) ou un transistor de puissance formé dans la face supérieure de la puce de circuit,
- le transistor ($T_{dis}$) comprenant un chemin de ligne (LPF) pouvant être commuté conducteur ou bloquant, avec une première zone terminale (LPF1) et une deuxième zone terminale (LPF2), dont la première zone terminale (LPF1) est connectée électriquement à un premier champ de connexion de chemin de ligne (TAF1) et la deuxième zone terminale (LPF2) à un deuxième champ de connexion de chemin de ligne (TAF2), toutes deux disposées sur la face supérieure (TRO) du support (TR), et le transistor ($T_{dis}$) comprenant une borne de commande ($GT_{dis}$) permettant de commuter le chemin de ligne (LPF) conducteur ou bloquant,
- une puce à diode électroluminescente (D1D) comprenant une diode électroluminescente ou une puce LED comprenant une diode laser, avec une face inférieure comportant un premier champ de connexion (DAF1) et une face supérieure comportant un deuxième champ de connexion (DAF2),
- la puce à diode électroluminescente (D1D) avec son premier champ de connexion (DAF1) étant disposée couchée sur le champ de connexion du premier chemin de ligne (TAF1) du transistor ($T_{dis}$) et ces deux champs de connexion étant connectés électriquement l'un à l'autre,
- un composant de stockage de charge (LSBT) comportant un accumulateur de charge (C1 à Cn) qui comprend une face inférieure avec un premier champ de connexion (LAF1) et une face supérieure avec un deuxième champ de connexion (LAF2),
- le composant de stockage de charge (LSBT) avec son premier champ de connexion (LAF1) étant disposé couché sur le deuxième champ de connexion du chemin de ligne (TAF2) du transistor ($T_{dis}$) et ces deux champs de connexion étant interconnectés électriquement,
- au moins un premier fil de liaison (BD1) qui relie le deuxième champ de connexion (DAF1) de la puce à diodes électroluminescentes (D1D) électriquement au deuxième champ de connexion (LAF2) du composant de stockage de charge (LSBT),

- un circuit de chargement (B1 à Bn) intégré dans la puce de circuit et comprenant une sortie, pour charger le composant de stockage de charge (LSBT) avec une charge électrique et

- un circuit de commande (CTR) intégré dans la puce de circuit pour commander le transistor ($T_{dis}$) et le circuit de chargement (B1 à Bn),

- un champ de connexion de charge (AF) non couvert et disposé sur la face supérieure (TRO) du support (TR) étant attribué au circuit de chargement (B1 à Bn), auquel champ de connexion la sortie du circuit de chargement (B1 à Bn) est connecté électriquement,

- le champ de connexion de charge (AF) du circuit de chargement (B1 à Bn) étant relié électriquement au deuxième champ de connexion (LAF2) du composant de stockage de charge (LSBT) par au moins un deuxième fil de liaison (BD2) et

- le circuit de commande (CTR) commandant le circuit de chargement (B1 à Bn) pour charger le composant de stockage de charge (LSBT) jusqu'à à un degré de chargement nécessaire pour la génération d'une impulsion lumineuse par la puce à diode électroluminescente (D1D) et commandant ensuite le transistor ($T_{dis}$) pour commuter conducteur son chemin de ligne (LPF).

2. Module lumineux selon la revendication 1, **caractérisé en ce**

- **que** ledit au moins un premier fil de liaison (BD1) comprend une première inductance parasite et une première résistance ohmique parasite,

- **que** ledit au moins un deuxième fil de liaison (BD2) comprend une deuxième inductance parasite et une deuxième résistance ohmique parasite,

- **que** la liaison électrique entre le premier champ de connexion (DAF1) de la puce à diode électroluminescente (D1D) et la première zone terminale (LPF1) du chemin de ligne (LPF) du transistor ($T_{dis}$) comprend une troisième inductance parasite et une troisième résistance ohmique parasite, et

- **que** la liaison électrique entre le premier champ de connexion (LAF1) du composant de stockage de charge (LSBT) et la deuxième zone terminale (LPF2) du chemin de ligne (LPF) du transistor ($T_{dis}$) comprend une quatrième inductance parasite et une quatrième résistance ohmique parasite,

- **que** la liaison électrique entre la sortie du circuit de chargement (B1 à Bn) et le champ de connexion de charge (AF) attribué au circuit de chargement (B1 à Bn) comprend une cinquième inductance parasite et une cinquième résistance ohmique parasite,

- la première inductance parasite, la troisième inductance parasite et la quatrième inductance parasite ayant au total une grandeur qui est inférieure à la grandeur de la somme de la troisième inductance parasite et de la cinquième inductance parasitaire ou moins qu'un 1/2 ou moins qu'un 1/4 ou moins qu'un 1/5 de la somme de la troisième inductance parasite et de la cinquième inductance parasite.

3. Module lumineux selon la revendication 1 ou 2, **caractérisé en ce**

- **que** les composants interconnectés électriquement, à savoir la puce à diode électroluminescente (D1D), le composant de stockage de charge (LSBT), ledit au moins un premier fil de liaison (BD1) et le transistor ($T_{dis}$) avec son chemin de ligne (LPF), forment ensemble un circuit de déchargement qui comprend une première inductance parasite et une première résistance ohmique parasite,

- **que** le composant de stockage de charge (LSBT) avec sa connexion électrique à la sortie du circuit de chargement (B1 à Bn) par ledit au moins un deuxième fil de liaison (BD2), forment un circuit de chargement qui comprend une deuxième inductance parasite et une deuxième résistance ohmique parasite,

- la première inductance parasite étant inférieure à la deuxième inductance parasite ou étant moins qu'un 1/2 ou moins qu'un 1/4 ou moins qu'un 1/5 de la deuxième inductance.

4. Module lumineux selon l'une des revendications 1 à 3, **caractérisé par**

- plusieurs puces à diode électroluminescente (D1D) et plusieurs composants de stockage de charge (LSBT),

- à chaque puce à diode électroluminescente (D1D), un composant de stockage de charge (LSBT) étant attribué,

- la face supérieure (TRO) du support (TR) comprenant pour chaque puce à diode électroluminescente (D1D) un premier champ de connexion de chemin de ligne (TAF1) non couvert qui est électriquement connecté à la première zone terminale (LPF1) du chemin de ligne (LPF) du transistor ($T_{dis}$), et pour chaque composant de stockage de charge (LSBT) un deuxième champ de connexion de chemin de ligne (TAF2) non couvert qui est électriquement connecté à la deuxième zone terminale (LPF2) du chemin de ligne (LFP) du transistor ($T_{dis}$),

- dans la puce de circuit, pour chaque composant de stockage de charge (LSBT), un circuit de chargement (B1 à Bn) associé à ce dernier étant intégré et, sur la face supérieure (TRO) du support (TR), un champ de connexion de charge (AF) étant disposé non couvert pour chaque circuit de chargement (B1 à Bn),
- chaque puce à diode électroluminescente (D1D) étant disposée avec son premier champ de connexion (DAF1) sur le premier champ de connexion de chemin de ligne (TAF1) associé du transistor ($T_{dis}$) sont disposés sur une surface et ces deux champs de connexion étant électriquement connectés l'un à l'autre,
- chaque composant de stockage de charge (LSBT) étant agencé avec son premier champ de connexion de charge (LAF1) sur le deuxième champ de connexion du chemin de ligne associé (TAF2) du transistor ($T_{dis}$) et ces deux champs de connexion étant électriquement connectés l'un à l'autre,
- le deuxième champ de connexion (DAF2) de chaque puce à diode électroluminescente (D1D) étant connecté au deuxième champ de connexion (LAF2) du composant de stockage de charge (LSBT) associé à la puce à diode électroluminescente (D1D) respective par au moins un premier fil de liaison (BD1),
- le champ de connexion de charge (AF) de chaque circuit de chargement (B1 à Bn) étant connecté au deuxième champ de connexion (LAF2) du composant de stockage de charge (LSBT) associé au circuit de chargement respectif (B1 à Bn) par au moins un deuxième fil de liaison (BD2) et
- le circuit de commande (CTR) commandant séquentiellement les circuits de charge (B1 à Bn) pour charger les composants de stockage de charge (LSBT) respectifs jusqu'à un niveau de charge requis pour la génération d'une impulsion lumineuse par les puces à diode électroluminescente (D1D) associées au composant de stockage de charge respectif (LSBT) et, avant l'activation du circuit de chargement (B1 à Bn) suivant, commandant le transistor ($T_{dis}$) pour commuter conducteur son chemin de ligne (LPF).

5. Module lumineux selon l'une des revendications 1 à 4, **caractérisé en ce que** ladite au moins une puce à diode électroluminescente (D1D) est une puce à diode laser avec une diode laser configurée comme émetteur par le bord.

6. Module lumineux selon l'une des revendications 1 à 5, **caractérisé par** un premier champ de connexion de tension d'alimentation non couvert disposé sur la face supérieure (TRO) du support (TR) pour un niveau de tension d'alimentation (VDD), un potentiel de référence de tension d'alimentation (GND) pouvant être appliqué au deuxième champ de connexion de chemin de ligne (TAF2) du transistor ($T_{dis}$) ou, si plusieurs deuxièmes champs de connexion de chemin de ligne sont présents, à tous ces deuxièmes champs de connexion de chemin de ligne du transistor ou à un deuxième champ de connexion de chemin de ligne commun à tous ces deuxièmes champs de connexion de chemin de ligne.

7. Module lumineux selon l'une des revendications 1 à 6, **caractérisé en ce que** le support (TR) comporte une masse d'enrobage dans laquelle sont intégrés un cadre conducteur muni de plusieurs languettes conductrices et la puce de circuit connectée électriquement aux languettes, les languettes conductrices comprenant à la face supérieure (TRO) du support (TR) des champs de connexion non couverts.

8. Module lumineux selon l'une des revendications 1 à 7, **caractérisé en ce**

- **que** le transistor ($T_{dis}$) de la puce de circuit est configuré dans celle-ci comme un transistor global réalisé dans la technologie des circuits analogiques, commandé en tension, comprenant une borne de commande totale (GSA) et un chemin de ligne total, pour faire passer un courant électrique sur le chemin de conduction total et pour bloquer le courant,
- la borne de commande totale (GSA) s'étendant sur une surface totale de borne de commande (GF) de la puce de circuit,
- **que** le circuit de commande (CTR) comprend un circuit d'attaque réalisé en technologie des circuits numériques pour commander la borne de commande totale (GSA) du transistor total pour la conduction et le blocage du courant, ou bien que la puce de circuit comprend un circuit d'attaque réalisé en technologie de circuits numériques, contrôlable par le circuit de commande, pour commander la borne de commande totale (GSA) du transistor total pour la conduction et le blocage du courant,
- le transistor total étant divisé en une multitude de transistors individuels réalisés en technologie des circuits analogues ou comprenant une multitude de tels transistors individuels,
- chaque transistor individuel comprenant une borne de commande individuelle (ESA) et les bornes de commande individuelles (ESA) des transistors individuels s'étendant chacune sur des zones de borne de commande individuelles de la puce, qui sont de même taille et/ou uniformément réparties sur la surface totale de borne de commande (GF) du transistor total,
- le circuit d'attaque comprenant une multitude de circuits d'attaque individuels (T1 à T9), chacun avec une entrée et u sorties, u étant un nombre entier naturel supérieur à ou égal à 2, qui sont divisées hiérarchiquement en différents étages, la sortie d'un circuit à transistor unique d'un i-ème étage, avec i égal à 1 à v et v étant un nombre entier naturel supérieur à ou égal à 2, étant connecté aux entrées des u circuits d'attaque individuels de l'étage (i+1),

- l'arrangement constitué d'un circuit d'attaque individuel de l'i-ième étage et des circuits d'attaque individuels de l'étage i+1 dont les entrées sont reliées aux sorties du circuit d'attaque individuel de l'i-ième étage, formant une structure semblable à elle-même,

- les structures semblables à elles-mêmes d'un i-ième étage étant plus grandes en surface que les structures semblables à elles-mêmes d'un étage i+1, et les structures semblables à elles-mêmes d'un étage i+1 et les structures semblables à elles-mêmes d'un i-ième étage dont ils ont été formés, étant imbriqués les uns avec les autres, et

les sorties des circuits d'attaque individuels (T1 à T9) de l'étage v étant reliées aux surfaces individuelles de connexion de commande (GFE) des transistors individuels.

9. Module lumineux selon la revendication 8, **caractérisé en ce que** chaque circuit d'attaque individuel (T1 à T9) comprend une entrée et quatre sorties, que chacun des circuits d'attaque individuels (T1 à T9) de l'i-ième étage et les quatre circuits d'attaque individuels (T1 à T9) de l'étage (i+1), ensemble avec la connexion électrique des quatre sorties des circuits d'attaque individuels (T1 à T9) de l'i-ième étage avec les entrées des quatre circuits d'attaque individuels (T1 à T9) de l'étage (i+1), forme une structure en forme de H, les circuits d'attaque individuels (T1 à T9) de l'étage (i+1) étant disposés aux quatre extrémités de la structure en forme de H et le circuit d'attaque individuel (T1 à T9) de l'i-ième étage étant disposé au milieu entre les quatre extrémités, et que les structures en forme de H ont, d'étage en étage, la même orientation.

10. Module lumineux selon la revendication 9, **caractérisé en ce que** chaque circuit de d'attaque individuel comprend une entrée et deux sorties, que chacun des circuits d'attaque individuels de l'i-ième étage est disposé au milieu entre les deux circuits d'attaque individuels de l'étage (i+1) et forme, ensemble avec la connexion électrique des deux sorties du circuit d'attaque individuel de l'i-ième étage aux entrées des deux circuits d'attaque individuels de l'étage (i+1), une structure à ligne droite et que ces structures semblables à elles-mêmes sont tournées d'étage en étage respectivement de 90° l'une par rapport à l'autre.

11. Module lumineux selon l'une des revendications 8 à 10, **caractérisé en ce que** les circuits d'attaque individuels (T1 à T9) sont conçus comme des circuits inverseurs et que les transistors individuels sont conçus comme transistors de puissance ou comme MOSFET.

12. Module lumineux selon l'une des revendications 1 à 11, **caractérisé en ce que** la face supérieure (TRO) du support (TR) a une forme rectangulaire avec deux bords longitudinaux et deux bords transversaux plus courts par rapport à ces bords longitudinaux, ledit au moins un premier champ de connexion de chemin de ligne (TAF1) du transistor ($T_{dis}$) étant disposé à un des deux bords transversaux et, sur l'autre bord transversal, des champs de connexion pour l'alimentation en énergie du circuit de commande (CTR), dudit au moins un circuit de chargement (B1 à Bn), dudit au moins un composant de stockage de charge (LSBT) et de ladite au moins une puce à diode électroluminescente (D1D) étant disposés.

13. Module lumineux selon la revendication 12, **caractérisé en ce que** sur chacun des bords longitudinaux de la surface supérieure (TRO) du support (TR), un de deux champs de connexion de signal de transfert d'au moins une paire de champs de connexion de signal de transfert est disposé, qui sont connectés électriquement l'un l'autre et servent à fournir des signaux de transfert spécifiques destinés à la puce de circuit, tels qu'un signal de réinitialisation, un signal de diagnostic, un signal de communication de bus et un signal de déclenchement. pour déclencher la génération d'une impulsion lumineuse au moyen de ladite au moins une puce à diode électroluminescente, les signaux de transfert pouvant être transférés, lorsque plusieurs modules lumineux sont disposés côte à côte, d'un module lumineux au module lumineux suivant adjacent ou être transférés d'un module lumineux au module lumineux adjacent respectif après traitement dans sa puce de circuit.

14. Agencement de plusieurs modules lumineux selon la revendication 13, **caractérisé en ce que** les modules lumineux sont disposés de manière à ce que les bords longitudinaux de leurs faces supérieures soient disposés adjacents les uns aux autres ou que les modules soient disposés les uns à côté des autres en cas d'orientation parallèle des bords longitudinaux, les champs de connexion de signal de transfert de paires identiques de champs de connexion de signal de transfert de deux modules lumineux adjacents étant connectés électriquement l'un à l'autre.

15. Agencement selon la revendication 14, **caractérisé en ce que** les puces à diode électroluminescente (D1D) de tous les modules d'éclairage adjacents sont disposées sur une ligne commune en forme d'arc de cercle ou sur une ligne

droite.

**FIG. 1**

EP 4 088 136 B1

Empfängerlinse
EL

S

256x4 Sensor

Aufsicht

1 x 4 Laser-Array

LDZ

LF2

Abstandsbild
(Szene)

Senderlinse — — — Zylinderlinse
SL                      ZL

Seitenansicht

D2

1 x 4 Laser-
Array

LDZ

LF2

Abstandsbild
(Szene)

**FIG. 2**

EP 4 088 136 B1

**FIG. 3**

EP 4 088 136 B1

FIG. 4

FIG. 5

EP 4 088 136 B1

D1 D2 D3 D4

C1 C2 C3 C4

K1 K2 K3 K4

CVDD

K1'
K2'
K3'
K4'

KG'

VDD Treiber IC

Laser-Array (D1 bis D4) DisC

Kondensator-Array KA
(C1 bis C4 und CVDD)

FIG. 6

FIG. 7

FIG. 8

**FIG. 9**

EP 4 088 136 B1

**FIG. 10**

**FIG. 11**

EP 4 088 136 B1

FIG. 12

FIG. 13

**FIG. 14**

EP 4 088 136 B1

**FIG. 15**

EP 4 088 136 B1

FIG. 16

FIG. 17

optimale Verteilung

**FIG. 18**

SLE

Bereich halber Lichtleistungsdichte

FIG. 19

SLE

FIG. 20

FIG. 21

SLE

**FIG. 22**

EP 4 088 136 B1

**FIG. 23**

FIG. 24

EP 4 088 136 B1

# （a）

# （b）

**FIG. 25**

**FIG. 26**

EP 4 088 136 B1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102009060873 A
- DE 102008062544 A
- DE 102016116368 A
- US 10193304 B
- EP 2002519 A
- EP 3301473 A
- DE 102016116369 A
- DE 102008021588 A
- DE 102017121713 A
- DE 19914362 A
- DE 19514062 A
- US 9185762 B
- DE 102014105482 A
- DE 102017100879 A
- DE 102018106860 A
- US 20180045882 A
- DE 102016116875 A
- DE 102006036167 B
- US 6697402 B
- US 9368936 B
- US 9155146 B
- DE 102018106861 A
- DE 19546563 C
- WO 2019234180 A
- EP 3660574 A
- US 20200264462 A
- WO 2008035983 A
- WO 2018154139 A
- US 20200264426 A
- US 9115146 B